# EUROPEAN PATENT SPECIFICATION

(11) **EP 3 926 702 B1**
(45) Date of publication and mention of the grant of the patent: **28.05.2025**
(21) Application number: 21166746.4
(22) Date of filing: 01.04.2021
(51) Int. Cl.: H10K 50/19

(54) **ORGANIC LIGHT-EMITTING DEVICE AND ELECTRONIC APPARATUS INCLUDING THE SAME**
ORGANISCHE LICHTEMITTIERENDE VORRICHTUNG UND ELEKTRONISCHE EINRICHTUNG DAMIT
DISPOSITIF ÉLECTROLUMINESCENT ORGANIQUE ET APPAREIL ÉLECTRONIQUE LE COMPRENANT

(30) Priority: 15.06.2020 KR 20200072601
(43) Date of publication of application: 22.12.2021
(73) Proprietor: Samsung Display Co., Ltd., Yongin-si, Gyeonggi-Do 17113 (KR)
(72) Inventor: HUR, Jaeweon, 17113 Yongin-si (KR); KIM, Seulong, 17113 Yongin-si (KR); KIM, Hyeongpil, 17113 Yongin-si (KR); BAE, Sungsoo, 17113 Yongin-si (KR); LEE, Dongchan, 17113 Yongin-si (KR)
(74) Representative: Marks & Clerk LLP

(56) References cited:
- EP-A1- 2 309 824
- US-A1- 2009 001 885
- US-A1- 2014 183 475
- US-A1- 2019 288 212

## Description

### BACKGROUND

### 1. Field

One or more aspects of embodiments of the present disclosure relate to an organic light-emitting device and an electronic apparatus including the same.

### 2. Description of Related Art

Organic light-emitting devices are self-emissive devices that may have a wide viewing angle, a high contrast ratio, and/or a short response time, and may show excellent characteristics in terms of luminance, driving voltage, and/or response speed.

An example organic light-emitting device (or OLED) includes a first electrode located on a substrate, and a hole transport region, an emission layer, an electron transport region, and a second electrode sequentially stacked on the first electrode. Holes provided from the first electrode may move toward the emission layer through the hole transport region, and electrons provided from the second electrode may move toward the emission layer through the electron transport region. Carriers (such as the holes and electrons) may recombine in the emission layer to produce excitons. These excitons may transition from an excited state to the ground state to thereby generate light.

US 2019/288212 A1 relates to an organic light-emitting diode device and a compound for a charge generation layer in an organic light-emitting diode device. US 2014/183475 A1 relates to an organic light-emitting diode device comprising a charge generation layer comprising an n-type charge generation layer and first and second p-type charge generation layers.

### SUMMARY

One or more aspects of embodiments of the present disclosure are directed toward an organic light-emitting device with high efficiency and a long lifespan.

Additional aspects will be set forth in part in the description which follows and, in part, will be apparent from the description, or may be learned by practice of the presented embodiments of the disclosure.

One or more example embodiments of the present disclosure provide an organic light-emitting device including:
a first electrode,
a second electrode facing the first electrode,
m light-emitting units stacked between the first electrode and the second electrode and each including at least one emission layer, and
m-1 charge generating layers, each located between two neighboring light-emitting units of the m light-emitting units and including an n-type charge generating layer and a p-type charge generation layer,
wherein m is an integer of 2 or more,
at least one of the m-1 p-type charge generation layers includes a first doping layer and a second doping layer,
the first doping layer includes a first organic material and a first inorganic material,
the second doping layer includes a second organic material and a second inorganic material, and
the first inorganic material and the second inorganic material are different from each other.

One or more example embodiments of the present disclosure provide an electronic apparatus including the organic light-emitting device.

At least some of the above and other features of the invention are set out in the claims.

### BRIEF DESCRIPTION OF THE DRAWINGS

The above and other aspects, features, and advantages of certain embodiments of the disclosure will be more apparent from the following description taken in conjunction with the accompanying drawings, in which:
FIGS. 1 to 3 are each a schematic cross-sectional view of an organic light-emitting device according to an embodiment; and
FIG. 4 shows a schematic cross-sectional view of an electronic apparatus according to an embodiment.

### DETAILED DESCRIPTION

Reference will now be made in more detail to embodiments, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein. Accordingly, the embodiments are merely described below, by referring to the drawings, to explain aspects of the present description. As used herein, the term "and/or" includes any and all combinations of one or more of the associated listed items. Throughout the disclosure, the expression "at least one of a, b or c" may refer to only a, only b, only c, both a and b, both a and c, both b and c, all of a, b, and c, or variations thereof.

Singular expressions and forms such as "a," "an," and "the" are intended to include the plural forms as well, unless the context clearly indicates otherwise.

It will be further understood that the terms "includes," "including," "comprises," and/or "comprising," used herein specify the presence of stated features or elements, but do not preclude the presence or addition of one or more other features or elements.

It will be understood that when a layer, region, or element is referred to as being "formed on" another layer, region, or element, it can be directly or indirectly formed on the other layer, region, or element. That is, for example, intervening layers, regions, or elements may be present. When an element is referred to as being "directly on," another element, there are no intervening elements present.

Sizes of elements in the drawings may be exaggerated for convenience of explanation. In other words, because sizes and thicknesses of components in the drawings are arbitrarily illustrated for convenience of explanation, the following embodiments are not limited thereto.

The term " organic layer" as used herein may refer to a single layer and/or a plurality of layers located between an anode and a cathode of an organic light-emitting device. Materials included in the "organic layer" are not limited to being organic materials.

The expression "(organic layer) includes a compound represented by Formula 1" as used herein may refer to a case in which the "(organic layer) includes one compound of Formula 1, or two or more different compounds of Formula 1".

Hereinafter, embodiments of the present disclosure will be described in more detail with reference to the attached drawings.

According to one or more embodiments, an organic light-emitting device includes:
a first electrode,
a second electrode facing the first electrode,
m light-emitting units stacked between the first electrode and the second electrode and each including at least one emission layer; and
m-1 charge generating layers, each located between two neighboring light-emitting units of the m light-emitting units and including an n-type charge generating layer and a p-type charge generation layer,
wherein m is an integer of 2 or more,
at least one of the m-1 p-type charge generation layers includes a first doping layer and a second doping layer,
the first doping layer includes a first organic material and a first inorganic material,
the second doping layer includes a second organic material and a second inorganic material, and
the first inorganic material is different from the second inorganic material.

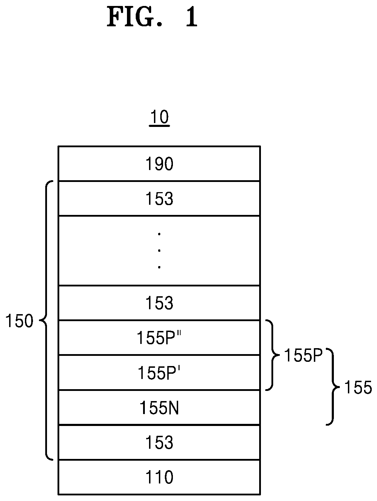

FIG. 1 is a schematic cross-sectional view of an organic light-emitting device 10 according to an embodiment. The organic light-emitting device 10 includes a first electrode 110, a second electrode 190 facing the first electrode 110, and an organic layer 150 located between the first electrode 110 and the second electrode 190. The organic layer 150 includes m light-emitting units 153 stacked between the first electrode 110 and the second electrode 190, and m-1 charge generation layers 155, each located between two neighboring light-emitting units of the m light-emitting units 153 and including an n-type charge generation layer 155N and a p-type charge generation layer 155P, wherein at least one of the m-1 p-type charge generation layers 155P includes a first doping layer 155P' and a second doping layer 155P".

The m light-emitting unit 153 is not limited as long as it is capable of emitting light. In an embodiment, each of the light-emitting units 153 may include one or more emission layers. In one or more embodiments, the light-emitting units 153 may each further include an organic layer other than an emission layer.

The number (e.g., multiplicity) of the m light-emitting units 153, that is, m, may be selected as needed, and the upper limit of the number is not limited. In an embodiment, the organic light-emitting device 10 may include two, three, four, or five light-emitting units 153.

In the organic light-emitting device 10 according to an embodiment, m may be 2 or 3, but is not limited thereto.

In an embodiment, the maximum emission wavelength of light emitted from at least one of the m light-emitting units 153 may be different from the maximum emission wavelength of light emitted from at least one light-emitting unit among the remaining light-emitting units. For example, at least two of the m light-emitting units 153 may be to emit differing or distinct maximum emission wavelengths of light. In an embodiment, in the organic light-emitting device 10 in which a first light-emitting unit and a second light-emitting unit are stacked, the maximum emission wavelength of light emitted from the first light-emitting unit may be different from the maximum emission wavelength of light emitted from the second light-emitting unit. In this case, an emission layer of the first light-emitting unit and an emission layer of the second light-emitting unit may each independently may have i) a single-layered structure including (e.g., consisting of) a single material, ii) a single-layer structure including (e.g., consisting of) a plurality of different materials, and iii) a multi-layered structure having a plurality of layers including (e.g., consisting of) a plurality of different materials. Accordingly, the light emitted from the first light-emitting unit and the second light-emitting unit may each independently be a single-color light or a mixed-color light. In an embodiment, in the organic light-emitting device 10 in which a first light-emitting unit, a second light-emitting unit, and a third light-emitting unit are stacked, the maximum emission wavelength of light emitted from the first light-emitting unit may be the same as the maximum emission wavelength of light emitted from the second light-emitting unit but different from the maximum emission wavelength of light emitted from the third light-emitting unit. In an embodiment, the maximum emission wavelength of light emitted from the first light-emitting unit, the maximum emission wavelength of light emitted from the second light-emitting unit, and the maximum emission wavelength of light emitted from the third light-emitting unit may be different from one another.

In an embodiment, the maximum emission wavelength of light emitted from the m light-emitting units 153 may all be the same. In an embodiment, in the organic light-emitting device 10 in which a first light-emitting unit, a second light-emitting unit, and a third light-emitting unit are stacked, the maximum emission wavelength of light emitted from the first light-emitting unit, the maximum emission wavelength of light emitted from the second light-emitting unit, and the maximum emission wavelength of light emitted from the third light-emitting unit may be identical to one another.

In an embodiment, the light emitted from each (all) of the m light-emitting units 153 may be blue light, and the maximum emission wavelength of light emitted from each light-emitting unit may all be the same. The blue light may have a maximum emission wavelength of about 440 nm to about 475 nm.

In an embodiment, m may be an integer of 3 or more, and the maximum emission wavelength of light emitted from at least three of the m light-emitting units 153 may be identical to each other.

In an embodiment, m may be an integer from 3 or more, and at least three light-emitting units of the m light-emitting units 153 may be to emit first-color light. In one or more embodiments, the organic light-emitting device 10 may further include a light-emitting unit to emit a second-color light that is different from the first-color light.

In an embodiment, in the organic light-emitting device 10 in which the first light-emitting unit, the second light-emitting unit, and the third light-emitting unit are stacked, the first light-emitting unit, the second light-emitting unit, and the third light-emitting unit may all emit first-color light. In one or more embodiments, the organic light-emitting device 10 may further include a fourth light-emitting unit, and the fourth light-emitting unit may be to emit a second-color light that is different from the first-color light. In this case, the position of the fourth light-emitting unit is not limited. In an embodiment, the first-color light may be blue light, but is not limited thereto.

In one or more embodiments, the maximum emission wavelengths of light emitted from the m light-emitting units 153 may each independently be about 370 nm to about 780 nm. In an embodiment, the maximum emission wavelengths of light emitted from the m light-emitting units 153 may each independently be about 435 nm to about 500 nm, about 500 nm to about 580 nm, or about 580 nm to about 780 nm.

The organic light-emitting device 10 includes a charge generation layer 155 between two neighboring light-emitting units of the m light-emitting units 153. Herein, the term "neighboring" refers to an arrangement or spatial relationship in which elements (layers) referred to as neighboring or being adjacent with one another are the closest such layers to each other. In an embodiment, the term "two neighboring light-emitting units" used herein refers to the two light-emitting units located closest to each other from among a plurality of light-emitting units. The "neighboring" may refer to a case where two layers are physically in contact with each other, as well as a case where another layer or element is located between the two layers. In an embodiment, a light-emitting unit neighboring the second electrode 190 refers to the light-emitting unit located closest to the second electrode, among the plurality of light-emitting units. Although the second electrode 190 and the light-emitting unit may be in physical contact, other layers may be located between the second electrode 190 and the light-emitting unit. In an embodiment, for example, an electron transport layer may be located between the second electrode 190 and the light-emitting unit.

The charge generation layer 155 is located between two neighboring light-emitting units. One of the two neighboring light-emitting units and the charge generation layer 155 may be in physical contact, and in some embodiments, additional layers may be located between the other light-emitting unit and the charge generation layer 155. In an embodiment, an electron transport layer may be located between the charge generation layer 155 and one of the two neighboring light-emitting units neighboring to the first electrode 110. In one or more embodiments, a hole transport layer may be located between the charge generation layer 155 and one of the two neighboring light-emitting units neighboring to the second electrode 190.

The charge generation layer 155 may generate a charge and/or separate the charge into a hole and an electron, and may provide the electron to one of two neighboring light-emitting units (thereby acting as a cathode), and may provide the hole to the other light-emitting unit, (thereby acting as an anode). The charge generation layer 155 is not directly connected to an electrode, and separates neighboring light-emitting units. The organic light-emitting device 10 including m light-emitting units 153 includes m-1 charge generation layers 155. Each of the m-1 charge generation layers 155 includes one n-type charge generation layer and one p-type charge generation layer. Accordingly, the organic light-emitting device 10 including the m-1 charge generation layers 155 includes m-1 n-type charge generation layers and m-1 p-type charge generation layers.

The term "n-type" refers to n-type semiconductor characteristics, for example, the characteristics of injecting or transporting electrons. The term "p-type" refers to p-type semiconductor characteristics, for example, the characteristics of injecting or transporting holes.

Each of the m-1 charge generation layers 155 includes an n-type charge generation layer 155N and a p-type charge generation layer 155P. In this regard, the n-type charge generation layer 155N and the p-type charge generation layer 155P may directly contact each other to form a p-n junction. Due to the p-n junction, electrons and holes may be simultaneously (e.g., concurrently) generated between the n-type charge generation layer 155N and the p-type charge generation layer 155P. The generated electrons may be transferred to one of the two neighboring light-emitting units through the n-type charge generation layer 155N. The generated holes may be transferred to the other one of the two neighboring light-emitting units through the p-type charge generation layer 155P. Because each of the m-1 charge generation layers 155 includes one n-type charge generation layer 155N and one p-type charge generation layer 155P, the organic light-emitting device 10 including m-1 charge generation layers 155 includes m-1 n-type charge generation layers 155N and m-1 p-type charge generation layers 155P.

In the m-1 charge generation layers 155, the n-type charge generation layer 155N may be located between the first electrode 110 and the p-type charge generation layer 155P.

The n-type charge generation layer 155N may supply electrons to a light-emitting unit neighboring the first electrode 110, and the p-type charge generation layer 155P may supply holes to a light-emitting unit neighboring the second electrode 190. Accordingly, the luminescence efficiency of the organic light-emitting device 10 including a plurality of emission layers, may be increased, and the driving voltage thereof may be reduced.

At least one of the m-1 p-type charge generation layers 155P includes the first doping layer 155P' and the second doping layer 155P".

In an embodiment, the first doping layer 155P' may be located between the first electrode 110 and the second doping layer 155P".

In the embodiment described above, the first electrode 110 may be an anode, which is a hole injection electrode, and the second electrode 190 may be a cathode, which is an electron injection electrode. In some embodiments, the first electrode 110 may be a cathode, which is an electron injection electrode, and the second electrode 190 may be an anode, which is a hole injection electrode.

In an embodiment, the first doping layer 155P' may be located between the first electrode 110 and the second doping layer 155P", and the first doping layer 155P' may directly contact the n-type charge generation layer 155N. In an embodiment, the first doping layer 155P' may be located at the interface of the n-type charge generation layer 155N and the second doping layer 155P".

According to the embodiment described above, because the first doping layer 155P' directly contacts the n-type charge generation layer 155N to form an p-n junction, holes may be generated between the n-type charge generation layer 155N and the p-type charge generation layer 155P, and the first doping layer 155P' may transfer the generated holes to the second doping layer 155P". The second doping layer 155P" may transfer the holes delivered by the first doping layer 155P' to the light-emitting units 153 neighboring thereto.

The first doping layer 155P' includes a first organic material and a first inorganic material, and the second doping layer 155P" includes a second organic material and a second inorganic material. The first inorganic material is different from the second inorganic material.

In an embodiment, the first inorganic material may include a post-transition metal, a metalloid, a compound that includes two or more post-transition metals, a compound that includes two or more metalloids, a compound that includes a post-transition metal and a metalloid, or any combination thereof.

The post-transition metal may include at least one selected from aluminium (Al), gallium (Ga), indium (In), thallium (TI), tin (Sn), lead (Pb), flerovium (FI), bismuth (Bi), and polonium (Po). For example, the post-transition metal may include at least one selected from aluminium (Al), gallium (Ga), indium (In), thallium (TI), tin (Sn), lead (Pb), and bismuth (Bi).

The metalloid may include at least one selected from boron (B), silicon (Si), germanium (Ge), arsenic (As), antimony (Sb), tellurium (Te), and astatine (At). For example, metalloid may include at least one selected from boron (B), silicon (Si), germanium (Ge), arsenic (As), antimony (Sb), and tellurium (Te).

In an embodiment, the compound including the two or more post-transition metals may be a compound consisting of the two or more post-transition metals.

In an embodiment, the compound including the two or more metalloids may be a compound consisting of the two or more metalloids.

In an embodiment, the compound including a post-transition metal and a metalloid may be a compound consisting of a post-transition metal and a metalloid.

In an embodiment, the first inorganic material may include Bi₂Te₃, Bi₇Te₃, Bi₂Te, Bi₄Te₃, BiTe, Bi₆Te₇, Bi₄Te₅, BiₓTe_{y}(0<x<100, 0<y<100, 0<x+y≤100), Sb_{2T}e₃, In₂Te₃, Ga₂Te₂, Al₂Te₃, Tl₂Te₃, As₂Te₃, GeSbTe, SnTe, PbTe, SiTe, GeTe, SiGe, AlInSb, AlGaSb, AlAsSb, GaAs, InSb, AlSb, AlAs, AlₐInₐSb(0<a<1), Al_{b}In_{(1-b)}Sb(0<b<1), AlSb, GaSb, AllnGaAs, or any combination thereof.

In an embodiment, the first inorganic material may have a work function absolute value of 3.0 eV or more. In an embodiment, the work function absolute value of the first inorganic material may be 3.0 eV or more, for example, 3.5 eV or more.

In an embodiment, the second inorganic material may include a halide of metal (e.g., a metal halide). In an embodiment, the second inorganic material may include a halide of an alkali metal, a halide of an alkali earth metal, a halide of a transition metal, a halide of a post-transition metal, a halide of a lanthanum metal, or any combination thereof.

In an embodiment, the second inorganic material may include an iodide of an alkali metal, an iodide of an alkali earth metal, an iodide of a transition metal, an iodide of a post-transition metal, an iodide of a lanthanum metal, or any combination thereof.

In an embodiment, the second inorganic material may include lithium (Li) iodide, sodium (Na) iodide, potassium (K) iodide, rubidium (Rb) iodide, cesium (Cs) iodide, beryllium (Be) iodide, magnesium (Mg) iodide, calcium (Ca) iodide, strontium (Sr) iodide, barium (Ba) iodide, ytterbium (Yb) iodide, samarium (Sm) iodide, copper (Cu) iodide, thallium (TI) iodide, silver (Ag) iodide, cadmium (Cd) iodide, mercury (Hg) iodide, tin (Sn) iodide, lead (Pb) iodide, bismuth (Bi) iodide, zinc (Zn) iodide, manganese (Mn) iodide, iron (Fe) iodide, cobalt (Co) iodide, nickel (Ni) iodide, aluminium (Al) iodide, indium (In) iodide, gallium (Ga) iodide, thorium (Th) iodide, uranium (U) iodide, or any combination thereof, but is not limited thereto.

In one embodiment, the second inorganic material may include Lil, Nal, KI, RbI, CsI, BeI₂, MgI₂, CaI₂, SrI₂, BaI₂, YbI, YbI₂, YbI₃, SmI₃, Cul, TII, Agl, Cdl₂, HgI₂, Snl₂, PbI₂, BiI₃, ZnI₂, MnI₂, FeI₂, CoI₂, NiI₂, AlI₃, InI₃, GaI₃, ThI₄, UI₃, or any combination thereof, but embodiments of the present disclosure are not limited thereto.

The first organic material included in the first doping layer 155P' and the second organic material included in the second doping layer 155P" may be identical to or different from each other.

In an embodiment, the first organic material may be the same as the second organic material, but embodiments of the present disclosure are not limited thereto.

In an embodiment, the first organic material and the second organic material may each include a hole transport material. The hole transport material is not particularly limited as long as it has hole transport characteristics. In an embodiment, the hole transport material may include a carbazole group, a condensed carbazole group, an indole group, a condensed indole group, a furan group, a dibenzofuran group, an acridine group, a phenoxazine group, a phenothiazine group, an amine group, or any combination thereof.

In an embodiment, the first organic material and the second organic material may each independently be selected from compounds represented by Formulae 201, 202 and 301-2 to 301-4: 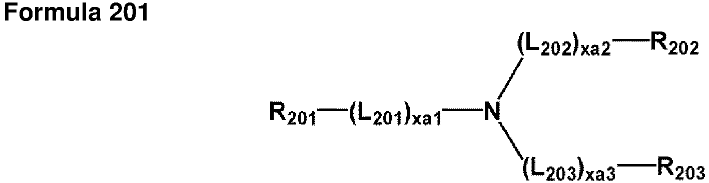 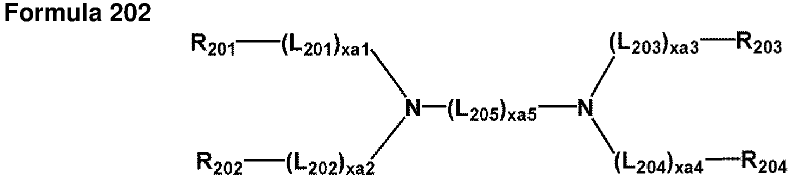 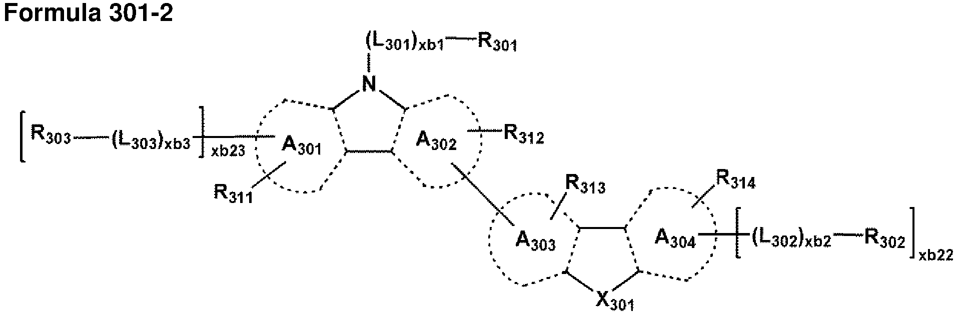 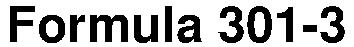 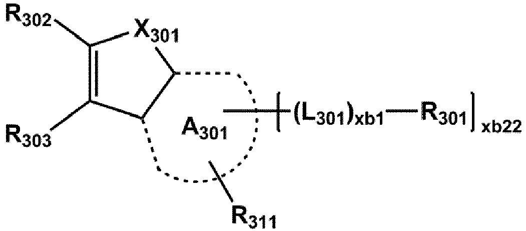 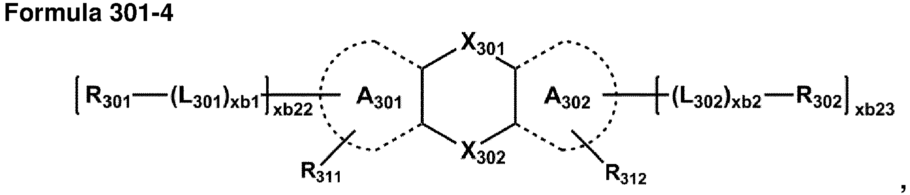 wherein, in Formulae 201, 202 and 301-2 to 301-4,
A₃₀₁ to A₃₀₄ are each independently selected from a benzene ring, a naphthalene ring, a phenanthrene ring, a fluoranthene ring, a triphenylene ring, a pyrene ring, a chrysene ring, a pyridine ring, a pyrimidine ring, an indene ring, a fluorene ring, a spiro-bifluorene ring, a benzofluorene ring, a dibenzofluorene ring, an indole ring, a carbazole ring, a benzocarbazole ring, a dibenzocarbazole ring, a furan ring, a benzofuran ring, a dibenzofuran ring, a naphthofuran ring, a benzonaphthofuran ring, a dinaphthofuran ring, a thiophene ring, a benzothiophene ring, a dibenzothiophene ring, a naphthothiophene ring, a benzonaphthothiophene ring, and a dinaphthothiophene ring,
X₃₀₁ is O, S, or N-[(L₃₀₄)_{xb4}-R₃₀₄],
X₃₀₂ is a single bond, C(R₃₀₅)(R₃₀₆), O, S, or N-[(L₃₀₅)_{xb5}-R₃₀₅],
L₂₀₁ to L₂₀₄ and L₃₀₁ to L₃₀₅ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e*.*g*. C₆-C₃₂) arylene group, a substituted or unsubstituted C₁-C₆₀ (*e.g*. C₁-C₂₀) heteroarylene group, a substituted or unsubstituted divalent non-aromatic condensed polycyclic group, and a substituted or unsubstituted divalent non-aromatic condensed heteropolycyclic group,
L₂₀₅ is selected from *-O-*', *-S-*', *-N(Q₂₀₁)-*', a substituted or unsubstituted C₁-C₂₀ (*e.g.* C₁-C₁₀) alkylene group, a substituted or unsubstituted C₂-C₂₀ (*e.g.* C₂-C₁₀) alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g*. C₆-C₃₂) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
xa1 to xa4 are each independently an integer from 0 to 3,
xa5 is an integer from 1 to 10, and
xb1 to xb5 are each an integer from 0 to 5,
xb22 and xb23 are each independently 0, 1, or 2,
R₂₀₁ to R₂₀₄ and Q₂₀₁ are each independently selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e*.*g*. C₆-C₃₂) aryl group, a substituted or unsubstituted C₆-C₆₀ (*e.g.* C₆-C₃₂) aryloxy group, a substituted or unsubstituted C₆-C₆₀ (*e.g.* C₆-C₃₂) arylthio group, a substituted or unsubstituted C₁-C₆₀ (*e*.*g*. C₁-C₂₀) heteroaryl group, a substituted or unsubstituted monovalent non-aromatic condensed polycyclic group, and a substituted or unsubstituted monovalent non-aromatic condensed heteropolycyclic group,
R₃₀₁ to R₃₀₆ are each independently selected from hydrogen, deuterium, -F, - CI, -Br, -I, a hydroxyl group, a nitro group, an amidino group, a hydrazine group, a hydrazone group, a substituted or unsubstituted C₁-C₆₀ (*e.g.* C₁-C₂₀) alkyl group, a substituted or unsubstituted C₂-C₆₀ (*e.g*. C₂-C₂₀) alkenyl group, a substituted or unsubstituted C₂-C₆₀ (*e.g*. C₂-C₂₀) alkynyl group, a substituted or unsubstituted C₁-C₆₀ (*e.g*. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (*e.g*. C₆-C₃₀) aryloxy group, a substituted or unsubstituted C₆-C₆₀ (*e.g*. C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), - B(Q₃₀₁)(Q₃₀₂), -C(=O)(Q₃₀₁), -S(=O)₂(Q₃₀₁), and -P(=O)(Q₃₀₁)(Q₃₀₂),
R₃₁₁ to R₃₁₄ are each independently selected from hydrogen, deuterium, -F, - CI, -Br, -I, a hydroxyl group, a nitro group, an amidino group, a hydrazino group, a hydrazono group, a C₁-C₂₀ (*e.g.* C₁-C₁₀) alkyl group, a C₁-C₂₀ (*e.g.* C₁-C₁₀) alkoxy group, a phenyl group, a biphenyl group, a terphenyl group, a naphthyl group - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂), and
Q₃₁ to Q₃₃ and Q₃₀₁ to Q₃₀₃ are each independently selected from a C₁-C₁₀ alkyl group, a C₁-C₁₀ alkoxy group, a phenyl group, a biphenyl group, a terphenyl group, and a naphthyl group.

In an embodiment, the first organic material and the second organic material may each independently be selected from compounds HT1 to HT73:

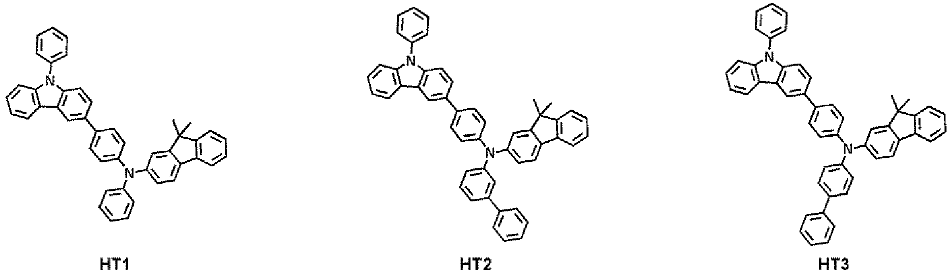

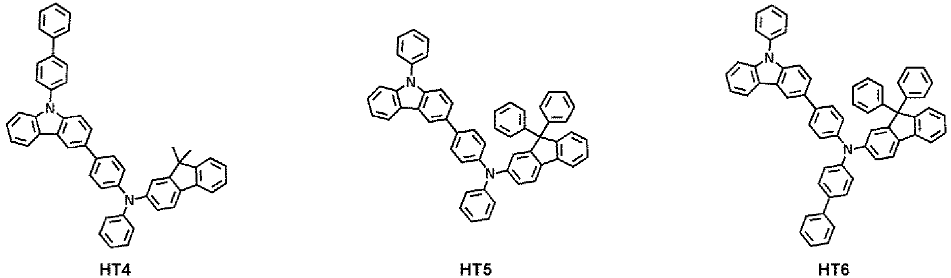

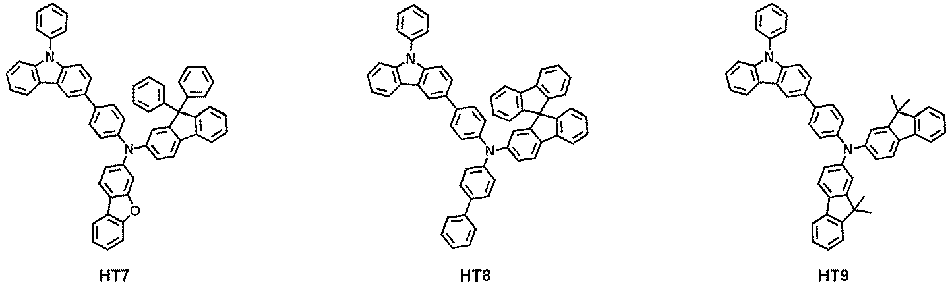

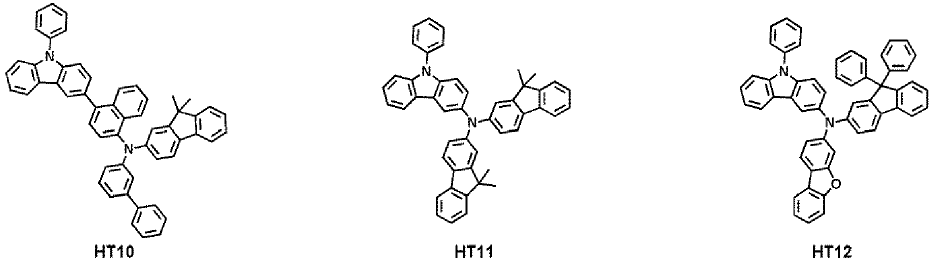

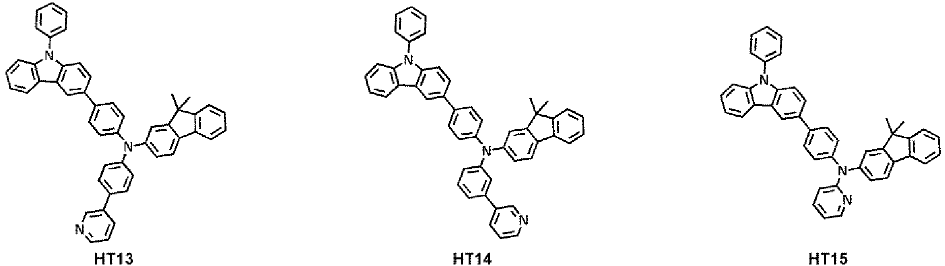

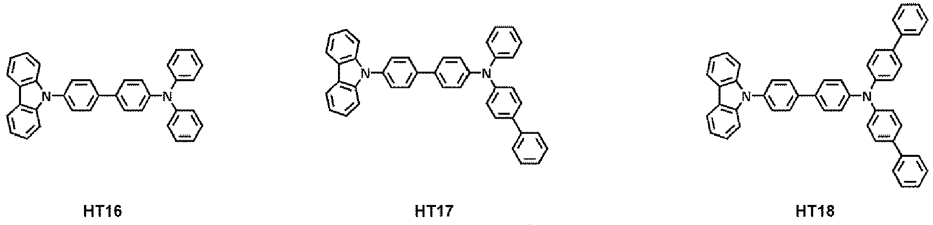

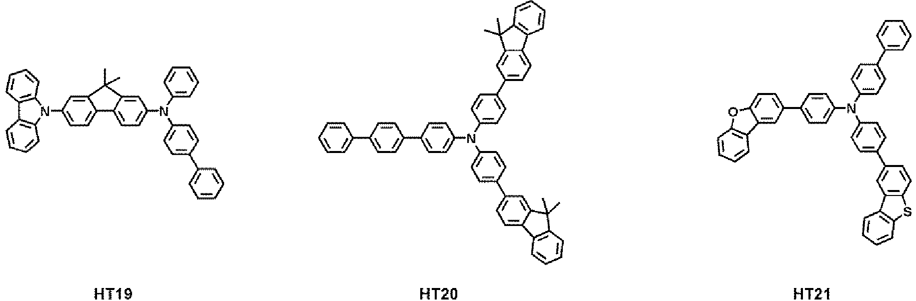

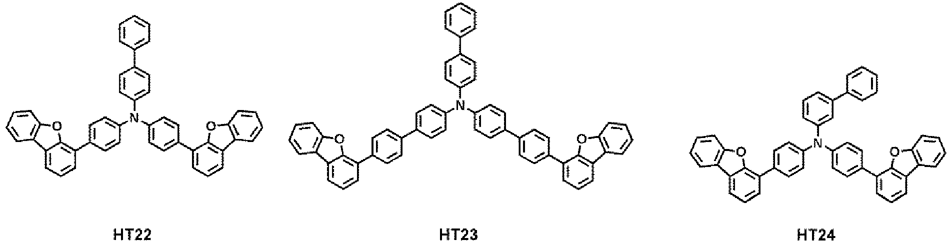

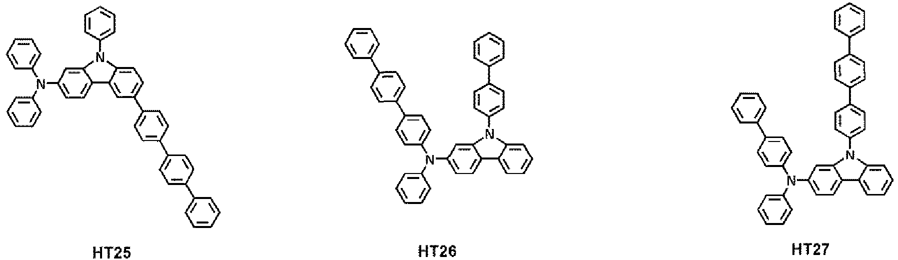

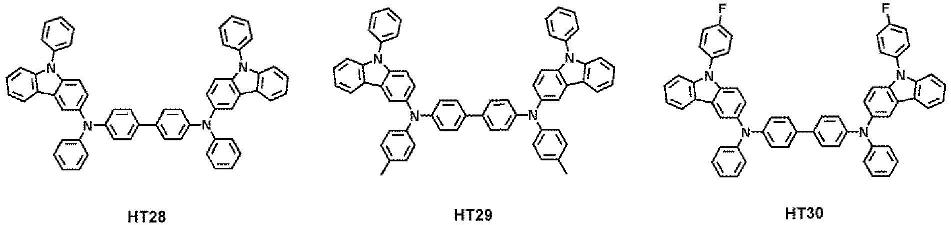

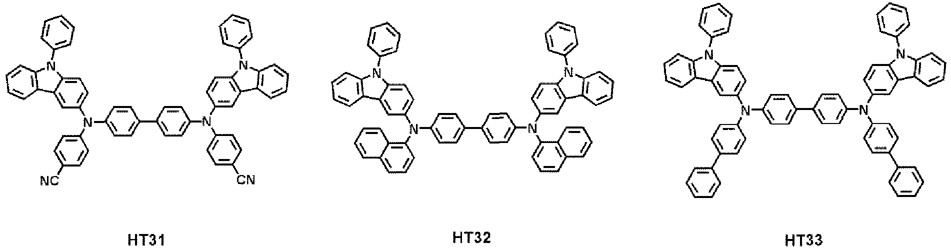

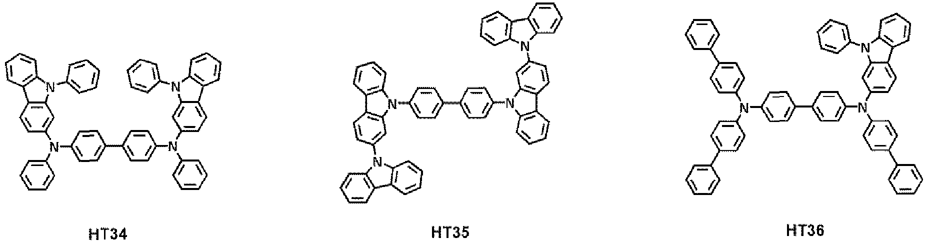

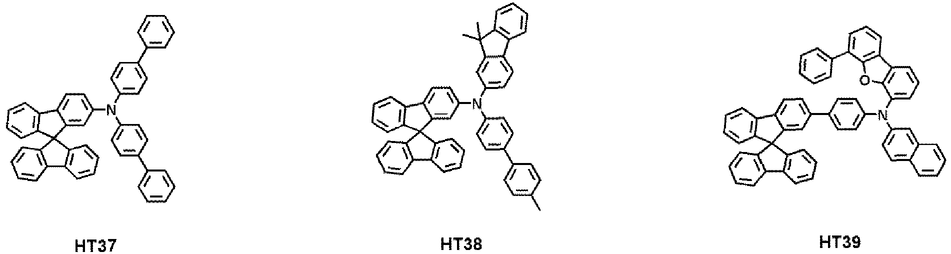

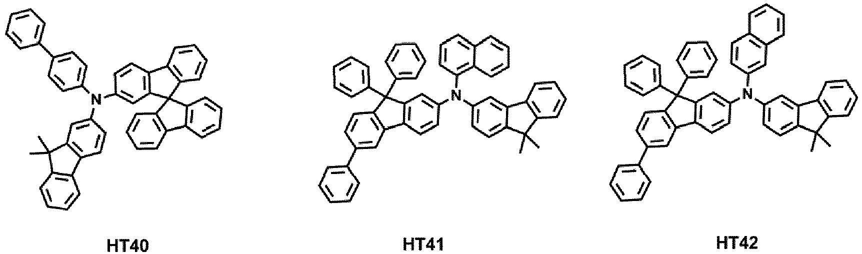

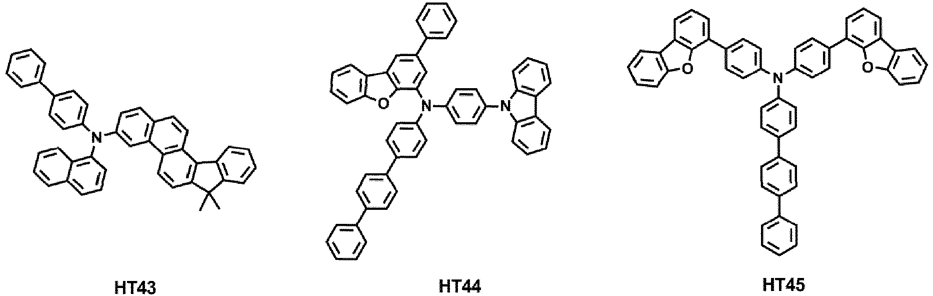

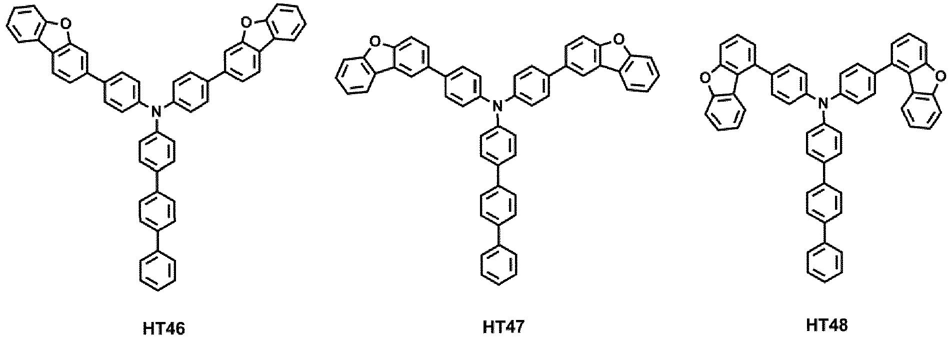

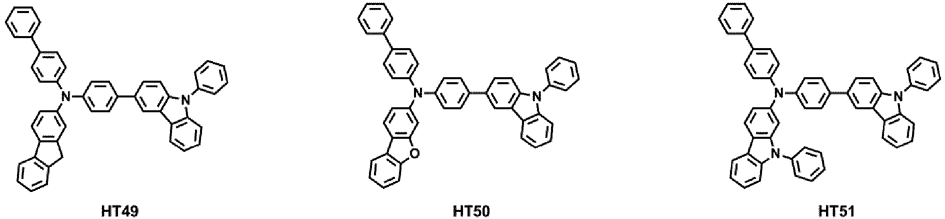

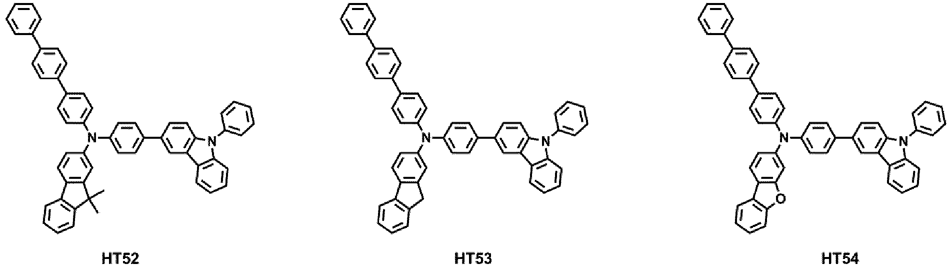

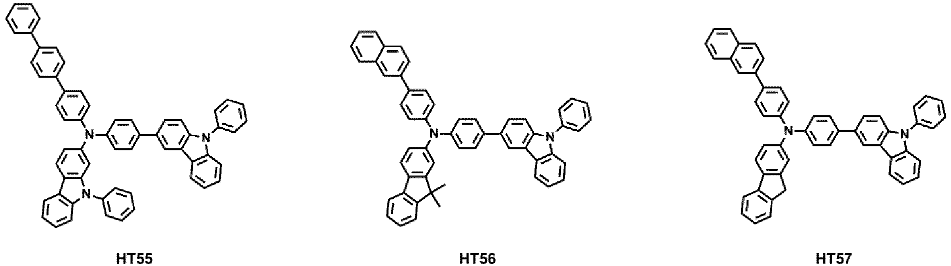

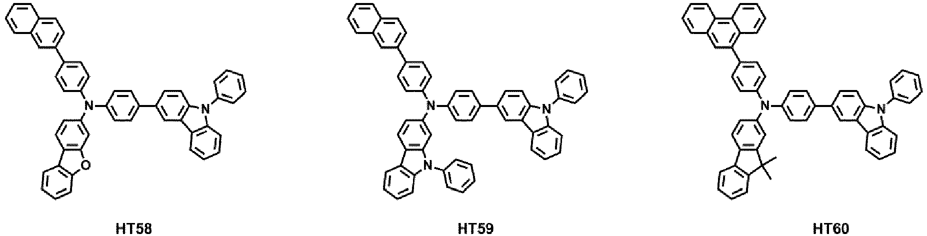

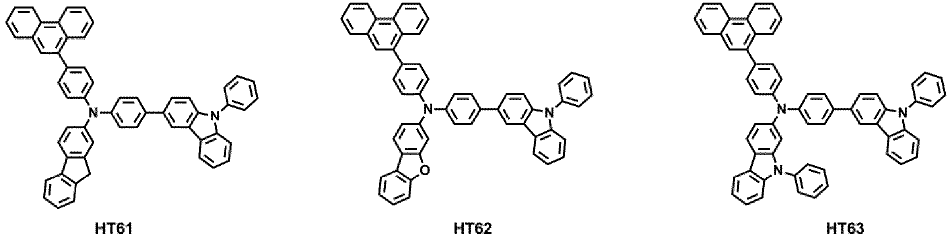

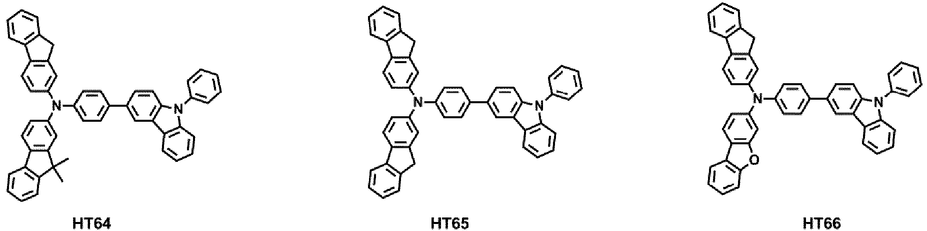

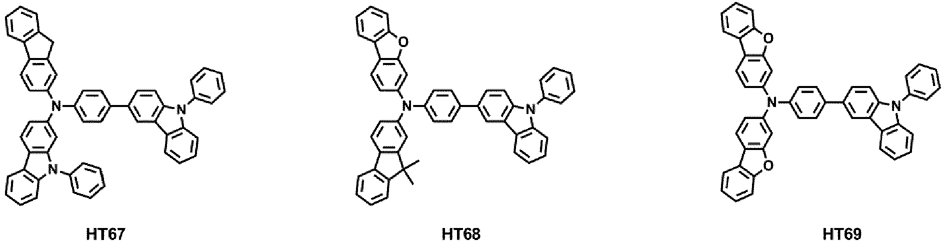

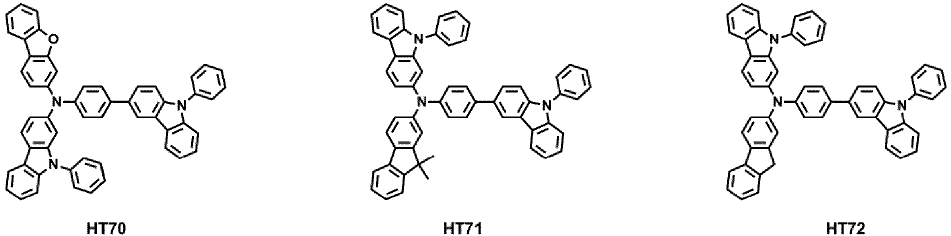

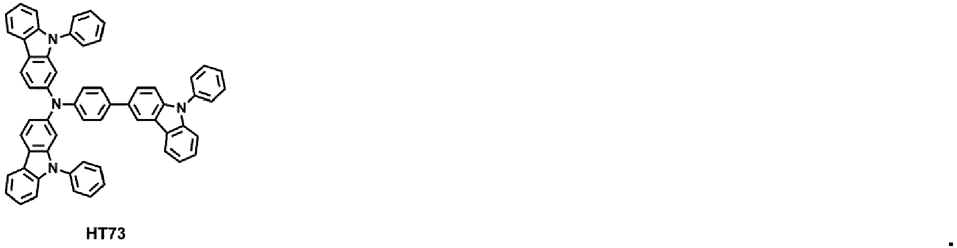

The amount of the first inorganic material included in the first doping layer 155P' may be about 0.01 parts by weight to about 49.9 parts by weight based on 100 parts by weight of the first organic material. In an embodiment, the amount of the first inorganic material included in the first doping layer 155P' may be about 0.1 parts by weight to about 49.9 parts by weight based on 100 parts by weight of the first organic material. In an embodiment, the amount of the first inorganic material included in the first doping layer 155P' may be about 0.1 parts by weight to about 20 parts by weight based on 100 parts by weight of the first organic material.

The amount of the second inorganic material included in the second doping layer 155P" may be about 0.01 parts by weight to about 49.9 parts by weight based on 100 parts by weight of the second organic material. In an embodiment, the amount of the second inorganic material included in the second doping layer 155P" may be about 0.1 parts by weight to about 49.9 parts by weight based on 100 parts by weight of the second organic material. In an embodiment, the amount of the second inorganic material included in the second doping layer 155P" may be about 0.1 parts by weight to about 20 parts by weight based on 100 parts by weight of the second organic material.

In an embodiment, the thickness of the first doping layer 155P' and the thickness of the second doping layer 155P" may each independently be about 1 Å to about 300 Å. In an embodiment, the thickness of the first doping layer 155P' and the thickness of the second doping layer 155P" may each independently be about 5 Å to about 200 Å. When the thickness of the first doping layer 155P' and the thickness of the second doping layer 155P" satisfy the above-described ranges, a high-quality organic light-emitting device may be implemented without a substantial increase in driving voltage.

The organic light-emitting device 10 includes the p-type charge generation layer 155P in a multi-layered structure including the first doping layer 155P' and the second doping layer 155P", in which charges are generated in the first doping layer 155P' and transferred to the neighboring second doping layer 155P", and the second doping layer 155P" may transfer the charges generated in the first doping layer 155P' to a light-emitting unit. Accordingly, compared to an organic light-emitting device using a p-type charge generation layer having a single-layered structure, the organic light-emitting device 10 may efficiently generate and transfer charges.

The first doping layer 155P' may efficiently generate holes when a p-n junction is formed with the n-type charge generation layer 155N, based on the principle that the conduction band of the n-type charge generation layer 155N has a band alignment with respect to the lowest unoccupied molecular orbital (LUMO) of the first material in the first doping layer 155P'.

The first doping layer 155P' may be provided as a mixed layer that includes the first organic material and the first inorganic material, wherein the first inorganic material is included as a dopant. In the organic light-emitting device 10 including the first doping layer 155P', in which the first inorganic material is doped in the matrix of the first organic material, the current may not leak in a direction substantially horizontal to the surface of the first doping layer 155P' and may flow in a direction substantially vertical thereto, leading to efficient delivery of charges to the light-emitting units 153. In some embodiments, the formation of islands including (e.g., consisting of) the first inorganic material alone may be prevented or reduced, so that the charges generated in the first doping layer 155P' may be efficiently transferred to the second doping layer 155P" and luminance imbalance of the light emitting surface of the organic light-emitting device 10 may be prevented or reduced. As such, the luminescence efficiency of the organic light-emitting device 10 may be improved.

The second organic material and the second inorganic material of the second doping layer 155P" may form a charge transfer complex (CT complex) to quickly transfer the charges transferred from the first doping layer 155P' to a neighboring light-emitting unit. The second doping layer 155P" may be provided as a mixed layer including the second organic material and the second inorganic material, wherein the second inorganic material may be included as a dopant. As such, in the organic light-emitting device 10 including the second doping layer 155P", in which the second inorganic material is doped in the matrix of the second organic material, the current may flow substantially vertically to the surface of the second doping layer 155P", without leakage in a direction substantially horizontal thereto. In addition, because a charge transfer complex may be formed in the second doping layer 155P", charges may be efficiently transferred to the light-emitting units 153. In some embodiments, the formation of islands including (e.g., consisting of) the second inorganic material alone may be prevented or reduced, so that the charges transferred by the first doping layer 155P' may be efficiently transferred to the light-emitting units 153 and the luminance imbalance of the light emitting surface of the organic light-emitting device 10 may be prevented or reduced. As such, the luminescence efficiency of the organic light-emitting device 10 may be improved.

In an embodiment, the (each) m-1 n-type charge generation layer 155N may include materials that may be included in an electron transport region described below.

In an embodiment, the (each) m-1 n-type charge generation layer 155N may include a metal-free compound containing at least one π electron deficient nitrogen-containing ring, a compound represented by Formula 601, a metal-containing material, or any combination thereof:

**Formula 601** [Ar₆₀₁]ₓₑ₁₁-[(L₆₀₁)ₓₑ₁-R₆₀₁]ₓₑ₂₁,

wherein, in Formula 601,
Ar₆₀₁ is a substituted or unsubstituted C₅-C₆₀ (*e.g*. C₅-C₃₀) carbocyclic group or a substituted or unsubstituted C₁-C₆₀ (*e.g*. C₁-C₂₀) heterocyclic group,
xe11 is 1, 2, or 3,
L₆₀₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g*. C₆-C₃₀) arylene group, a substituted or unsubstituted C₁-C₆₀ (*e.g*. C₁-C₂₀) heteroarylene group, a substituted or unsubstituted divalent non-aromatic condensed polycyclic group, and a substituted or unsubstituted divalent non-aromatic condensed heteropolycyclic group,
xe1 is an integer from 0 to 5,
R₆₀₁ is selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (*e.g.* C₆-C₃₀) aryloxy group, a substituted or unsubstituted C₆-C₆₀ (*e.g*. C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), -C(=O)(Q₆₀₁), - S(=O)₂(Q₆₀₁), and -P(=O)(Q₆₀₁)(Q₆₀₂),
Q₆₀₁ to Q₆₀₃ are each independently a C₁-C₁₀ alkyl group, a C₁-C₁₀ alkoxy group, a phenyl group, a biphenyl group, a terphenyl group, or a naphthyl group, and
xe21 is an integer from 1 to 5.

The metal-containing material may be metal, metal oxide, metal halide, or any combination thereof.

In an embodiment, when a metal is included as the metal-containing material, the metal may be an alkali metal, an alkaline earth metal, a rare earth metal, a transition metal, a post-transition metal, or any combination thereof, but embodiments of the present disclosure are not limited thereto.

In an embodiment, when a metal oxide is included as the metal-containing material, the metal oxide may be an alkali metal oxide, but embodiments of the present disclosure are not limited thereto.

In one or more embodiments, when a metal halide is included as the metal-containing material, the metal halide may be a halide of an alkali metal, but embodiments of the present disclosure are not limited thereto.

In an embodiment, the metal-containing material may be Yb, Ag, Al, Sm, Mg, Li, Rbl, KI, Ti, Rb, Na, K, Ba, Mn, YbSi₂ or any combination thereof, but embodiments of the present disclosure are not limited thereto. In an embodiment, the metal-containing material may be Yb, Ag, Al, Li, or any combination thereof, but embodiments of the present disclosure are not limited thereto.

The thickness of the n-type charge generation layer 155N may be about 1 Å to about 500 Å. In an embodiment, the thickness of the n-type charge generation layer 155N may be about 10 Å to about 200 Å or about 10 Å to about 100 Å, but is not limited thereto. When the thickness of the n-type charge generation layer 155N satisfies the above-described ranges, a high-quality organic light-emitting device may be implemented without a substantial increase in driving voltage.

In an embodiment, at least one emission layer of the m light-emitting units 153 may include a condensed cyclic compound represented by Formula 3: 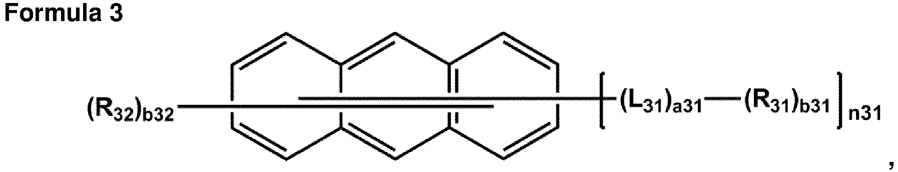 wherein, in Formula 3,
L₃₁ is selected from an unsubstituted or substituted C₅-C₆₀ (*e.g*. C₅-C₃₀) carbocyclic group and an unsubstituted or substituted C₁-C₆₀ (*e.g*. C₁-C₂₀) heterocyclic group,
a31 is an integer from 0 to 5,
R₃₁ and R₃₂ are each independently selected from hydrogen, deuterium, -F, - Cl, -Br, -I, a hydroxyl group, a cyano group, a nitro group, an amidino group, a hydrazine group, a hydrazone group, a substituted or unsubstituted C₁-C₆₀ (*e*.*g*. C₁-C₂₀) alkyl group, a substituted or unsubstituted C₂-C₆₀ (*e*.*g*. C₂-C₂₀) alkenyl group, a substituted or unsubstituted C₂-C₆₀ (*e.g*. C₂-C₂₀) alkynyl group, a substituted or unsubstituted C₁-C₆₀ (*e.g*. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₀) aryl group, a substituted or unsubstituted C₆-C₆₀ (e.g. C₆-C₃₀) aryloxy group, a substituted or unsubstituted C₆-C₆₀ (e.g. C₆-C₃₀) arylthio group, a substituted or unsubstituted C₁-C₆₀ (e.g. C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂),
b31 and b32 are each independently an integer from 1 to 5,
n31 is an integer from 1 to 3, and
at least one of the substituted C₅-C₆₀ (*e.g*. C₅-C₃₀) carbocyclic group, the substituted C₁-C₆₀ (*e.g.* C₁-C₂₀) heterocyclic group, the substituted C₁-C₆₀ (*e.g.* C₁-C₂₀) alkyl group, the substituted C₂-C₆₀ (*e.g*. C₂-C₂₀) alkenyl group, the substituted C₂-C₆₀ (*e.g.* C₂-C₂₀) alkynyl group, the substituted C₁-C₆₀ (*e.g.* C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (*e.g.* C₆-C₃₀) aryl group, the substituted C₆-C₆₀ (*e.g.* C₆-C₃₀) aryloxy group, the substituted C₆-C₆₀ (*e.g*. C₆-C₃₀) arylthio group, the substituted C₁-C₆₀ (*e.g*. C₁-C₂₀) heteroaryl group, the substituted monovalent non-aromatic condensed polycyclic group, or the substituted monovalent non-aromatic condensed heteropolycyclic group is selected from:
deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g*. C₁-C₂₀) alkoxy group,
a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g*. C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g*. C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), and -P(=O)(Q₂₁)(Q₂₂), and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂) ,
wherein Q₁₁ to Q₁₃, Q₂₁ to Q₂₃ and Q₃₁ to Q₃₃ are each independently selected from hydrogen, deuterium, -F, -Cl, -Br, -I, a hydroxyl group, a cyano group, a nitro group, an amidino group, a hydrazine group, a hydrazone group, a C₁-C₆₀ (*e.g*. C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g*. C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, a monovalent non-aromatic condensed heteropolycyclic group, a biphenyl group, and a terphenyl group.

In an embodiment, at least one emission layer of the m light-emitting units 153 may include a condensed cyclic compound represented by Formula 3-1: 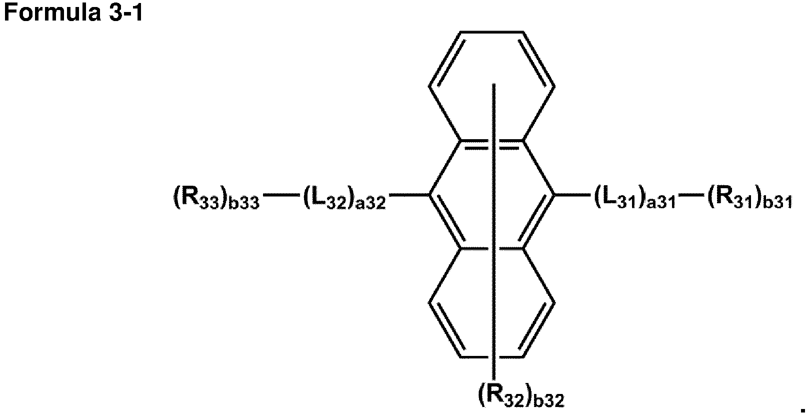
L₃₁, a31, R₃₁, R₃₂, b31, and b32 in Formula 3-1 are each independently the same as described above.
L₃₂ and R₃₃ are each independently the same as described in connection with L₃₁ and R₃₁,
a32 is an integer from 0 to 5, and
b33 is an integer from 0 to 5.

In an embodiment, at least one of R₃₁ or R₃₂ in Formula 3 and at least one of R₃₁ to R₃₃ in Formula 3-1 may be a group represented by one selected from Formulae 3A and 3B: 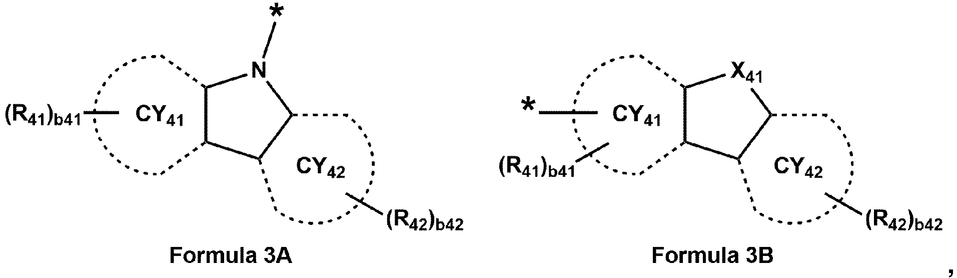 wherein, in Formulae 3A and 3B,
CY₄₁ and CY₄₂ are each independently selected from a C₅-C₃₀ (*e.g*. C₅-C₂₀) carbocyclic group, and a C₁-C₃₀ (*e.g*. C₁-C₂₀) heterocyclic group,
X₄₁ is selected from O, S, and N(R₄₃),
R₄₁ to R₄₃ are each independently selected from hydrogen, deuterium, -F, - Cl, -Br, -I, a hydroxyl group, a cyano group, a nitro group, an amidino group, a hydrazine group, a hydrazone group, a substituted or unsubstituted C₁-C₆₀ (*e.g*. C₁-C₂₀) alkyl group, a substituted or unsubstituted C₂-C₆₀ (*e.g*. C₂-C₂₀) alkenyl group, a substituted or unsubstituted C₂-C₆₀ (*e.g*. C₂-C₂₀) alkynyl group, a substituted or unsubstituted C₁-C₆₀ (*e.g*. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (*e.g*. C₆-C₃₀) aryloxy group, a substituted or unsubstituted C₆-C₆₀ (*e.g.* C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂),
b41 and b42 are each independently an integer from 1 to 10, and
* indicates a binding site to a neighboring atom.

In an embodiment, R₃₁ in Formula 3 and at least one of R₃₁ or R₃₃ in Formula 3-1 may be a group represented by one selected from Formulae 3A and 3B.

In an embodiment, at least one of R₃₁ or R₃₂ in Formula 3 and at least one of R₃₁ to R₃₃ in Formula 3-1 may be a group represented by one selected from Formulae 3A-1 and 3B-1 to 3B-12: 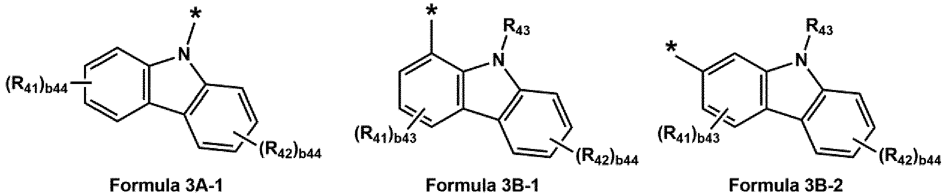 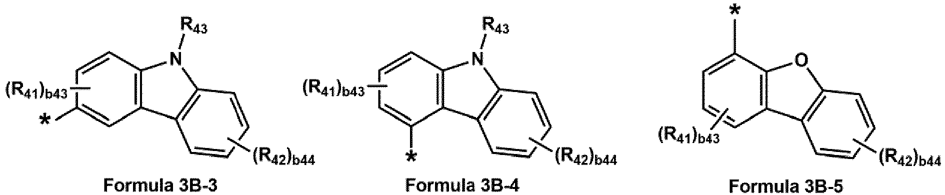 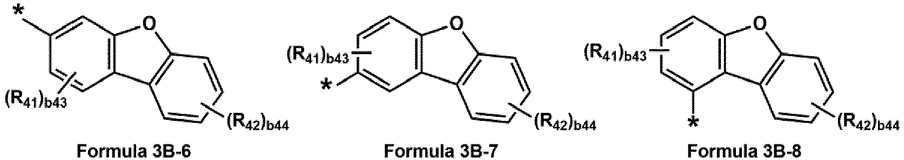 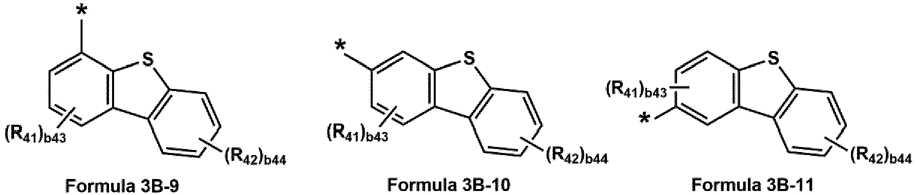 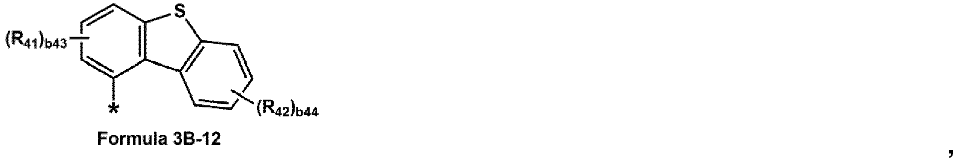 wherein, in Formulae 3A-1 and 3B-1 to 3B-12,
R₄₁ to R₄₃ are each independently the same as described in connection with Formulae 3A and 3B,
b43 is an integer from 1 to 3,
b44 is an integer from 1 to 4, and
* indicates a binding site to a neighboring atom.

In an embodiment, R₃₁ in Formula 3 and at least one of R₃₁ or R₃₃ in Formula 3-1 may each independently be a group represented by one selected from Formulae 3A-1 and 3B-1 to 3B-12.

In an embodiment, a compound represented by Formula 3 and a compound represented by Formula 3-1 may each act as a host in an emission layer.

In an embodiment, at least one emission layer in the m light-emitting units 153 may include one of Compounds H1 to H24, one of Compounds BH1 to BH13, 9,10-di(2-naphthyl)anthracene (ADN), 2-methyl-9,10-bis(naphthalen-2-yl)anthracene (MADN), or any combination thereof, but embodiments of the present disclosure are not limited thereto:

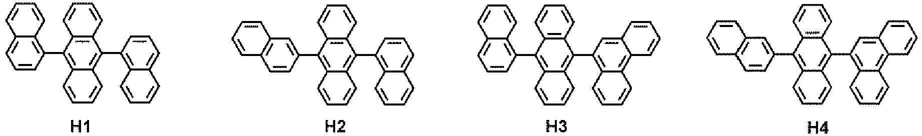

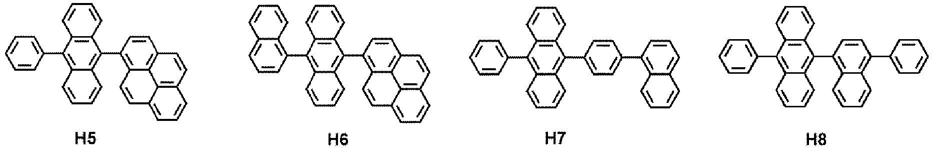

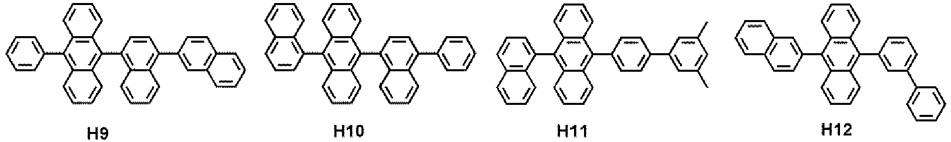

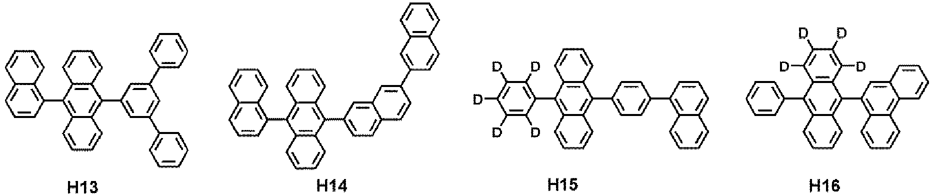

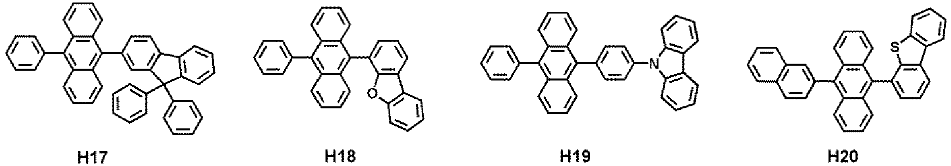

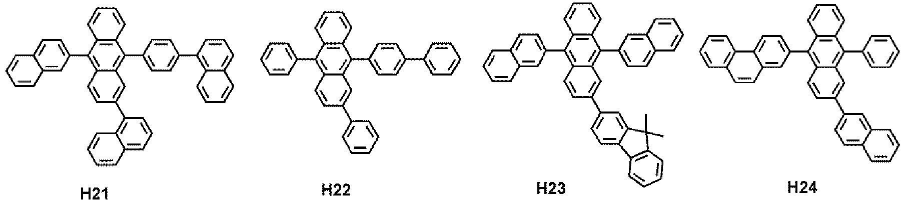

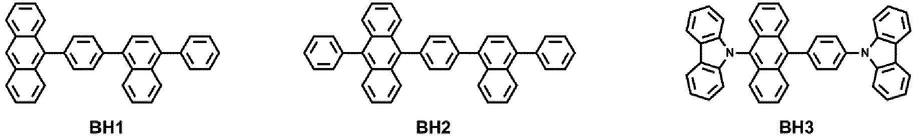

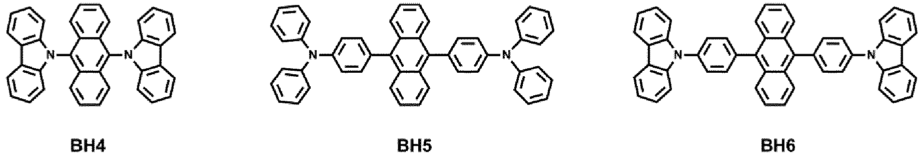

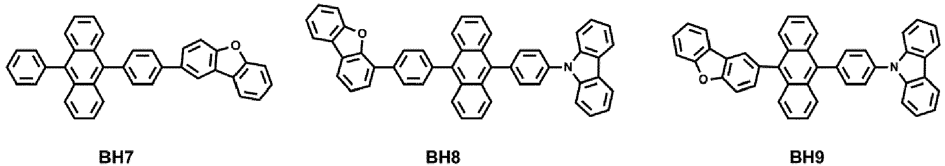

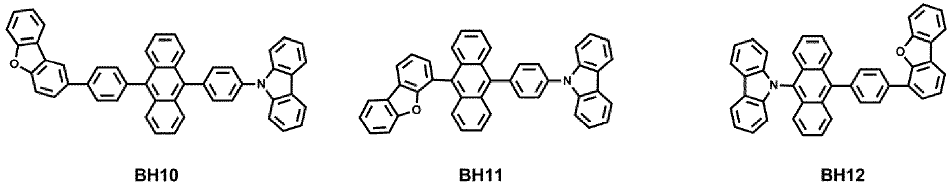

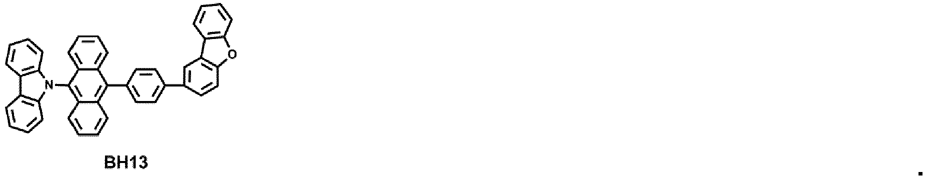

In an embodiment, at least one emission layer of the m light-emitting units 153 may include a condensed cyclic compound represented by Formula 4: 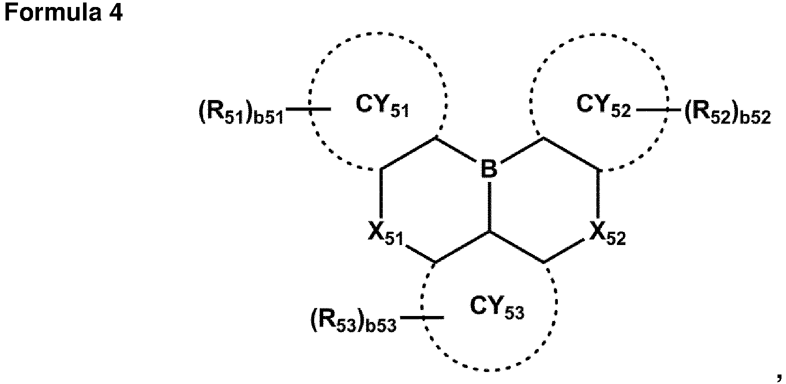 wherein, in Formula 4,
X₅₁ is selected from C(R₅₄)(R₅₅), N(R₅₄), O, and S,
X₅₂ is selected from C(R₅₆)(R₅₇), N(R₅₆), O, and S,
CY₅₁ to CY₅₃ are each independently selected from a C₅-C₃₀ (*e.g*. C₅-C₂₀) carbocyclic group and a C₁-C₃₀ (*e.g*. C₁-C₂₀) heterocyclic group,
R₅₁ to R₅₃ and R₅₄ to R₅₇ are each independently selected from hydrogen, deuterium, -F, -Cl, -Br, -I, a hydroxyl group, a cyano group, a nitro group, an amidino group, a hydrazine group, a hydrazone group, a substituted or unsubstituted C₁-C₆₀ (*e.g.* C₁-C₂₀) alkyl group, a substituted or unsubstituted C₂-C₆₀ (*e.g.* C₂-C₂₀) alkenyl group, a substituted or unsubstituted C₂-C₆₀ (*e.g*. C₂-C₂₀) alkynyl group, a substituted or unsubstituted C₁-C₆₀ (*e.g*. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (*e.g*. C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂),
b51 to b53 are each independently an integer from 1 to 10,
when b51, b52, and/or b53 are at least two, two neighboring R₅₁ groups, two neighboring R₅₂ groups, and/or two neighboring R₅₃ groups, respectively, are optionally linked to form a C₅-C₃₀ (*e.g.* C₅-C₂₀) carbocyclic group or a C₁-C₃₀ (*e.g.* C₁-C₂₀) heterocyclic group,
at least one of the substituted C₁-C₆₀ (*e.g*. C₁-C₂₀) alkyl group, the substituted C₂-C₆₀ (*e.g.* C₂-C₂₀) alkenyl group, the substituted C₂-C₆₀ (*e.g.* C₂-C₂₀) alkynyl group, the substituted C₁-C₆₀ (*e.g*. C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (*e.g.* C₆-C₃₀) aryl group, the substituted C₆-C₆₀ (*e.g.* C₆-C₃₀) aryloxy group, the substituted C₆-C₆₀ (*e.g.* C₆-C₃₀) arylthio group, the substituted C₁-C₆₀ (*e.g.* C₁-C₂₀) heteroaryl group,the substituted monovalent non-aromatic condensed polycyclic group, or the substituted monovalent non-aromatic condensed heteropolycyclic group is selected from:
   deuterium, -F, -Cl, -Br, -I, a hydroxyl group, a cyano group, a nitro group, an amidino group, a hydrazino group, a hydrazono group, a C₁-C₆₀ (*e.g*. C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (e.g. C₁-C₂₀) alkoxy group,
   a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), and -P(=O)(Q₁₁)(Q₁₂);
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g*. C₁-C₂₀) heteroaryl group, a monovalent non-aromatic condensed polycyclic group, and a monovalent non-aromatic condensed heteropolycyclic group;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g*. C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g*. C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), and -P(=O)(Q₂₁)(Q₂₂), and
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
   wherein Q₁₁ to Q₁₃, Q₂₁ to Q₂₃ and Q₃₁ to Q₃₃ are each independently selected from hydrogen, deuterium, -F, -Cl, -Br, -I, a hydroxyl group, a cyano group, a nitro group, an amidino group, a hydrazine group, a hydrazone group, a C₁-C₆₀ (*e.g*. C₁-C₂₀) alkyl group, a C₂-C₆₀ *(e.g.* C₂-C₂₀) alkenyl group, a C₂-C₆₀ *(e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, a monovalent non-aromatic condensed heteropolycyclic group, a biphenyl group, and a terphenyl group.

In an embodiment, at least one emission layer of the m light-emitting units 153 may include a condensed cyclic compound represented by Formula 4-1:

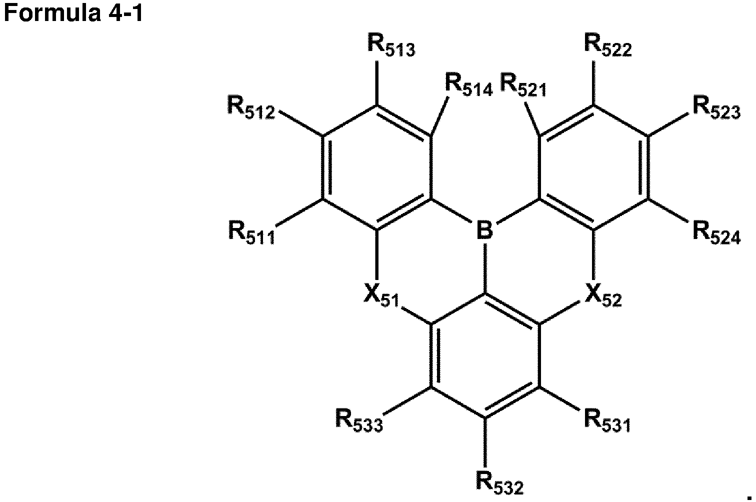

In Formula 4-1,
X₅₁ and X₅₂ are each independently the same as described above,
R₅₁₁ to R₅₁₄, R₅₂₁ to R₅₂₄ and R₅₃₁ to R₅₃₃ are each independently the same as described in connection with R₅₁ to R₅₃, and
two neighboring R₅₁₁ to R₅₁₄ groups, two neighboring R₅₂₁ to R₅₂₄ groups, and/or two neighboring R₅₃₁ to R₅₃₃ groups are optionally linked to form a C₅-C₃₀ (*e.g*. C₅-C₂₀) carbocyclic group or a C₁-C₃₀ (*e.g*. C₁-C₂₀) heterocyclic group.

In an embodiment, the condensed cyclic compound represented by Formula 4 and the condensed cyclic compound represented by Formula 4-1 may act as a dopant in an emission layer.

In an embodiment, at least one emission layer in the m light-emitting units 153 may include at least one selected from Compounds BD1 to BD19, but embodiments of the present disclosure are not limited thereto:

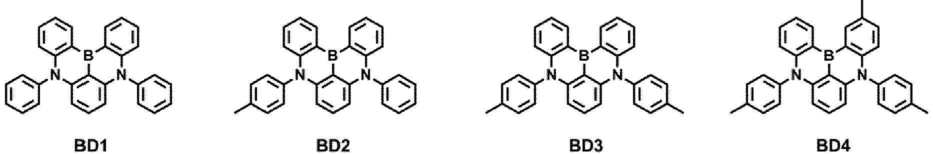

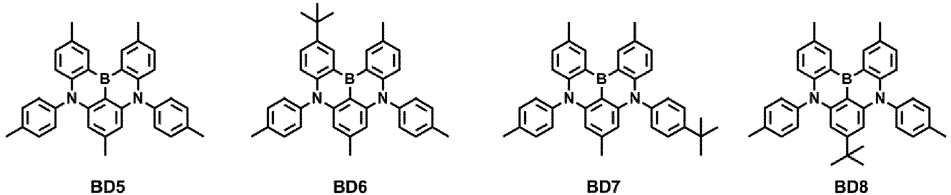

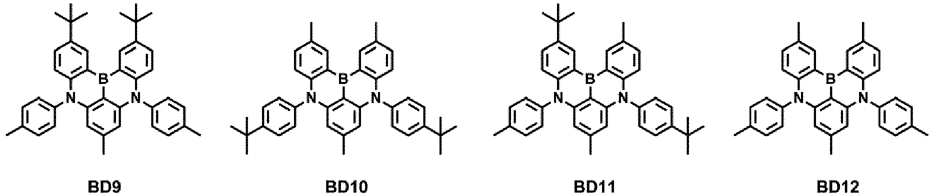

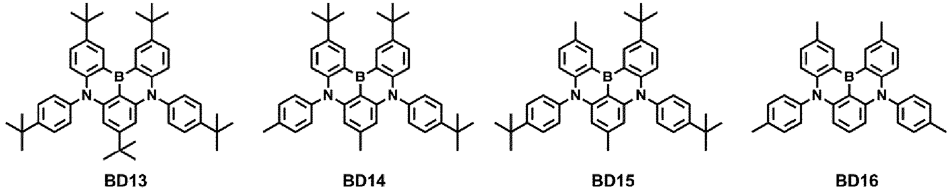

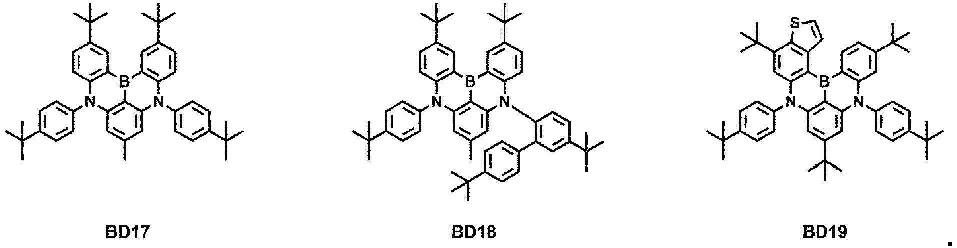

The condensed cyclic compound represented by Formula 4 includes a polycyclic condensed structure containing a boron atom, and may therefore have an increased separation between its highest occupied molecular orbital (HOMO) and lowest unoccupied molecular orbital (LUMO) due to multiple resonance effects. Further, due to the polycyclic condensed structure, the condensed cyclic compound may emit light having a narrow full width at half maximum (FWHM). Accordingly, the color purity of light emitted from the organic light-emitting device 10 may be improved, and the optical resonance utilization efficiency of the organic light-emitting device 10 may be improved, leading to a higher luminescence efficiency.

In an embodiment, in the organic light-emitting device 10, at least one emission layer of the m light-emitting units may include a host and a dopant, where the host may include the condensed cyclic compound represented by Formula 3, and the dopant may include the condensed cyclic compound represented by Formula 4, but embodiments of the present disclosure are not limited thereto.

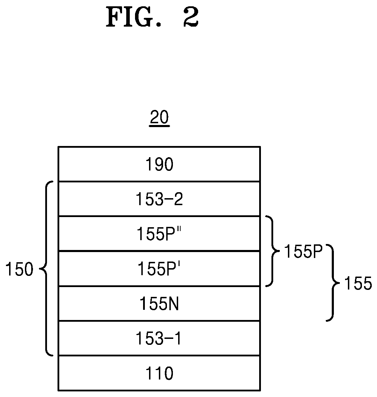

FIG. 2 is a schematic cross-sectional view of an organic light-emitting device 20 according to an embodiment. FIG. 2 shows an example of an organic light-emitting device when m is 2.

The organic light-emitting device 20 of FIG. 2 includes the first electrode 110, the second electrode 190 facing the first electrode 110, a first light-emitting unit 153-1 stacked between the first electrode 110 and the second electrode 190, a second light-emitting unit 153-2 located between the first light-emitting unit 153-1 and the second electrode 190, and the charge generation layer 155 located between the first light-emitting unit 153-1 and the second light-emitting unit 153-2. The charge generation layer 155 includes the n-type charge generation layer 155N and the p-type charge generation layer 155P, and the p-type charge generation layer 155P includes the first doping layer 155P' and the second doping layer 155P".

The first electrode 110, first light-emitting unit 153-1, second light-emitting unit 153-2, charge generation layer 155, and second electrode 190 of the organic light-emitting device 20 may be understood by referring to the corresponding description provided above.

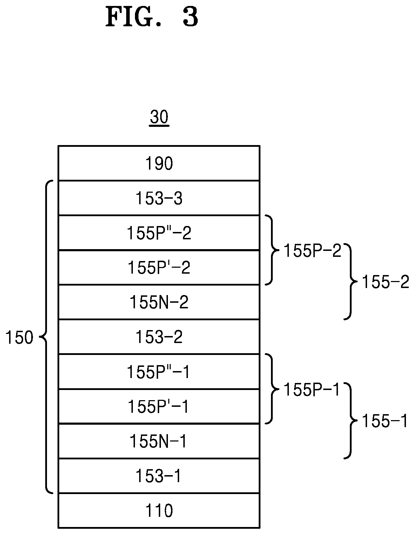

FIG. 3 is a schematic cross-sectional view of an organic light-emitting device 30 according to an embodiment. FIG. 3 shows an example of an organic light-emitting device when m is 3.

The organic light-emitting device 30 of FIG. 3 includes the first electrode 110, the second electrode 190 facing the first electrode, the first light-emitting unit 153-1 stacked between the first electrode 110 and the second electrode 190, the second light-emitting unit 153-2 located between the first light-emitting unit 153-1 and the second electrode 190, a third light-emitting unit 153-3 located between the second light-emitting unit 153-2 and the second electrode 190, a first charge generation layer 155-1 located between the first light-emitting unit 153-1 and the second light-emitting unit 153-2, and a second charge generation layer 155-2 located between the second light-emitting unit 153-2 and the third light-emitting unit 153-3.

The first charge generation layer 155-1 includes a first n-type charge generation layer 155N-1 and a first p-type charge generation layer 155P-1, and the first p-type charge generation layer 155P-1 includes a first doping layer 155P'-1 and a second doping layer 155P"-1.

The second charge generation layer 155-2 includes a second n-type charge generation layer 155N-2 and a second p-type charge generation layer 155P-2, and the second p-type charge generation layer 155P-2 includes a first doping layer 155P'-2 and a second doping layer 155P"-2.

The first electrode 110, the first light-emitting unit 153-1, the second light-emitting unit 153-2, the third light-emitting device 153-3, the first charge generation layers 155-1, the second charge generation layer 155-2, and the second electrode 190 of the organic light-emitting device 30 may each be understood by referring to the description provided above.

FIG. 3 shows that the first charge generation layer 155-1 and the second charge generation layer 155-2 each includes a first doping layer 155P'-1 or 155P'-2 and a second doping layer 155P"-1 or 155P"-2. In one or more embodiments, one of the first charge generation layer 155-1 and the second charge generation layer 155-2 may include the first doping layer and the second doping layer, and the other charge generation layer may have a p-type charge generation layer of single-layered structure (e.g., consisting of a single layer).

### [First electrode 110]

In FIGS. 1 to 3, a substrate may be additionally located under the first electrode 110 or above the second electrode 190. The substrate may be a glass substrate and/or a plastic substrate, each having excellent mechanical strength, thermal stability, transparency, surface smoothness, ease of handling, and water resistance.

The first electrode 110 may be formed by, for example, depositing or sputtering a material for forming the first electrode 110 on the substrate. When the first electrode 110 is an anode, the material for the first electrode 110 may be selected from materials with a high work function to facilitate hole injection.

The first electrode 110 may be a reflective electrode, a semi-transmissive electrode, or a transmissive electrode. When the first electrode 110 is a transmissive electrode, a material for forming the first electrode 110 may be selected from indium tin oxide (ITO), indium zinc oxide (IZO), tin oxide (SnO₂), zinc oxide (ZnO), and any combination thereof, but embodiments of the present disclosure are not limited thereto. In one or more embodiments, when the first electrode 110 is a semi-transmissive electrode or a reflective electrode, a material for forming the first electrode 110 may be selected from magnesium (Mg), silver (Ag), aluminium (Al), aluminium-lithium (Al-Li), calcium (Ca), magnesium-indium (Mg-In), magnesium-silver (Mg-Ag), and any combination thereof, but embodiments of the present disclosure are not limited thereto.

The first electrode 110 may have a single-layered structure or a multi-layered structure including two or more layers. In an embodiment, the first electrode 110 may have a three-layered structure of ITO/Ag/ITO, but the structure of the first electrode 110 is not limited thereto.

### [Organic layer 150]

An organic layer 150 is located on the first electrode 110. The organic layer 150 may include light-emitting units 153, 153-1, 153-2, and 153-3.

The organic light-emitting devices illustrated in FIG. 2 or 3 include two or three light-emitting units. However, the number of light-emitting units of an organic light-emitting device according to the present disclosure is not limited thereto, and, when needed, four or more light-emitting units may be included.

The organic layer 150 may further include a hole transport region located between the first electrode 110 and the light-emitting unit 153, 153-1, 153-2, or 153-3, and an electron transport region located between the light-emitting unit 153, 153-1, 153-2, or 153-3 and the second electrode 190.

### [Hole transport region in organic layer 150]

The hole transport region may have i) a single-layered structure including (e.g., consisting of) a single material, ii) a single-layered structure including a plurality of different materials, or iii) a multi-layered structure having a plurality of layers including a plurality of different materials.

The hole transport region may include at least one layer selected from a hole injection layer, a hole transport layer, an emission auxiliary layer, and an electron blocking layer.

In an embodiment, the hole transport region may have a single-layered structure including a plurality of different materials, or a multi-layered structure having a hole injection layer/hole transport layer, a hole injection layer/hole transport layer/emission auxiliary layer, a hole injection layer/emission auxiliary layer, a hole transport layer/emission auxiliary layer, or a hole injection layer/hole transport layer/electron blocking layer, wherein the constituting layers of each structure are sequentially stacked from the first electrode 110 in this stated order, but the structure of the hole transport region is not limited thereto.

The hole transport region may include at least one selected from m-MTDATA, TDATA, 2-TNATA, NPB(NPD), β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylene dioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201, and a compound represented by Formula 202: 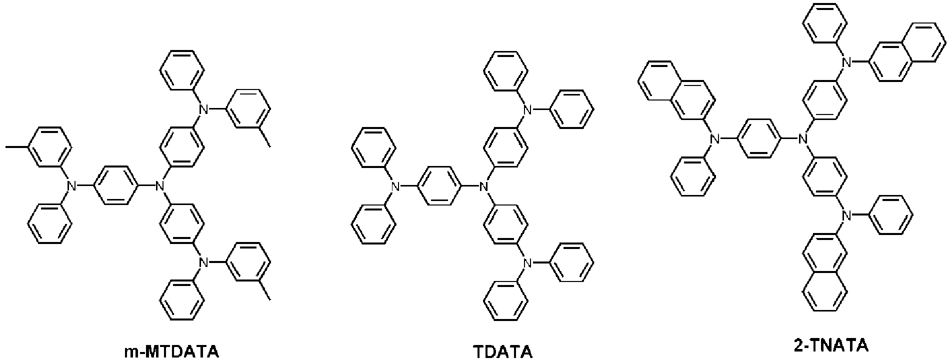 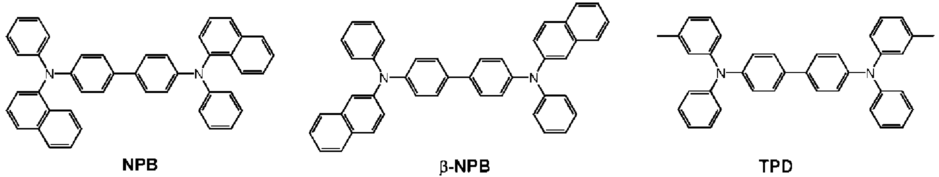 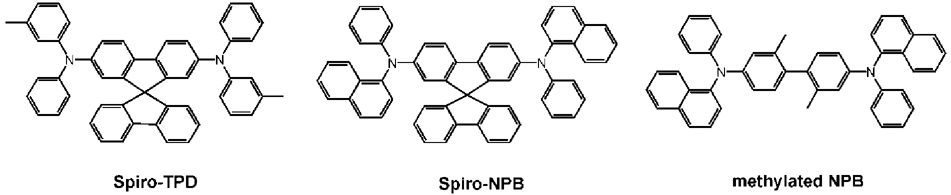 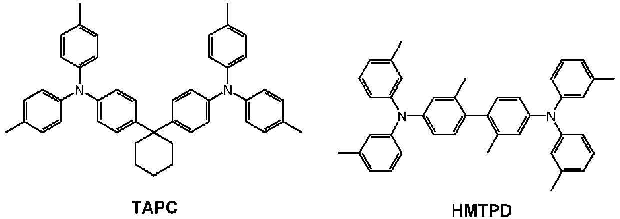 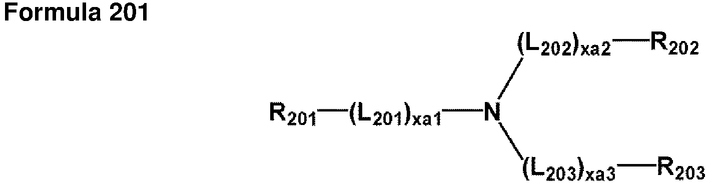 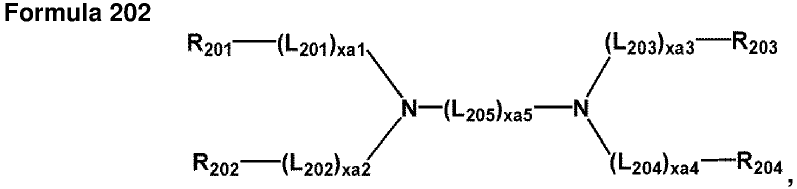 wherein, in Formulae 201 and 202,
L₂₀₁ to L₂₀₄ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (e.g. C₆-C₃₂) arylene group, a substituted or unsubstituted C₁-C₆₀ (e.g. C₁-C₂₀) heteroarylene group, a substituted or unsubstituted divalent non-aromatic condensed polycyclic group, and a substituted or unsubstituted divalent non-aromatic condensed heteropolycyclic group,
L₂₀₅ is selected from *-O-*', *-S-*', *-N(Q₂₀₁)-*', a substituted or unsubstituted C₁-C₂₀ (*e.g.* C₁-C₁₀) alkylene group, a substituted or unsubstituted C₂-C₂₀ (*e.g.* C₂-C₁₀) alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g*. C₆-C₃₂) arylene group, a substituted or unsubstituted C₁-C₆₀ (*e.g*. C₁-C₂₀) heteroarylene group, a substituted or unsubstituted divalent non-aromatic condensed polycyclic group, and a substituted or unsubstituted divalent non-aromatic condensed heteropolycyclic group,
xa1 to xa4 are each independently an integer from 0 to 3,
xa5 is an integer from 1 to 10, and
R₂₀₁ to R₂₀₄ and Q₂₀₁ are each independently selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₂) aryl group, a substituted or unsubstituted C₆-C₆₀ (*e.g.* C₆-C₃₂) aryloxy group, a substituted or unsubstituted C₆-C₆₀ (*e.g.* C₆-C₃₂) arylthio group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group.

In an embodiment, R₂₀₁ and R₂₀₂ in Formula 202 may optionally be linked to each other via a single bond, a dimethyl-methylene group, or a diphenyl-methylene group, and R₂₀₃ and R₂₀₄ may optionally be linked to each other via a single bond, a dimethyl-methylene group, or a diphenyl-methylene group.

In an embodiment, in Formulae 201 and 202,
L₂₀₁ to L₂₀₅ may each independently be selected from:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃) and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be 0, 1, or 2.

In one or more embodiments, xa5 may be 1, 2, 3, or 4.

In one or more embodiments, R₂₀₁ to R₂₀₄ and Q₂₀₁ may each independently be selected from a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃) and -N(Q₃₁)(Q₃₂),
wherein Q₃₁ to Q₃₃ may each independently be the same as described above.

In one or more embodiments, at least one selected from R₂₀₁ to R₂₀₃ in Formula 201 may each independently be selected from:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

In one or more embodiments, in Formula 202, i) R₂₀₁ and R₂₀₂ may be linked to each other via a single bond, and/or ii) R₂₀₃ and R₂₀₄ may be linked to each other via a single bond.

In one or more embodiments, at least one of R₂₀₁ to R₂₀₄ in Formula 202 may be selected from;
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

The compound represented by Formula 201 may be represented by Formula 201-1:

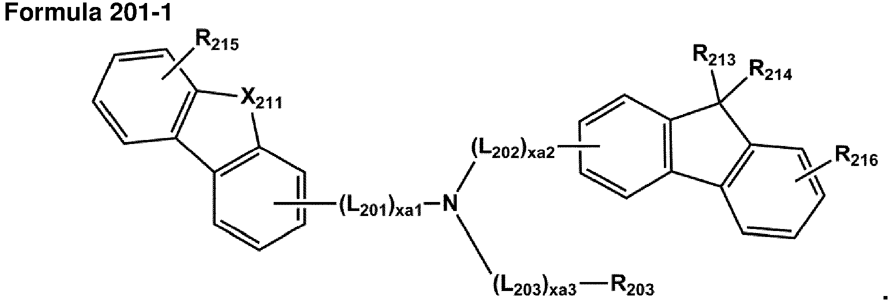

In an embodiment, the compound represented by Formula 201 may be represented by Formula 201-2, but embodiments of the present disclosure are not limited thereto:

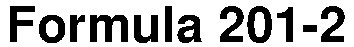

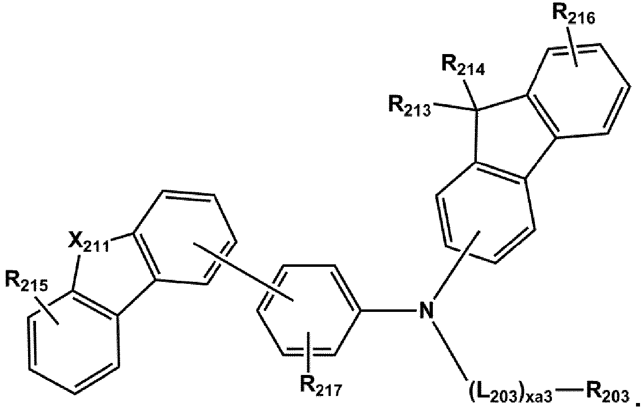

In one or more embodiments, the compound represented by Formula 201 may be represented by Formula 201-2(1), but embodiments of the present disclosure are not limited thereto:

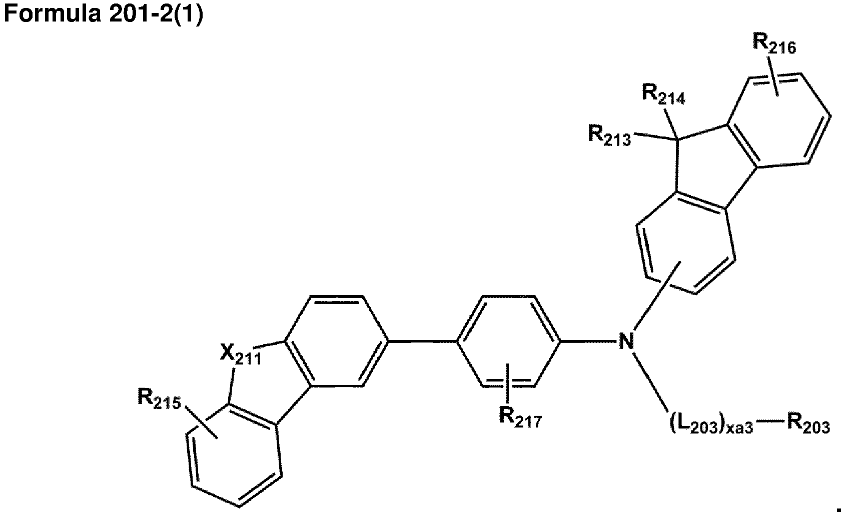

In one or more embodiments, the compound represented by Formula 201 may be represented by Formula 201A:

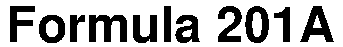

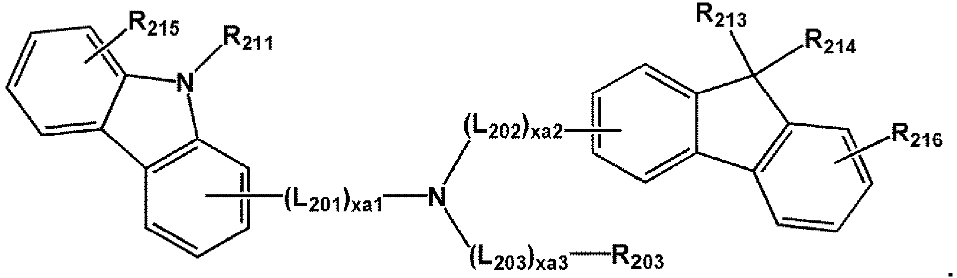

In one or more embodiments, the compound represented by Formula 201 may be represented by Formula 201A(1), but embodiments of the present disclosure are not limited thereto:

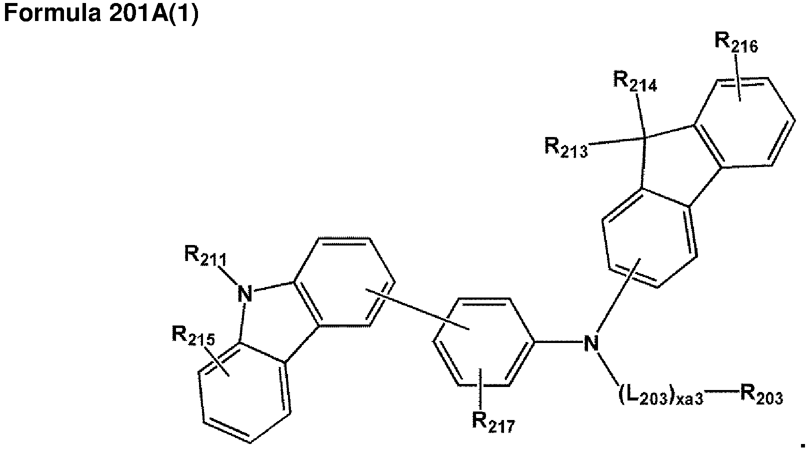

In one or more embodiments, the compound represented by Formula 201 may be represented by Formula 201A-1, but embodiments of the present disclosure are not limited thereto:

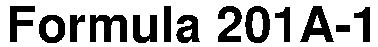

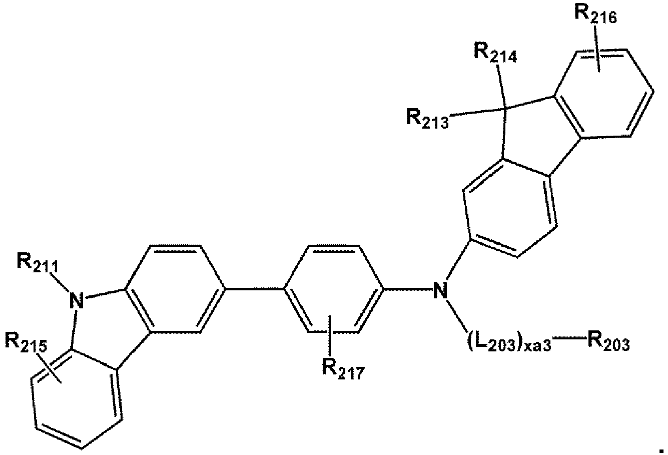

In one or more embodiments, the compound represented by Formula 202 may be represented by Formula 202-1:

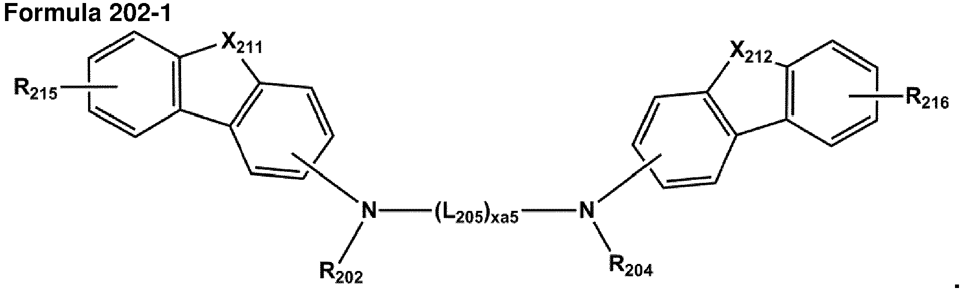

In one or more embodiments, the compound represented by Formula 202 may be represented by Formula 202-1 (1):

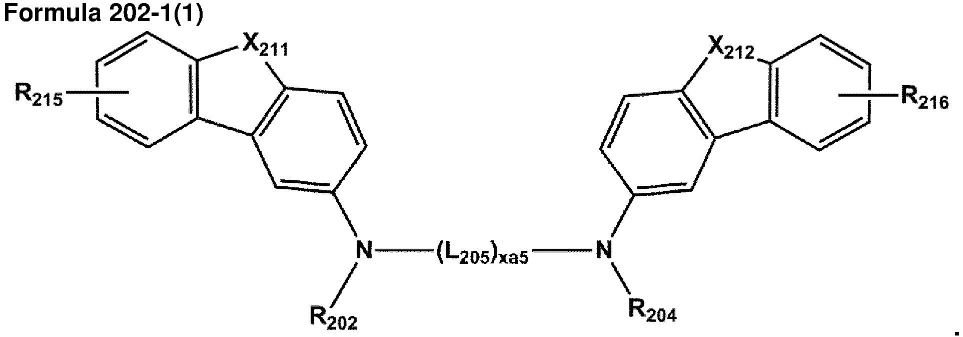

In one embodiment, the compound represented by Formula 202 may be represented by Formula 202A:

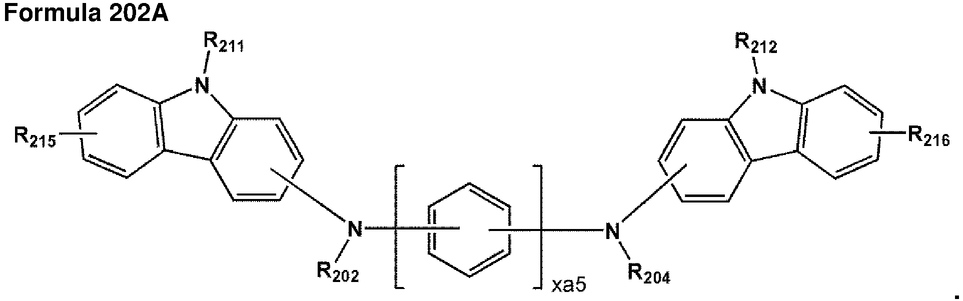

In one or more embodiments, the compound represented by Formula 202 may be represented by Formula 202A-1:

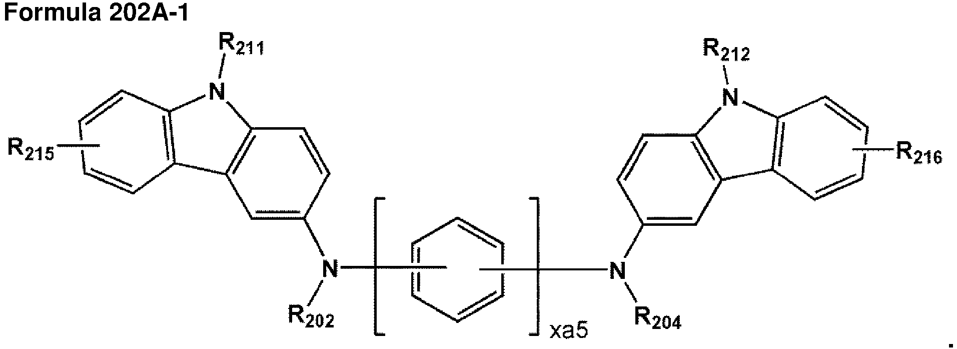

In Formulae 201-1, 201-2, 201-2(1), 201A, 201A(1), 201A-1, 202-1, 202-1(1), 202A, and 202A-1,
L₂₀₁ to L₂₀₃, xa1 to xa3, xa5, and R₂₀₂ to R₂₀₄ may each independently be the same as described above,
L₂₀₅ may be selected from a phenylene group, and a fluorenylene group,
X₂₁₁ may be selected from O, S, and N(R₂₁₁),
X₂₁₂ may be selected from O, S, and N(R₂₁₂),
R₂₁₁ and R₂₁₂ may each independently be the same as described in connection with R₂₀₃, and
R₂₁₃ to R₂₁₇ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT48, but embodiments of the present disclosure are not limited thereto:

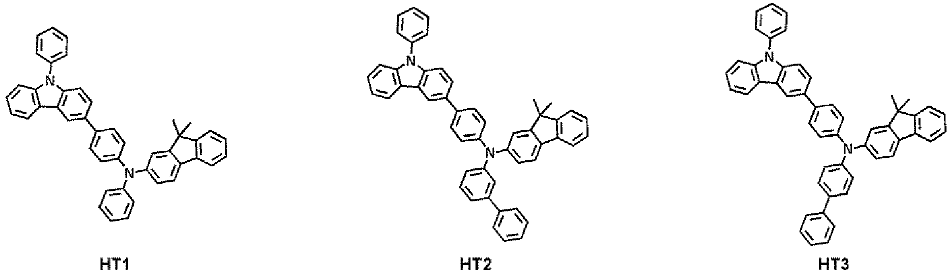

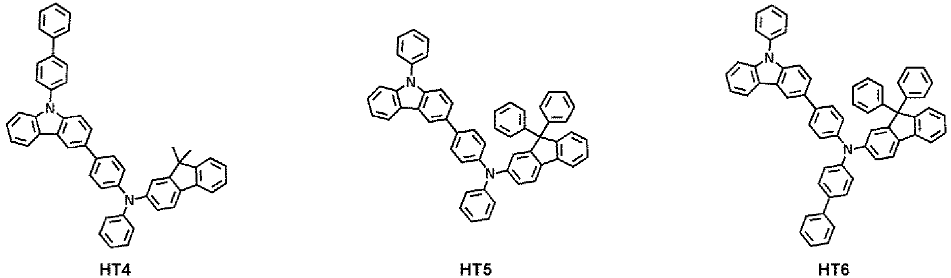

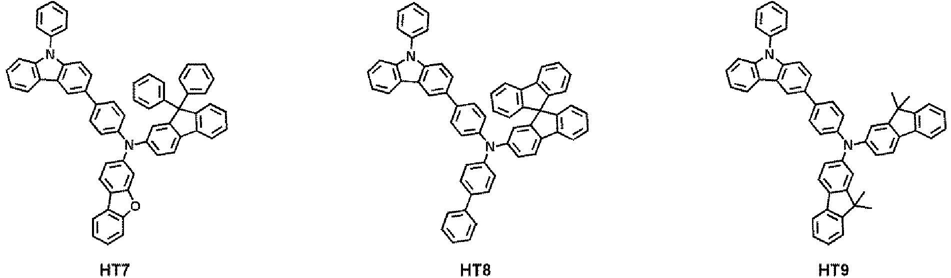

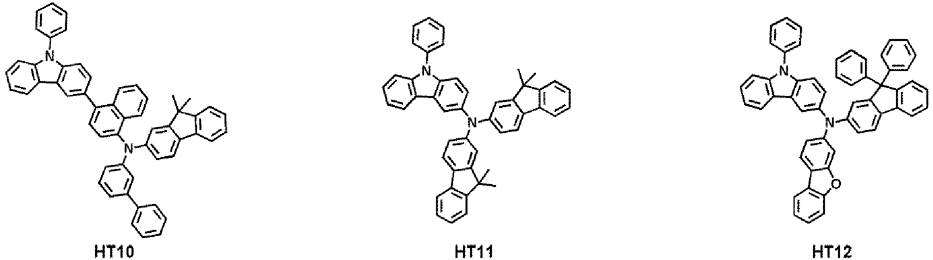

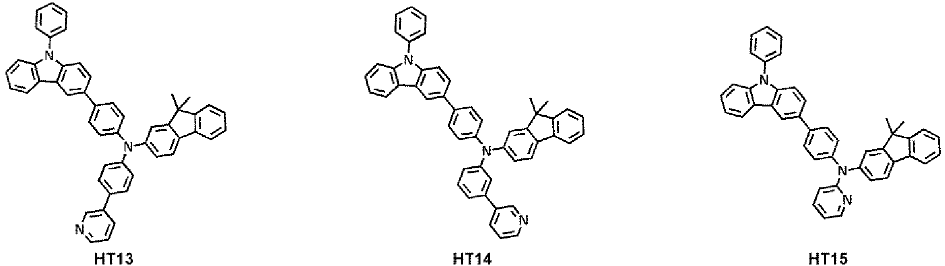

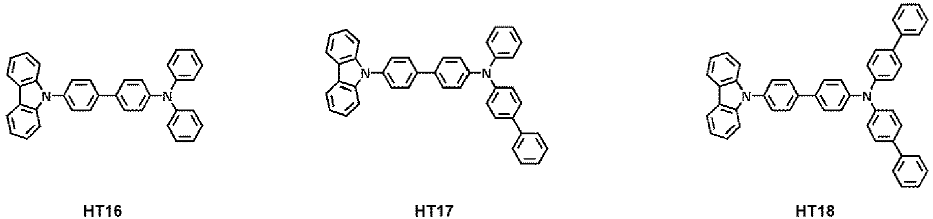

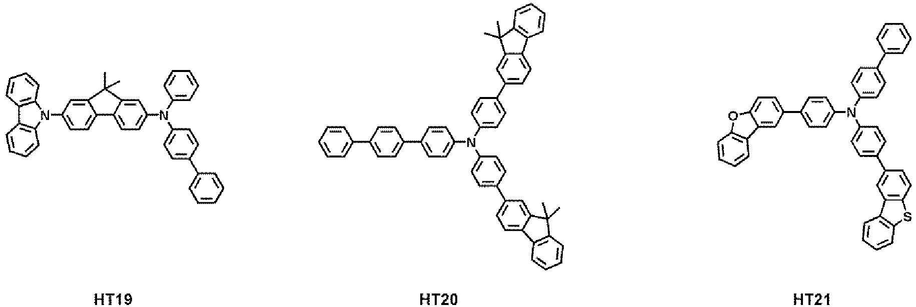

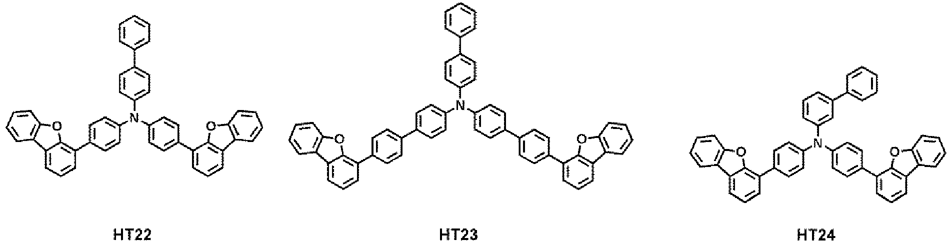

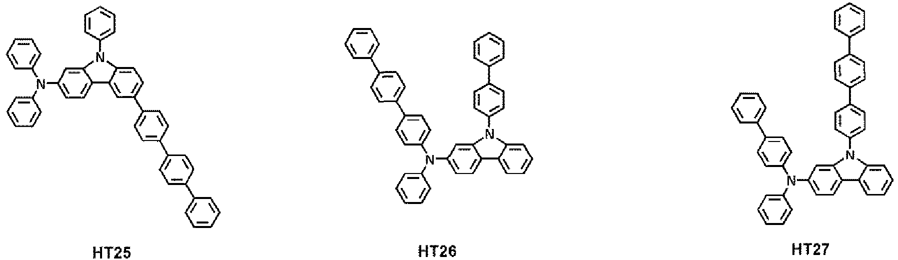

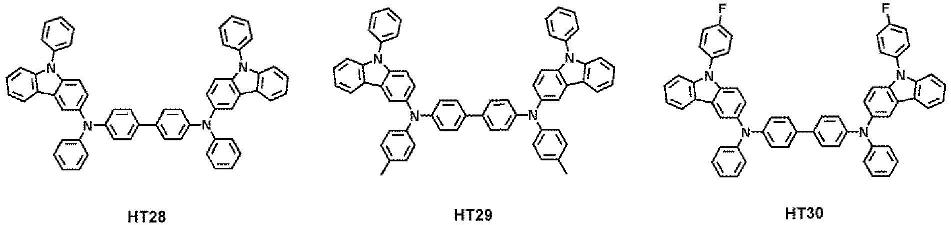

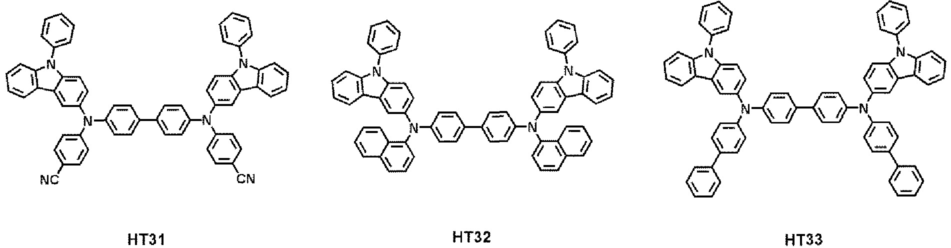

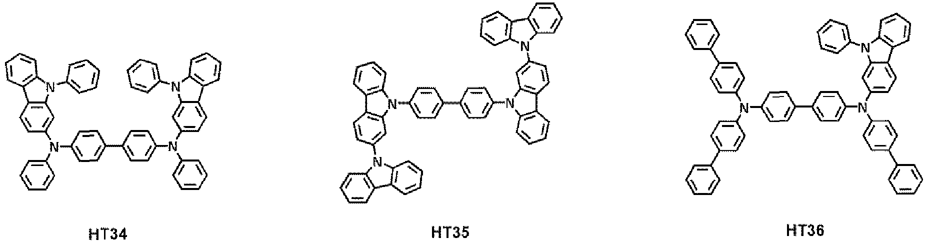

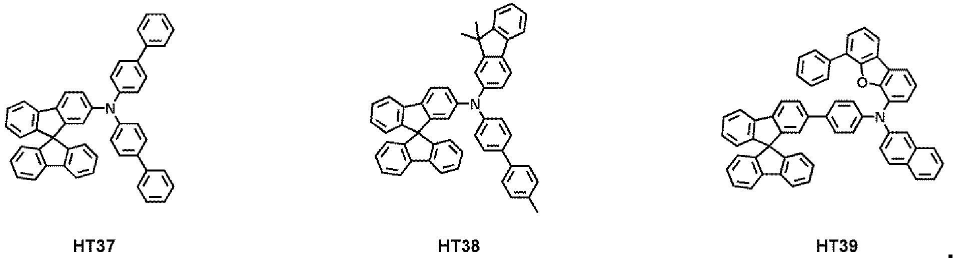

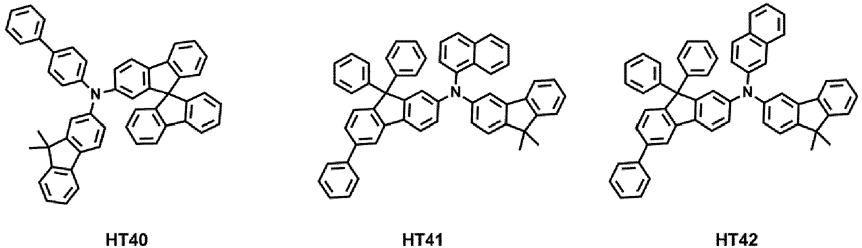

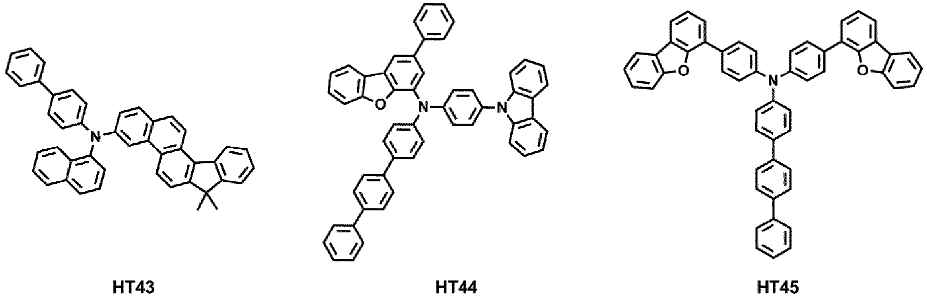

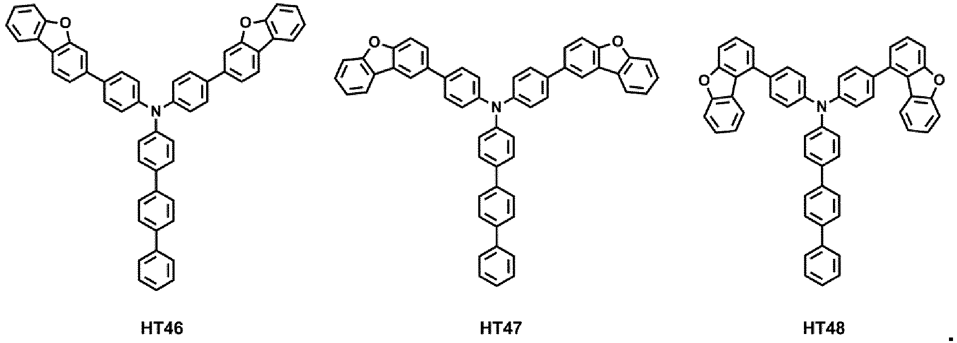

The hole transport region may have a thickness of about 100 Å to about 10,000 Å, for example, about 100 Å to about 7,000 Å, about 100 Å to about 5,000 Å, or about 100 Å to about 1,000 Å. When the hole transport region includes at least one selected from a hole injection layer and a hole transport layer, the thickness of the hole injection layer may be about 50 Å to about 9,000 Å, for example, about 100 Å to about 9,000 Å, about 100 Å to about 7,000 Å, about 100 Å to about 5,000 Å, about 100 Å to about 3,000 Å, about 100 Å to about 2,000 Å, or about 100 Å to about 1,000 Å, and the thickness of the hole transport layer may be about 50 Å to about 2,000 Å, for example, about 100 Å to about 1,500 Å, or about 100 Å to about 300 Å. When the thicknesses of the hole transport region, the hole injection layer and the hole transport layer are within these ranges, satisfactory hole transporting characteristics may be obtained without a substantial increase in driving voltage.

The emission auxiliary layer may increase the light-emission efficiency of the device by compensating for an optical resonance distance of the wavelength of light emitted by an emission layer, and the electron blocking layer may block or reduce the flow of electrons from an electron transport region. The emission auxiliary layer and the electron blocking layer may each include the same materials as described above.

### [p-dopant]

The hole transport region may further include, in addition to these materials, a charge-generation material for the improvement of conductive properties. The charge-generation material may be substantially homogeneously or non-homogeneously dispersed in the hole transport region.

The charge-generation material may be, for example, a p-dopant.

In an embodiment, a lowest unoccupied molecular orbital (LUMO) energy level of the p-dopant may be -3.5 eV or less.

The p-dopant may include at least one selected from a quinone derivative, a metal oxide, and a cyano group-containing compound, but embodiments of the present disclosure are not limited thereto.

In an embodiment, the p-dopant may include at least one selected from:
a quinone derivative (such as tetracyanoquinodimethane (TCNQ) and/or 2,3,5,6-tetrafluoro-7,7,8,8-tetracyanoquinodimethane (F4-TCNQ));
a metal oxide (such as tungsten oxide and/or molybdenum oxide);
1,4,5,8,9,12-hexaazatriphenylene-hexacarbonitrile (HAT-CN); and
a compound represented by Formula 221,
but embodiments of the present disclosure are not limited thereto: 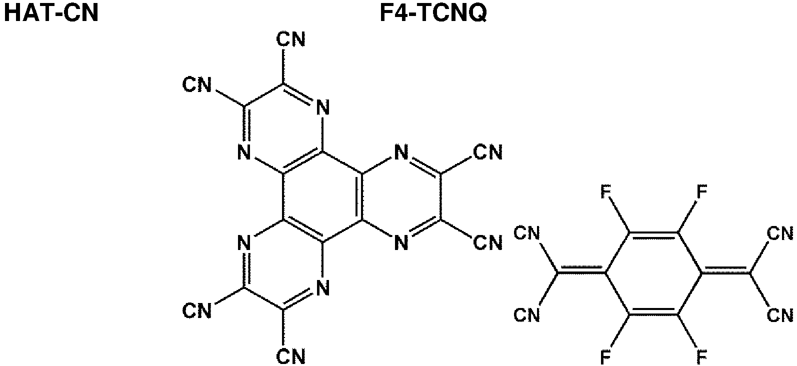 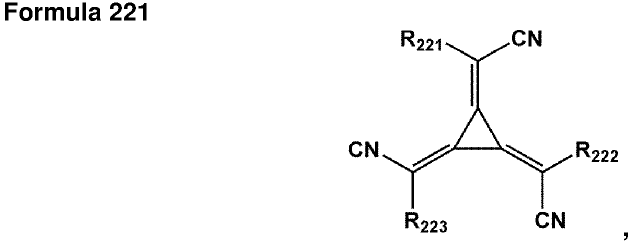 wherein, in Formula 221,
   R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₀) aryl group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group, and at least one selected from R₂₂₁ to R₂₂₃ may have at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### [Emission layer in organic layer 150]

In the organic light-emitting device 10, 20, or 30, the light-emitting unit 153, 153-1, 153-2, or 153-3 includes an emission layer, and the emission layer may have a structure in which at least two layers selected from a red emission layer, a green emission layer, a yellow emission layer, and a blue emission layer may be stacked in contact or separated from each other. In an embodiment, the emission layer may have a structure in which two or more materials selected from a red light emitting material, a green light emitting material, a yellow light emitting material, and a blue light emitting material are mixed without the division of layers.

The emission layer may further include an electron transport-auxiliary layer above the emission layer and/or a hole transport-auxiliary layer under the emission layer. The hole transport-auxiliary layer may act as the hole transport layer, an emission auxiliary layer, and/or an electron blocking layer, and the electron transport-auxiliary layer may act as a buffer layer, a hole blocking layer, an electron control layer, and/or an electron transport layer. The hole transport-auxiliary layer and the electron transport-auxiliary layer may each include the same materials as described for the hole transport region and the electron transport region, respectively.

The emission layer may include a host and a dopant. The dopant may include at least one selected from a phosphorescent dopant and a fluorescent dopant.

An amount of a dopant in the emission layer may be, based on about 100 parts by weight of the host, about 0.01 to about 15 parts by weight, but embodiments of the present disclosure are not limited thereto.

The emission layer may have a thickness of about 100 Å to about 1,000 Å, for example, about 100 Å to about 800 Å, about 150 Å to about 800 Å, about 150 Å to about 700 Å, about 150 Å to about 650 Å, about 200 Å to about 600 Å or about 200 Å to about 300 Å. When the thickness of the emission layer is within this range, excellent light-emission characteristics may be obtained without a substantial increase in driving voltage.

### [Host in emission layer]

The host may include a condensed cyclic compound represented by Formula 3.

In one or more embodiments, the host may include a compound represented by Formula 301:

**Formula 301** [Ar₃₀₁]_{xb11}-[(L₃₀₁)_{xb1}-R₃₀₁]_{xb21},

wherein, in Formula 301,
Ar₃₀₁ may be a substituted or unsubstituted C₅-C₆₀ (*e.g*. C₅-C₃₀) carbocyclic group or a substituted or unsubstituted C₁-C₆₀ (*e.g*. C₁-C₂₀) heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₀) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
xb1 may be an integer from 0 to 5,
R₃₀₁ may be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ (*e.g*. C₁-C₂₀) alkyl group, a substituted or unsubstituted C₂-C₆₀ (*e.g*. C₂-C₂₀) alkenyl group, a substituted or unsubstituted C₂-C₆₀ (*e.g.* C₂-C₂₀) alkynyl group, a substituted or unsubstituted C₁-C₆₀ (*e.g.* C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (e.g. C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), -B(Q₃₀₁)(Q₃₀₂), - C(=O)(Q₃₀₁), -S(=O)₂(Q₃₀₁), and -P(=O)(Q₃₀₁)(Q₃₀₂), and
xb21 may be an integer from 1 to 5,
wherein Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

In an embodiment, Ar₃₀₁ in Formula 301 may be selected from:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

When xb11 in Formula 301 is two or more, two or more of Ar₃₀₁(s) may be linked via a single bond.

In one or more embodiments, the compound represented by Formula 301 may be represented by one of Formula 301-1 or Formula 301-2:

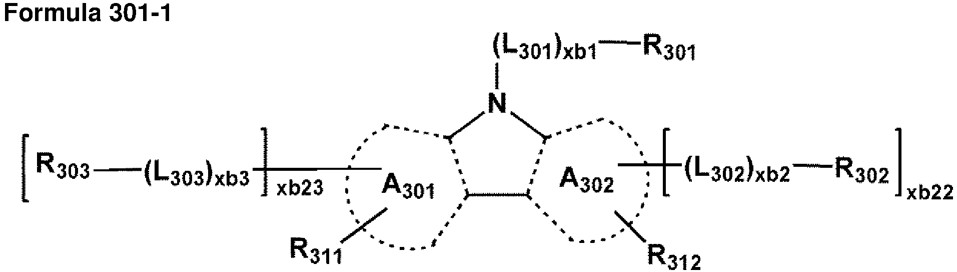

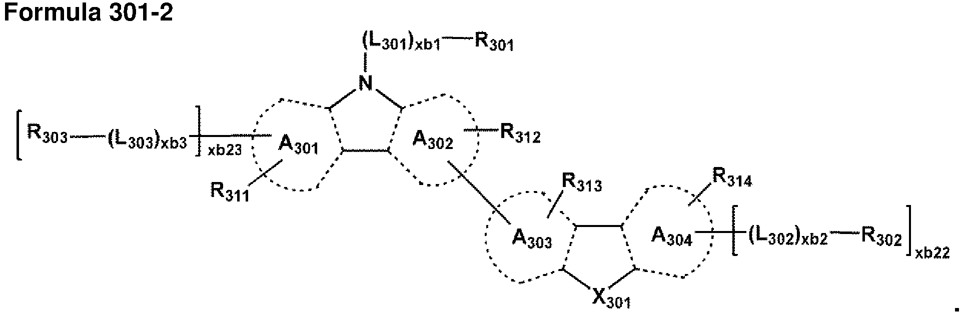

In Formulae 301-1 and 301-2
A₃₀₁ to A₃₀₄ may each independently be selected from a benzene ring, a naphthalene ring, a phenanthrene ring, a fluoranthene ring, a triphenylene ring, a pyrene ring, a chrysene ring, a pyridine ring, a pyrimidine ring, an indene ring, a fluorene ring, a spiro-bifluorene ring, a benzofluorene ring, a dibenzofluorene ring, an indole ring, a carbazole ring, a benzocarbazole ring, a dibenzocarbazole ring, a furan ring, a benzofuran ring, a dibenzofuran ring, a naphthofuran ring, a benzonaphthofuran ring, a dinaphthofuran ring, a thiophene ring, a benzothiophene ring, a dibenzothiophene ring, a naphthothiophene ring, a benzonaphthothiophene ring, and a dinaphthothiophene ring,
X₃₀₁ may be O, S, or N-[(L₃₀₄)_{xb4}-R₃₀₄],
R₃₁₁ to R₃₁₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
xb22 and xb23 may each independently be 0, 1, or 2,
L₃₀₁, xb1, R₃₀₁ and Q₃₁ to Q₃₃ may each independently be the same as described above,
L₃₀₂ to L₃₀₄ may each independently be the same as described in connection with L₃₀₁,
xb2 to xb4 may each independently be the same as described in connection with xb1, and
R₃₀₂ to R₃₀₄ are each independently the same as described in connection with R₃₀₁.

In an embodiment, L₃₀₁ to L₃₀₄ in Formulae 301, 301-1, and 301-2 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
wherein Q₃₁ to Q₃₃ may each independently be the same as described above.

In an embodiment, R₃₀₁ to R₃₀₄ in Formulae 301, 301-1, and 301-2 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
wherein Q₃₁ to Q₃₃ may each independently be the same as described above.

In one or more embodiments, the host may include an alkaline earth metal complex or Zn complex. For example, the host may include a complex selected from a Be complex (for example, Compound H55), a Mg complex, and a Zn complex. In an embodiment, the host may be selected from a Be complex (for example, Compound H55), an Mg complex, and a Zn complex.

The host may include at least one selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and Compounds H1 to H55 and BH1 to BH13.

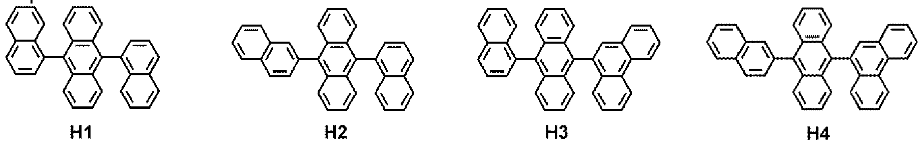

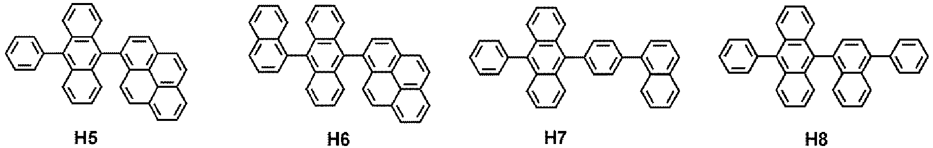

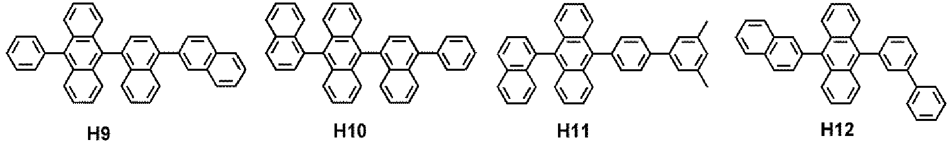

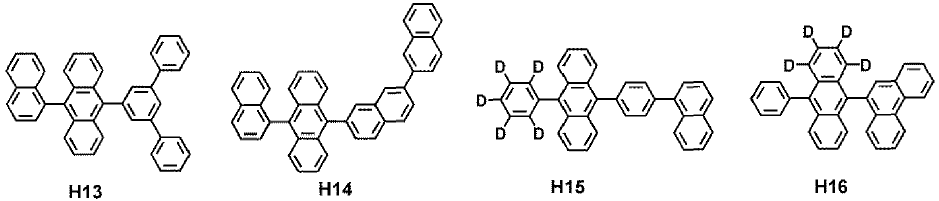

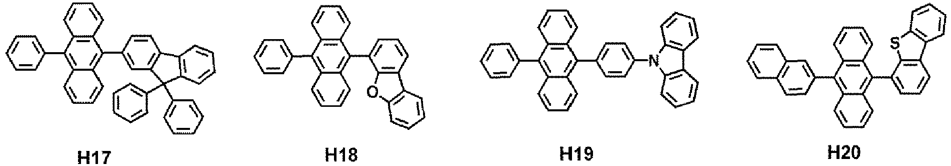

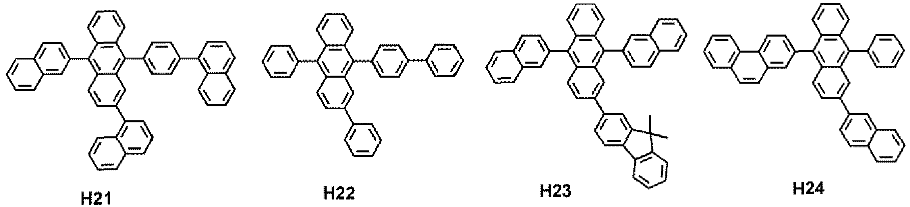

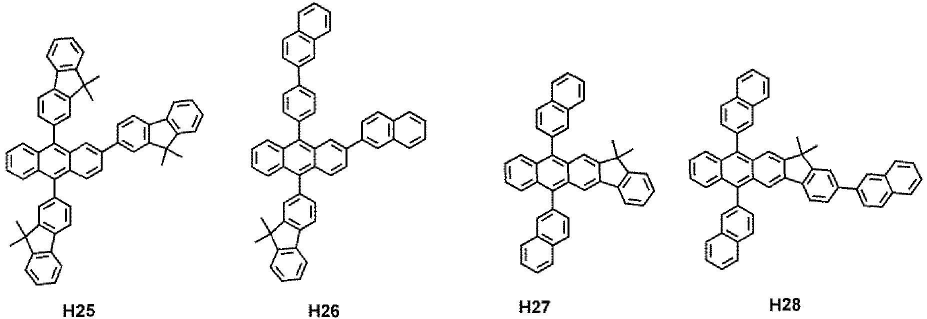

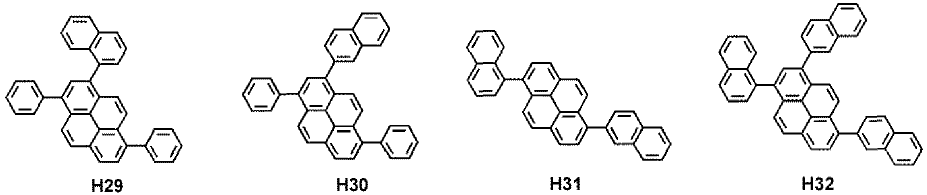

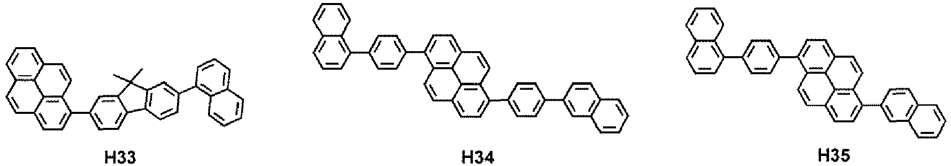

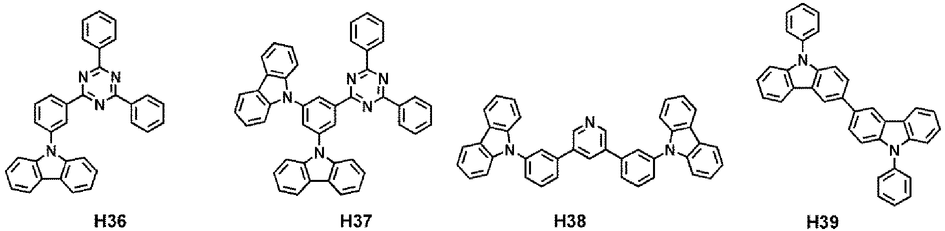

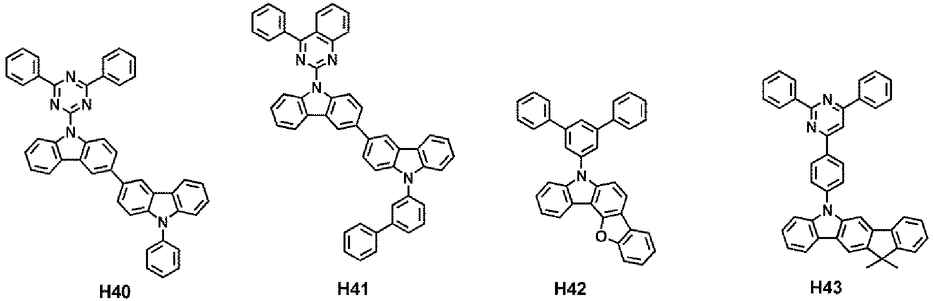

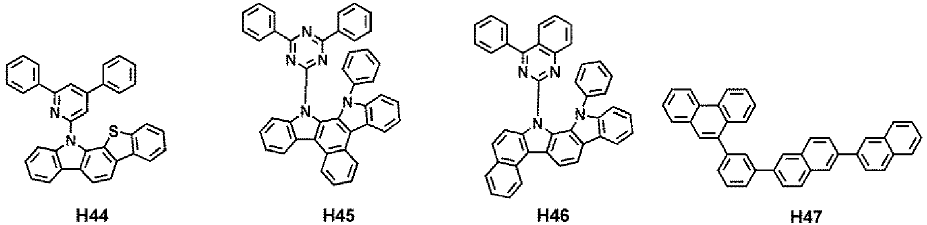

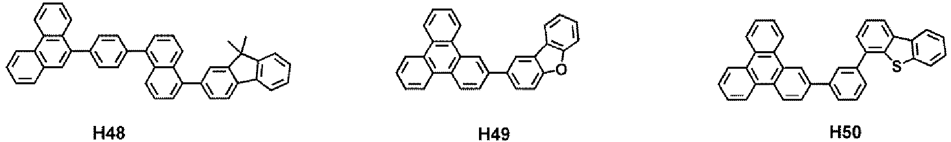

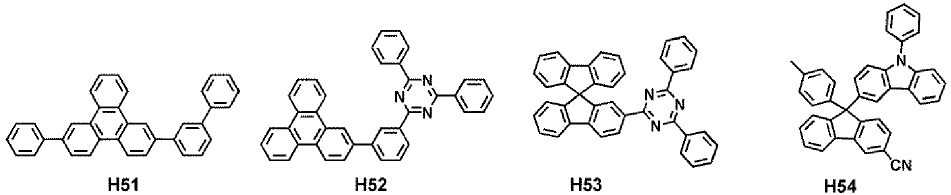

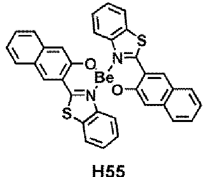

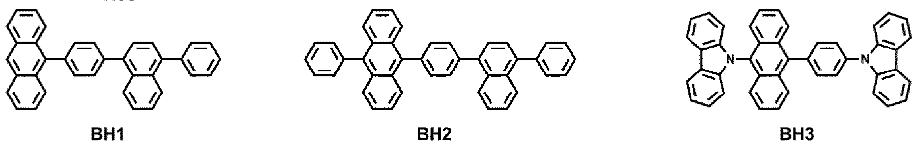

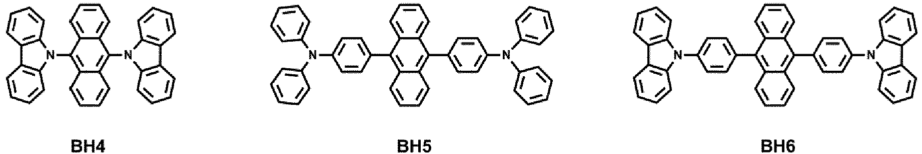

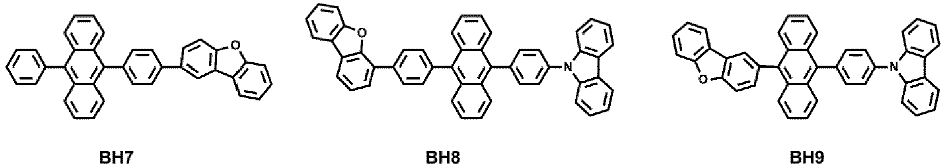

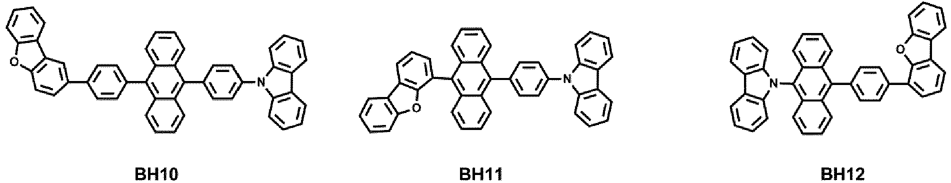

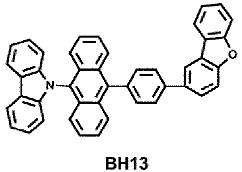

### [Phosphorescent dopant included in the emission layer]

The phosphorescent dopant may include an organometallic complex represented by Formula 401:

**Formula 401** M(L₄₀₁)_{xc1}(L₄₀₂)_{xc2}

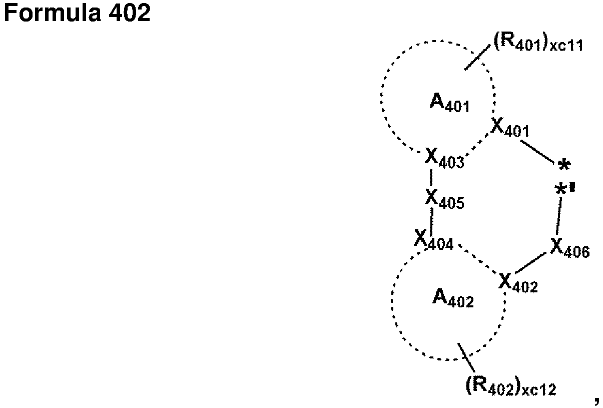

wherein, in Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
L₄₀₁ may be a ligand represented by Formula 402, and xc1 may be 1, 2, or 3, wherein when xc1 is two or more, two or more L₄₀₁(s) may be identical to or different from each other,
L₄₀₂ may be an organic ligand, and xc2 may be an integer from 0 to 4, wherein when xc2 is two or more, two or more L₄₀₂(s) may be identical to or different from each other,
X₄₀₁ to X₄₀₄ may each independently be nitrogen or carbon,
X₄₀₁ and X₄₀₃ may be linked via a single bond or a double bond, and X₄₀₂ and X₄₀₄ may be linked via a single bond or a double bond,
A₄₀₁ and A₄₀₂ may each independently be a C₅-C₆₀ (e.g. C₅-C₃₀) carbocyclic group or a C₁-C₆₀ (e.g. C₁-C₂₀) heterocyclic group,
X₄₀₅ may be a single bond, *-O-*', *-S-*', *-C(=O)-*', *-N(Q₄₁₁)-*', *-C(Q₄₁₁)(Q₄₁₂)-*', *-C(Q411)=C(Q412)-*', *-C(Q₄₁₁)=*', or *=C=*', wherein Q₄₁₁ and Q₄₁₂ may each independently be hydrogen, deuterium, a C₁-C₂₀ alkyl group, a C₁-C₂₀ alkoxy group, a phenyl group, a biphenyl group, a terphenyl group, or a naphthyl group,
X₄₀₆ may be a single bond, O, or S,
R₄₀₁ and R₄₀₂ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₀) aryl group, a substituted or unsubstituted C₆-C₆₀ (*e.g.* C₆-C₃₀) aryloxy group, a substituted or unsubstituted C₆-C₆₀ (*e.g.* C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂), and Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer from 0 to 10, and
* and *' in Formula 402 each indicate a binding site to a M in Formula 401.

In an embodiment, A₄₀₁ and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen and X₄₀₂ may be carbon, or ii) X₄₀₁ and X₄₀₂ may each be nitrogen at the same time.

In one or more embodiments, R₄₀₁ and R₄₀₂ in Formula 402 may each independently be selected from:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group, and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantyl group, a norbornyl group, and a norbornenyl group;
a cyclopentyl group, a cyclohexyl group, an adamantyl group, a norbornyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantyl group, a norbornyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantyl group, a norbornyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q₄₀₁), and -P(=O)(Q₄₀₁)(Q₄₀₂),
wherein Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments of the present disclosure are not limited thereto.

In one or more embodiments, when xc1 in Formula 401 is two or more, two A₄₀₁(s) in two or more L₄₀₁(s) may optionally be linked to each other via X₄₀₇ (which is a linking group), two A₄₀₂(s) may optionally be linked to each other via X₄₀₈ (which is a linking group, see Compounds PD1 to PD4 and PD7). X₄₀₇ and X₄₀₈ may each independently be a single bond, *-O-*', *-S-*', *-C(=O)-*', *-N(Q₄₁₃)-*', *-C(Q₄₁₃)(Q₄₁₄)-*' or *-C(Q₄₁₃)=C(Q₄₁₄)-*' (where Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group), but embodiments of the present disclosure are not limited thereto.

L₄₀₂ in Formula 401 may be a monovalent, divalent, or trivalent organic ligand. In an embodiment, L₄₀₂ may be selected from halogen, diketone (for example, acetylacetonate), carboxylic acid (for example, picolinate), -C(=O), isonitrile, -CN, and a phosphorus group (for example, phosphine or phosphite), but embodiments of the present disclosure are not limited thereto.

In one or more embodiments, the phosphorescent dopant may be selected from, for example, Compounds PD1 to PD25, but embodiments of the present disclosure are not limited thereto:

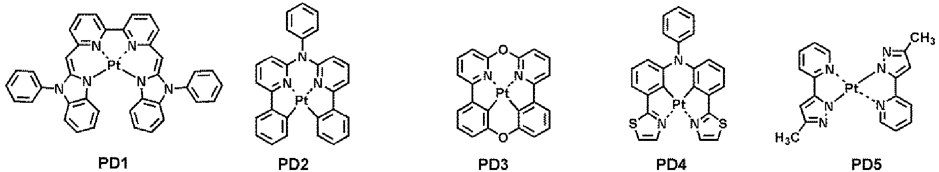

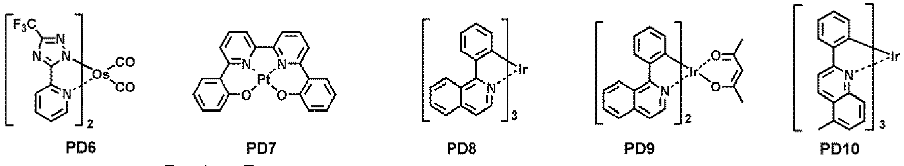

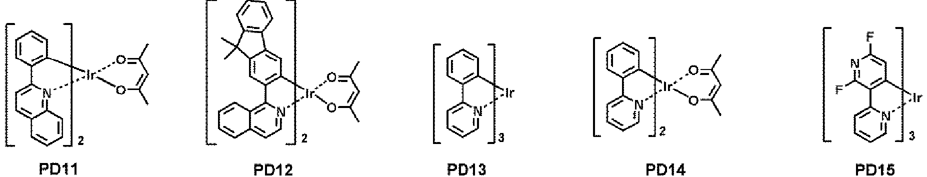

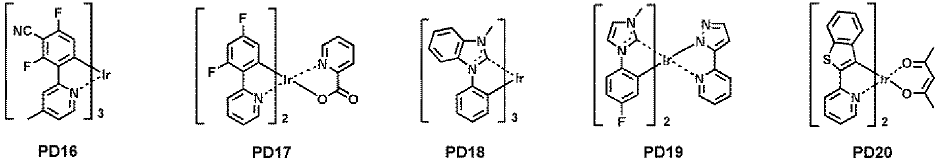

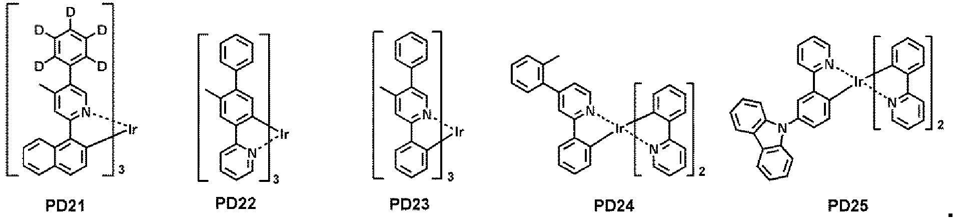

### [Fluorescent dopant in emission layer]

The fluorescent dopant may include a condensed cyclic compound represented by Formula 4.

The fluorescent dopant may include an arylamine compound or a styrylamine compound.

In an embodiment, the fluorescent dopant may include a compound represented by Formula 501: 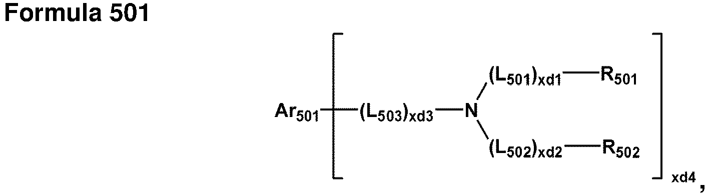 wherein, in Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (e.g. C₆-C₃₀) arylene group, a substituted or unsubstituted C₁-C₆₀ (e.g. C₁-C₂₀) heteroarylene group, a substituted or unsubstituted divalent non-aromatic condensed polycyclic group, and a substituted or unsubstituted divalent non-aromatic condensed heteropolycyclic group,
xd1 to xd3 may each independently be an integer from 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (*e.g.* C₆-C₃₀) aryloxy group, a substituted or unsubstituted C₆-C₆₀ (*e.g.* C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group, and
xd4 may be an integer from 1 to 6.

For example, Ar₅₀₁ may be a substituted or unsubstituted C₅-C₃₀ carbocyclic group or a substituted or unsubstituted C₁-C₂₀ heterocyclic group, but embodiments are not limited thereto.

In an embodiment, Ar₅₀₁ in Formula 501 may be selected from:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, L₅₀₁ to L₅₀₃ in Formula 501 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, R₅₀₁ and R₅₀₂ in Formula 501 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but embodiments of the present disclosure are not limited thereto.

In an embodiment, the fluorescent dopant may be selected from Compounds FD1 to FD22:

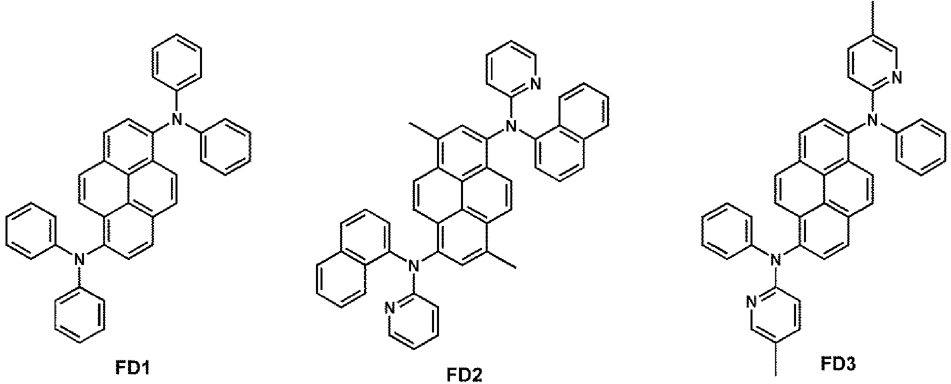

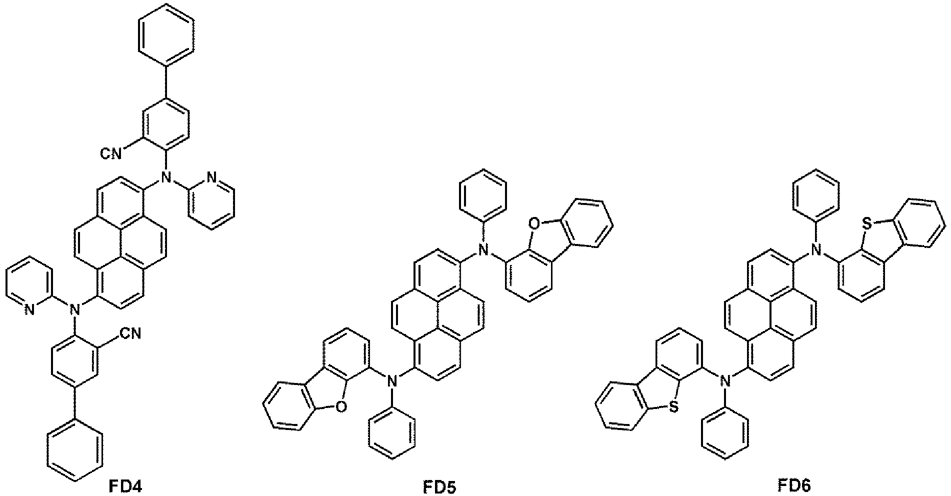

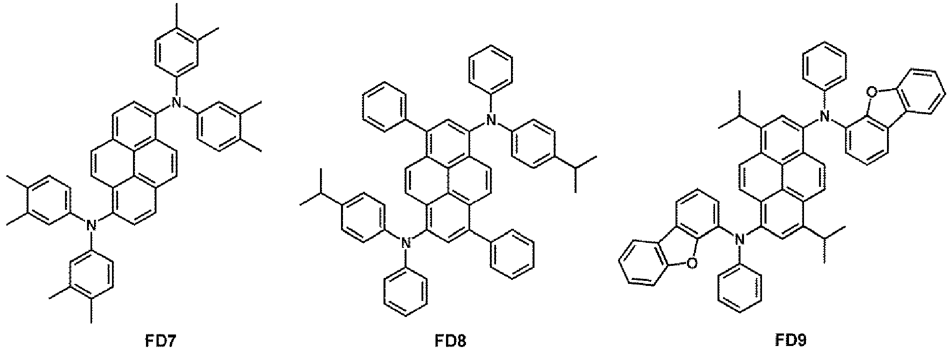

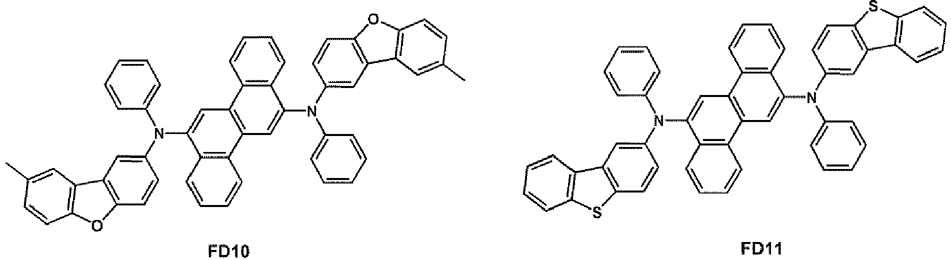

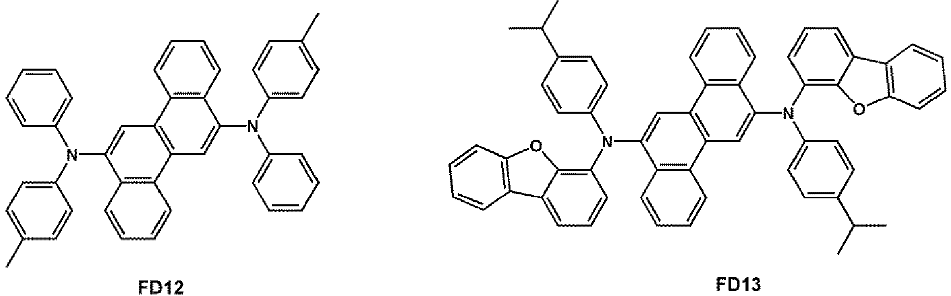

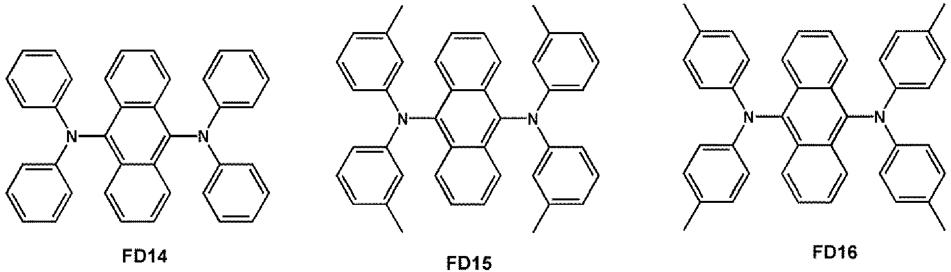

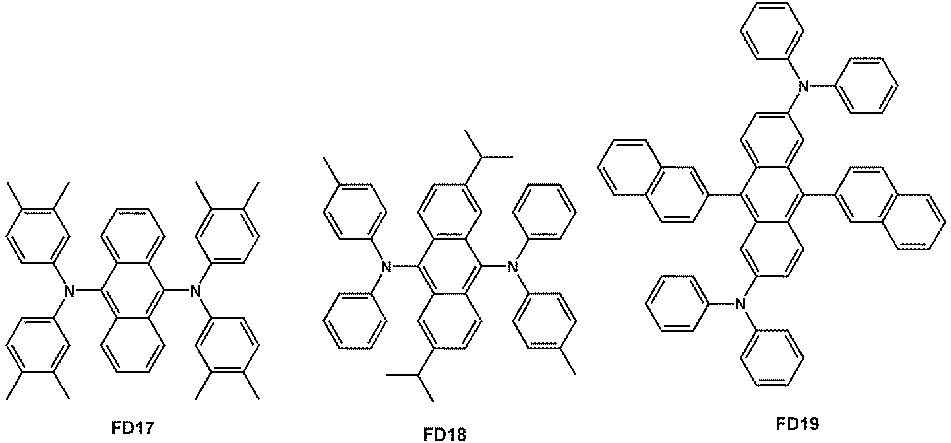

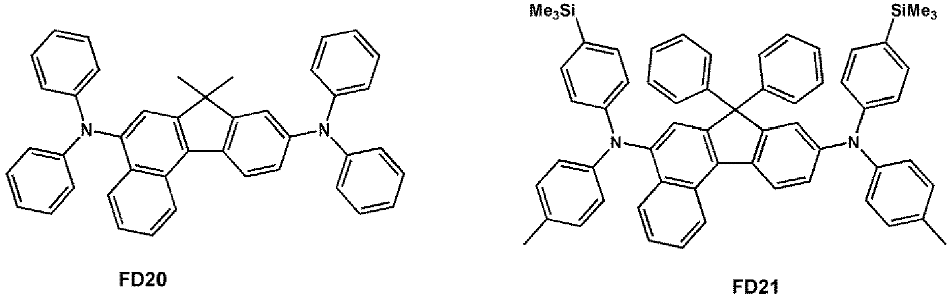

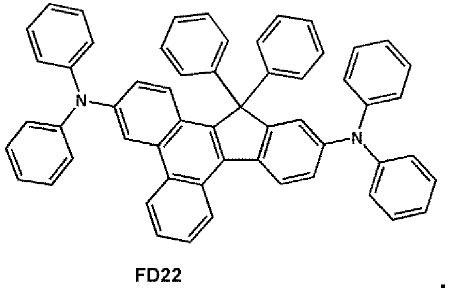

In one or more embodiments, the fluorescent dopant may be selected from the following compounds, but embodiments of the present disclosure are not limited thereto.

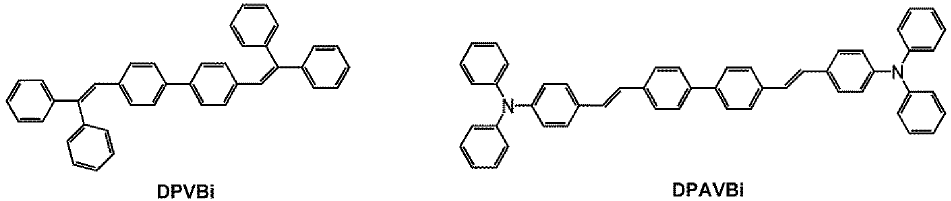

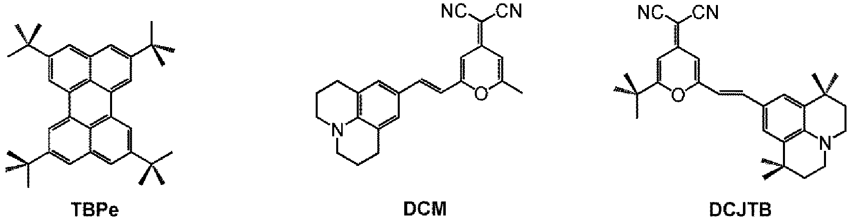

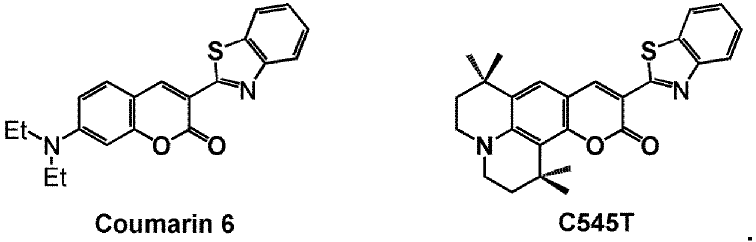

### [Electron transport region]

The electron transport region may have i) a single-layered structure including (e.g., consisting of) a single material, ii) a single-layered structure including a plurality of different materials, or iii) a multi-layered structure having a plurality of layers including a plurality of different materials.

The electron transport region may include at least one selected from a buffer layer, a hole blocking layer, an electron control layer, an electron transport layer, and an electron injection layer, but embodiments of the present disclosure are not limited thereto.

In an embodiment, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein the constituting layers of each structure are sequentially stacked from an emission layer. However, embodiments of the structure of the electron transport region are not limited thereto.

The electron transport region (for example, a buffer layer, a hole blocking layer, an electron control layer, and/or an electron transport layer in the electron transport region) may include a metal-free compound containing at least one π electron-deficient nitrogen-containing ring.

The term "π electron-deficient nitrogen-containing ring" may refer to a C₁-C₆₀ (*e.g.* a C₁-C₃₀) heterocyclic group having at least one *-N=*' moiety as a ring-forming moiety.

In an embodiment, the "π electron-deficient nitrogen-containing ring" may be i) a 5-membered to 7-membered heteromonocyclic group having at least one *-N=*' moiety, ii) a heteropolycyclic group in which two or more 5-membered to 7-membered heteromonocyclic groups each having at least one *-N=*' moiety are condensed with each other, or iii) a heteropolycyclic group in which at least one 5-membered to 7-membered heteromonocyclic group having at least one *-N=*' moiety, is condensed with at least one C₅-C₆₀ (*e.g*. a C₅-C₃₀) carbocyclic group.

Examples of the π electron-deficient nitrogen-containing ring include an imidazole ring, a pyrazole ring, a thiazole ring, an isothiazole ring, an oxazole ring, an isoxazole ring, a pyridine ring, a pyrazine ring, a pyrimidine ring, a pyridazine ring, an indazole ring, a purine ring, a quinoline ring, an isoquinoline ring, a benzoquinoline ring, a phthalazine ring, a naphthyridine ring, a quinoxaline ring, a quinazoline ring, a cinnoline ring, a phenanthridine ring, an acridine ring, a phenanthroline ring, a phenazine ring, a benzimidazole ring, an isobenzothiazole ring, a benzoxazole ring, an isobenzoxazole ring, a triazole ring, a tetrazole ring, an oxadiazole ring, a triazine ring, a thiadiazole ring, an imidazopyridine ring, an imidazopyrimidine ring, and an azacarbazole ring, but are not limited thereto.

In an embodiment, the electron transport region may include a compound represented by Formula 601:

**Formula 601** [Ar₆₀₁]ₓₑ₁₁-[(L₆₀₁)ₓₑ₁-R₆₀₁]ₓₑ₂₁,

wherein, in Formula 601,
Ar₆₀₁ is a substituted or unsubstituted C₅-C₆₀ (*e.g*. C₅-C₃₀) carbocyclic group or a substituted or unsubstituted C₁-C₆₀ (*e.g*. C₁-C₂₀) heterocyclic group,
xe11 is 1, 2, or 3,
L₆₀₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g*. C₆-C₃₀) arylene group, a substituted or unsubstituted C₁-C₆₀ (*e.g*. C₁-C₂₀) heteroarylene group, a substituted or unsubstituted divalent non-aromatic condensed polycyclic group, and a substituted or unsubstituted divalent non-aromatic condensed heteropolycyclic group,
xe1 is an integer from 0 to 5,
R₆₀₁ is selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₀) aryl group, a substituted or unsubstituted C₆-C₆₀ (*e.g*. C₆-C₃₀) aryloxy group, a substituted or unsubstituted C₆-C₆₀ (*e.g*. C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), -C(=O)(Q₆₀₁), - S(=O)₂(Q₆₀₁), and -P(=O)(Q₆₀₁)(Q₆₀₂),
Q₆₀₁ to Q₆₀₃ are each independently a C₁-C₁₀ alkyl group, a C₁-C₁₀ alkoxy group, a phenyl group, a biphenyl group, a terphenyl group, or a naphthyl group, and
xe21 is an integer from 1 to 5.

In an embodiment, at least one of the xe11 Ar₆₀₁(s) or the xe21 R₆₀₁(s) may include the π electron-deficient nitrogen-containing ring.

In an embodiment, ring Ar₆₀₁ in Formula 601 may be selected from:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), and -P(=O)(Q31)(Q32),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is 2 or more, two or more Ar₆₀₁(s) may be linked to each other via a single bond.

In one or more embodiments, Ar₆₀₁ in Formula 601 may be an anthracene group.

In one or more embodiments, the compound represented by Formula 601 may be represented by Formula 601-1: 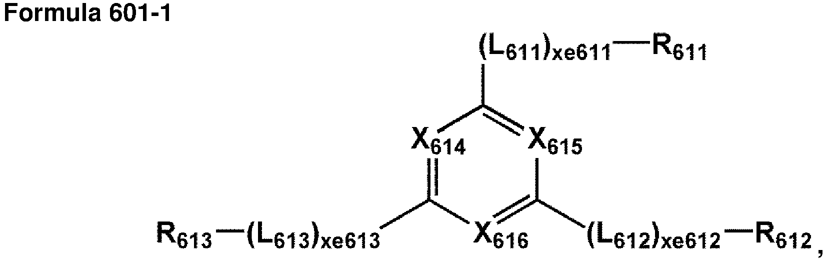 wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each independently be the same as described in connection with L₆₀₁,
xe611 to xe613 may each independently be the same as described in connection with xe1,
R₆₁₁ to R₆₁₃ may each independently be the same as described in connection with R₆₀₁, and
R₆₁₄ to R₆₁₆ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In an embodiment, L₆₀₁ and L₆₁₁ to L₆₁₃ in Formulae 601 and 601-1 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group,
but embodiments of the present disclosure are not limited thereto.

In one or more embodiments, xe1 and xe611 to xe613 in Formulae 601 and 601-1 may each independently be 0, 1, or 2.

In one or more embodiments, R₆₀₁ and R₆₁₁ to R₆₁₃ in Formulae 601 and 601-1 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂),
wherein Q₆₀₁ and Q₆₀₂ may each independently be the same as described above.

The electron transport region may include at least one compound selected from Compounds ET1 to ET36, but embodiments of the present disclosure are not limited thereto:

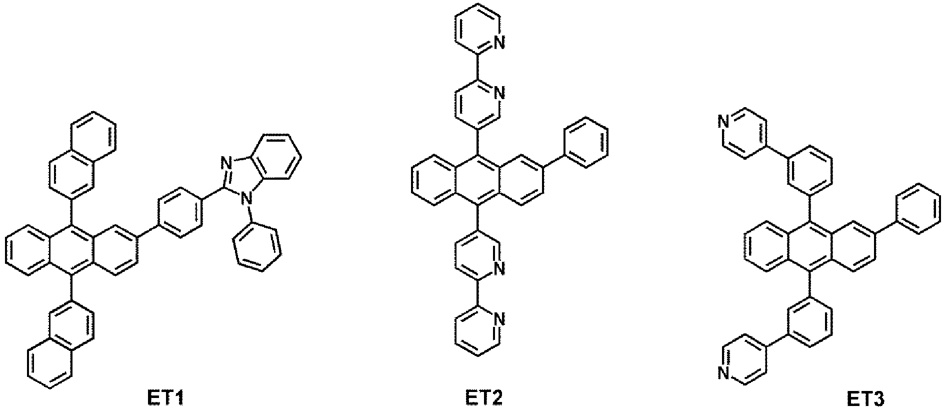

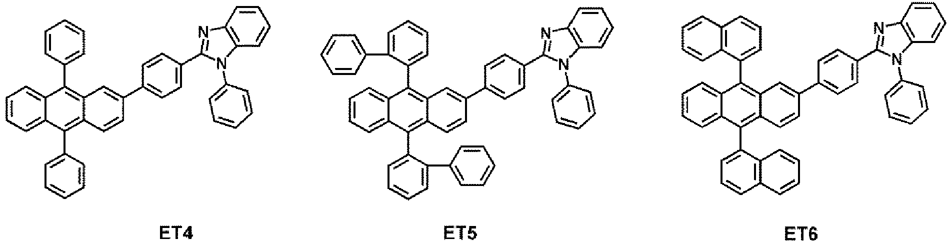

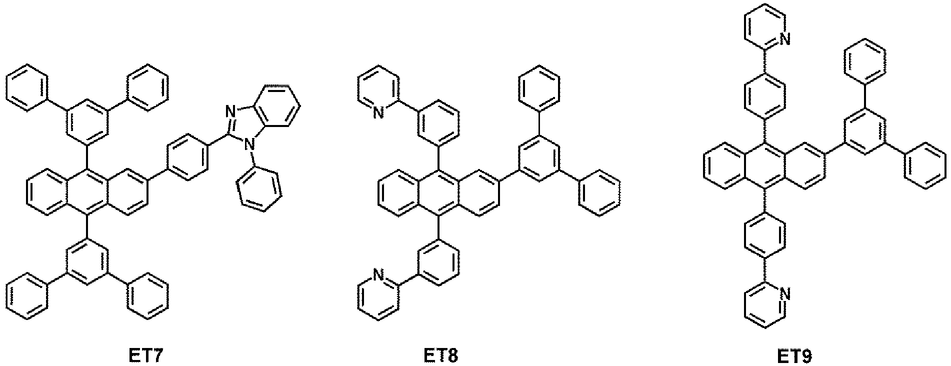

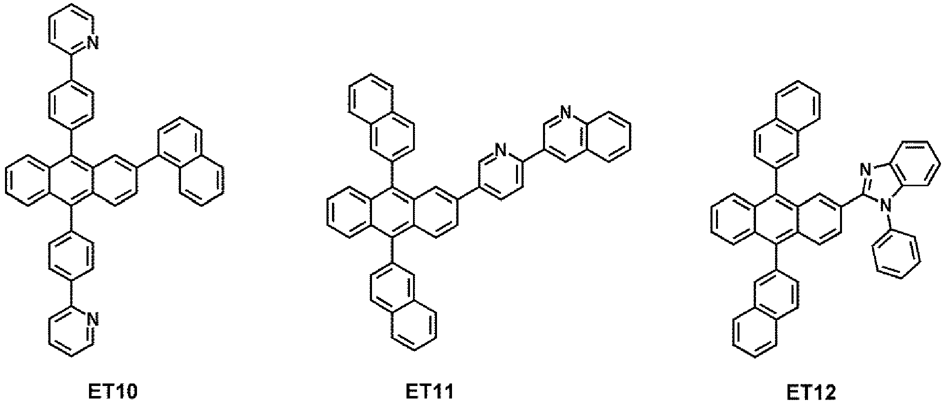

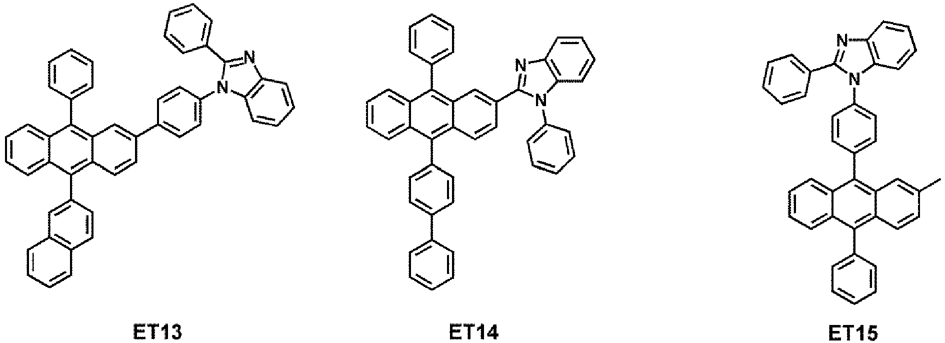

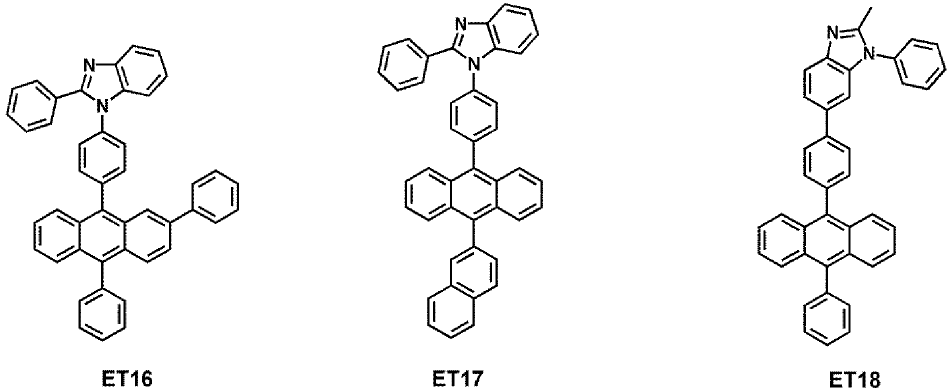

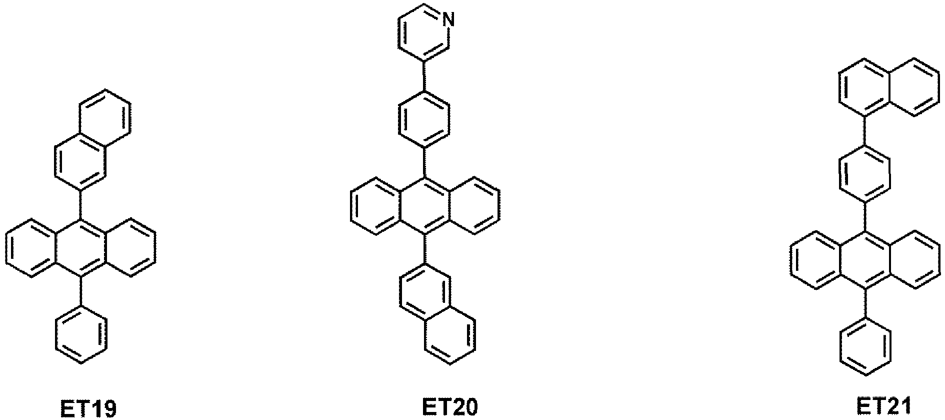

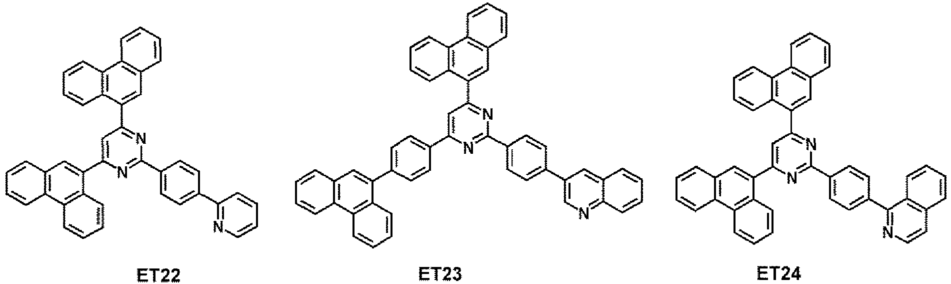

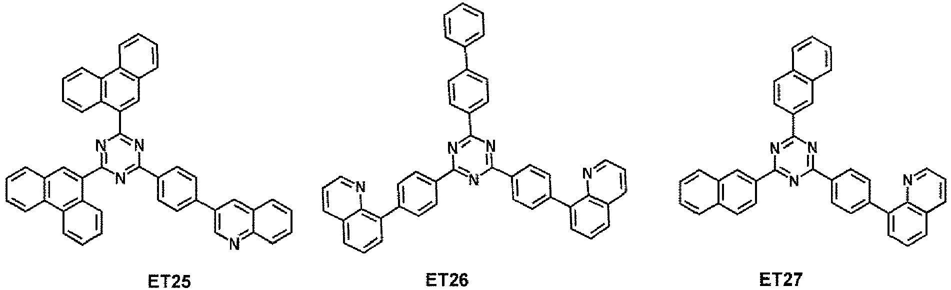

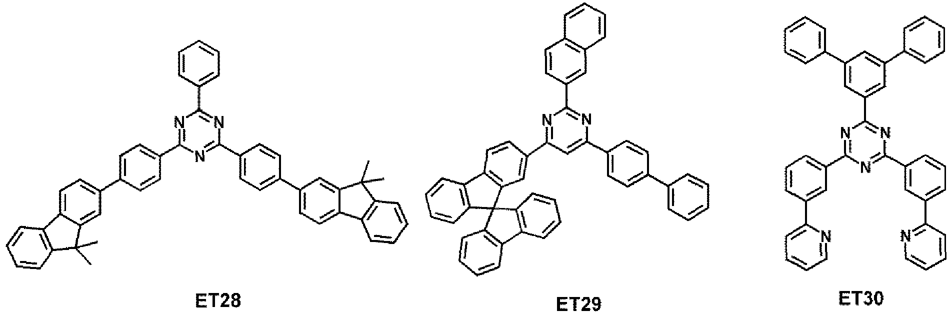

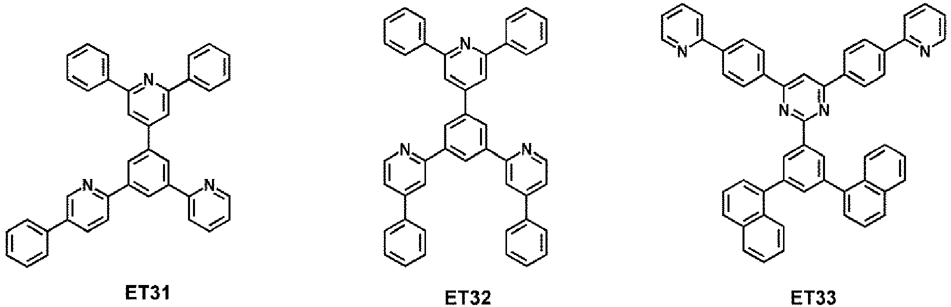

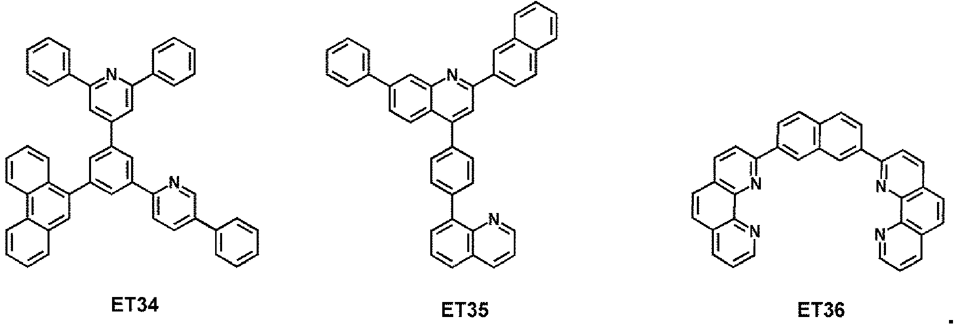

In one or more embodiments, the electron transport region may include at least one compound selected from 2,9-dimethyl-4,7-diphenyl-1,10-phenanthroline (BCP), 4,7-diphenyl-1,10-phenanthroline (Bphen), Alq₃, BAIq, 3-(biphenyl-4-yl)-5-(4-tert-butylphenyl)-4-phenyl-4H-1,2,4-triazole (TAZ), and NTAZ.

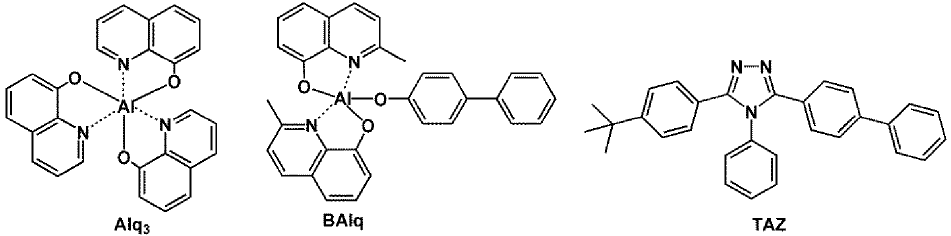

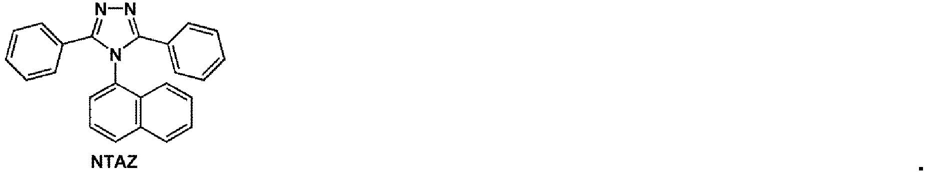

The thicknesses of the buffer layer, the hole blocking layer, and the electron control layer may each independently be about 20 Å to about 1,000 Å, for example, about 20 Å to about 700 Å, about 20 Å to about 500 Å, about 20 Å to about 400 Å, about 30 Å to about 400 Å or about 30 Å to about 300 Å. When the thicknesses of the buffer layer, the hole blocking layer, and the electron control layer are within these ranges, excellent hole blocking characteristics and/or excellent electron control characteristics may be obtained without a substantial increase in driving voltage.

The electron transport layer may have a thickness of about 50 Å to about 1,000 Å, for example, about 100 Å to about 1,000 Å, about 100 Å to about 700 Å, about 100 Å to about 600 Å, about 150 Å to about 600 Å, or about 150 Å to about 500 Å. When the thickness of the electron transport layer is within the range described above, the electron transport layer may have satisfactory electron transport characteristics without a substantial increase in driving voltage.

The electron transport region (for example, the electron transport layer in the electron transport region) may further include, in addition to the materials described above, a metal-containing material.

The metal-containing material may include at least one selected from an alkali metal complex and an alkaline earth-metal complex. The alkali metal complex may include a metal ion selected from a Li ion, a Na ion, a K ion, a Rb ion, and a Cs ion, and the alkaline earth-metal complex may include a metal ion selected from a Be ion, a Mg ion, a Ca ion, a Sr ion, and a Ba ion. A ligand coordinated with the metal ion of the alkali metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

In an embodiment, the metal-containing material may include a Li complex. The Li complex may include, for example, Compound ET-D1 (lithium quinolate, LiQ) or ET-D2:

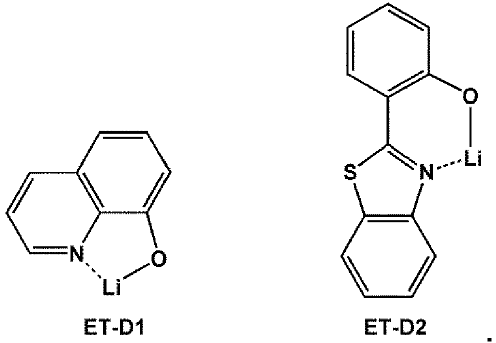

The electron transport region may include an electron injection layer to facilitate the injection of electrons from the second electrode 190. The electron injection layer may directly contact the second electrode 190.

The electron injection layer may have i) a single-layered structure including (e.g., consisting of) a single material, ii) a single-layered structure including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof.

The alkali metal may be selected from Li, Na, K, Rb, and Cs. In an embodiment, the alkali metal may be Li, Na, or Cs. In one or more embodiments, the alkali metal may be Li or Cs, but embodiments of the present disclosure are not limited thereto.

The alkaline earth metal may be selected from Mg, Ca, Sr, and Ba.

The rare earth metal may be selected from Sc, Y, Ce, Tb, Yb, and Gd.

The alkali metal compound, the alkaline earth-metal compound, and the rare earth metal compound may be selected from oxides and halides (for example, fluorides, chlorides, bromides, or iodides) of the alkali metal, the alkaline earth-metal, and the rare earth metal.

The alkali metal compound may be selected from alkali metal oxides (such as Li₂O, Cs₂O, and/or K₂O), and alkali metal halides (such as LiF, NaF, CsF, KF, Lil, Nal, Csl, KI, and/or Rbl). In an embodiment, the alkali metal compound may be selected from LiF, Li₂O, NaF, Lil, Nal, Csl, and KI, but embodiments of the present disclosure are not limited thereto.

The alkaline earth-metal compound may be selected from alkaline earth-metal oxides (such as BaO, SrO, CaO, BaₓSr₁₋ₓO (0<x<1), and/or BaₓCa₁₋ₓO (0<x<1)). In an embodiment, the alkaline earth-metal compound may be selected from BaO, SrO, and CaO, but embodiments of the present disclosure are not limited thereto.

The rare earth metal compound may be selected from YbF₃, ScF₃, Sc₂O₃, Y₂O₃, Ce₂O₃, GdF₃ and TbF₃. In an embodiment, the rare earth metal compound may be selected from YbF₃, ScF₃, TbF₃, YbI₃, ScI₃, and TbI₃, but embodiments of the present disclosure are not limited thereto.

The alkali metal complex, the alkaline earth-metal complex, and the rare earth metal complex may respectively include an ion of an alkali metal, an alkaline earth-metal, and a rare earth metal as described above, and a ligand coordinated with a metal ion of the alkali metal complex, the alkaline earth-metal complex, or the rare earth metal complex may be selected from hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, and cyclopentadiene, but embodiments of the present disclosure are not limited thereto.

The electron injection layer may include (e.g., consist of) an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof, as described above. In one or more embodiments, the electron injection layer may further include an organic material. When the electron injection layer further includes an organic material, the alkali metal, alkaline earth metal, rare earth metal, alkali metal compound, alkaline earth-metal compound, rare earth metal compound, alkali metal complex, alkaline earth-metal complex, rare earth metal complex, or combination thereof may be substantially homogeneously or non-homogeneously dispersed in a matrix including the organic material.

A thickness of the electron injection layer may be about 1 Å to about 100 Å, for example, about 3 Å to about 90 Å or about 3 Å to about 20 Å. When the thickness of the electron injection layer is within the range described above, the electron injection layer may have satisfactory electron injection characteristics without a substantial increase in driving voltage.

### [Second electrode 190]

The second electrode 190 may be a cathode (which is an electron injection electrode), and in this regard, a material for forming the second electrode 190 may be selected from a metal, an alloy, an electrically conductive compound, and a combination thereof, each having a relatively low work function.

The second electrode 190 may include at least one selected from lithium (Li), silver (Ag), magnesium (Mg), aluminium (Al), aluminium-lithium (Al-Li), calcium (Ca), ytterbium (Yb), magnesium-indium (Mg-In), magnesium-silver (Mg-Ag), silver-ytterbium (Ag-Yb), ITO, and IZO, but embodiments of the present disclosure are not limited thereto. The second electrode 190 may be a transmissive electrode, a semi-transmissive electrode, or a reflective electrode.

The second electrode 190 may have a single-layered structure or a multi-layered structure including two or more layers.

### [Capping layer]

A first capping layer may be located outside the first electrode 110, and/or a second capping layer may be located outside the second electrode 190. For example, the light-emitting device 10, 20, or 30 may have a structure in which the first capping layer, the first electrode 110, the organic layer 150, and the second electrode 190 are sequentially stacked in this stated order, a structure in which the first electrode 110, the organic layer 150, the second electrode 190, and the second capping layer are sequentially stacked in this stated order, or a structure in which the first capping layer, the first electrode 110, the organic layer 150, the second electrode 190, and the second capping layer are sequentially stacked in this stated order.

In the organic layer 150 of the organic light-emitting device 10, 20, or 30, light generated in an emission layer may pass through the first electrode 110 and the first capping layer toward the outside, wherein the first electrode 110 may be a semi-transmissive electrode or a transmissive electrode. In the organic layer 150 of the organic light-emitting device 10, 20, or 30, light generated in an emission layer may pass through the second electrode 190 and the second capping layer toward the outside, wherein the second electrode 190 may be a semi-transmissive electrode or a transmissive electrode.

The first capping layer and the second capping layer may increase the external luminescence efficiency of the device, according to the principle of constructive interference.

The first capping layer and the second capping layer may protect the organic light-emitting device 10, 20, or 30, and furthermore, may allow light, generated by the organic light-emitting device 10, 20, or 30, to be efficiently emitted.

The first capping layer and the second capping layer may each independently have a refractive index of 1.6 or more with respect to a wavelength of about 589 nm.

The first capping layer and the second capping layer may each independently be an organic capping layer including an organic material, an inorganic capping layer including an inorganic material, or a composite capping layer including an organic material and an inorganic material.

At least one selected from the first capping layer and the second capping layer may each independently include a carbocyclic compound, a heterocyclic compound, an amine group-containing compound, a porphyrin derivative, a phthalocyanine derivative, a naphthalocyanine derivative, an alkali metal complex, an alkaline earth-metal complex, or a combination thereof. The carbocyclic compound, the heterocyclic compound, and the amine group-containing compound may be optionally substituted with a substituent containing O, N, S, Se, Si, F, CI, Br, I, or any combination thereof. In an embodiment, at least one of the first capping layer or the second capping layer may each independently include an amine group-containing compound.

In an embodiment, at least one of the first capping layer or second capping layer may each independently include a compound represented by Formula 201, a compound represented by Formula 202, or any combination thereof.

In one or more embodiments, at least one of the first capping layer or the second capping layer may each independently include a compound selected from Compounds HT28 to HT33, Compounds CP1 to CP5, or any combination thereof, but embodiments of the present disclosure are not limited thereto:

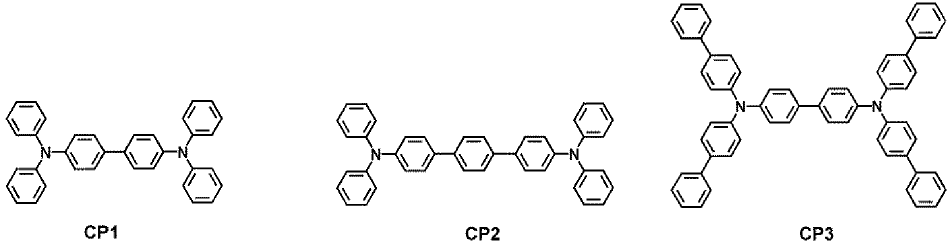

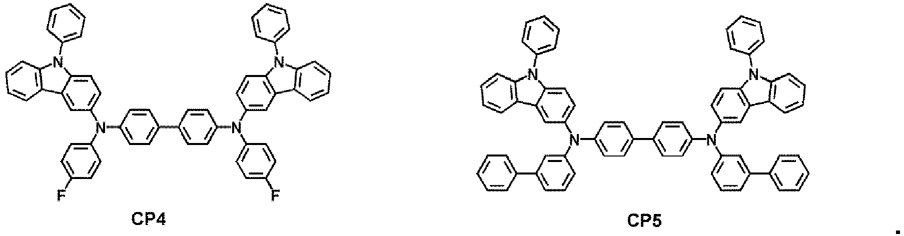

### [Electronic apparatus]

The organic light-emitting device may be included in various electronic apparatuses. In an embodiment, the electronic apparatus including the organic light-emitting device may be a light-emitting apparatus, an authentication apparatus, or the like.

The electronic apparatus (for example, light-emitting apparatus) may further include, in addition to the organic light-emitting device, a color filter, a color conversion layer, or a color filter and a color conversion layer. The color filter and/or the color conversion layer may be located in at least one traveling direction of light emitted from the organic light-emitting device. In an embodiment, the light emitted from the organic light-emitting device may be blue light or white light, but embodiments of the present disclosure are not limited thereto. The organic light-emitting device may be the same as described above.

The electronic apparatus may include a first substrate. The first substrate may include a plurality of subpixel areas, and the color filter or the color conversion layer may include a plurality of subpixel areas respectively corresponding to a plurality of color filter areas or color conversion layer areas.

A pixel-defining film may be located between the plurality of subpixel areas to define each of the subpixel areas.

The color filter or the color conversion layer may further include a light-blocking pattern located between a plurality of color filter areas or between a plurality of color conversion layer areas.

The color filter areas or the color conversion areas may include a first area emitting first color light, a second area emitting second color light, and/or a third area emitting third color light, and the first color light, the second color light, and/or the third color light may have different maximum emission wavelengths from one another. In an embodiment, the first color light may be red light, the second color light may be green light, and the third color light may be blue light, but embodiments of the present disclosure are not limited thereto. In an embodiment, the plurality of color filter areas or the plurality of color filter areas may each include a quantum dot, but embodiments of the present disclosure are not limited thereto. For example, the first area may include a red quantum dot, the second area may include a green quantum dot, and the third area may not include a quantum dot. The first area, the second area, and/or the third area may each include a scatterer, but embodiments of the present disclosure are not limited thereto.

In an embodiment, the organic light-emitting device may emit first light, the first area may absorb the first light to emit first first-color light, the second area may absorb the first light to emit second first-color light, and the third area may absorb the first light to emit third first-color light. In this regard, the first first-color light, the second first-color light, and the third first-color light may have different maximum emission wavelengths from one another. For example, the first light may be blue light, the first first-color light may be red light, the second first-color light may be green light, and the third first-color light may be blue light, but embodiments of the present disclosure are not limited thereto.

The electronic apparatus may further include a thin-film transistor in addition to the organic light-emitting device as described above. The thin-film transistor may include a source electrode, a drain electrode, and an activation layer, wherein any one of the source electrode and the drain electrode may be electrically connected to any one of the first electrode and the second electrode of the organic light-emitting device.

The thin-film transistor may further include a gate electrode, a gate insulation layer, and/or the like.

The active layer may include crystalline silicon, amorphous silicon, an organic semiconductor, an oxide semiconductor, and/or the like, but embodiments of the present disclosure are not limited thereto.

The electronic apparatus may further include a sealing portion for sealing the organic light-emitting device. The sealing portion may be placed between the color filter and the organic light-emitting device. The sealing portion allows light from the organic light-emitting device to be extracted to the outside, while simultaneously (e.g., concurrently) preventing or reducing ambient air and moisture from penetrating into the organic light-emitting device. The sealing portion may be a sealing substrate including a transparent glass substrate and/or a plastic substrate. The sealing portion may be a thin film encapsulation layer including at least one layer of an organic layer and/or a inorganic layer. When the sealing portion is a thin film encapsulation layer, the electronic apparatus may be flexible.

In addition to the color filter and/or color conversion layer, various functional layers may be further located on the sealing portion, as desired depending on the use of the electronic apparatus. The functional layers may include a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus for authenticating an individual by using biometric information of a biometric body (for example, a fingertip, a pupil, and/or the like).

The authentication apparatus may further include, in addition to the organic light-emitting device, a biometric information collector.

The electronic apparatus may be applied to various displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, various measuring instruments, meters (for example, meters for a vehicle, an aircraft, and a vessel), projectors, and/or the like, but embodiments of the present disclosure are not limited thereto.

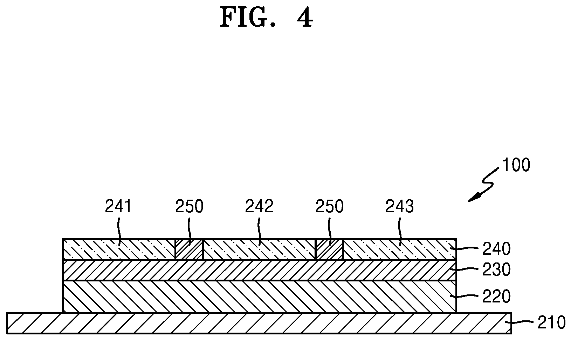

### [Description of FIG. 4]

FIG. 4 is a schematic cross-sectional view of an electronic apparatus 100 according to an embodiment. The electronic apparatus 100 includes a substrate 210, an organic light-emitting device 220 located on the substrate 210, a capping layer 230 located on the organic light-emitting device 220, and the color conversion layer 240 located on the capping layer 230.

The substrate 210, the organic light-emitting device 220, and the capping layer 230 may each be understood by referring to the above descriptions.

The color conversion layer 240 includes a first color conversion layer area 241, a second color conversion layer area 242, a third color conversion layer area 243, and a light-blocking pattern 250 located between neighboring areas of the first, second, and third color conversion layer area 241, 242, and 243.

The first, second, and third color conversion layer regions 241, 242, and 243 may each include quantum dots, but embodiments of the present disclosure are not limited thereto. In one embodiment, the first color conversion layer area 241 includes a red quantum dot, the second color conversion layer area 242 includes a green quantum dot, and the third color conversion layer area 243 may not include quantum dots, but embodiments of the present disclosure are not limited thereto.

### [Preparation method]

Each layer included in a charge generation layer, each layer included in a hole transport region, and each layer included in an emission layer and an electron transport region may be formed in a set or predetermined area by vacuum deposition, spin coating, casting, a Langmuir Blodgett (LB) method, inkjet printing, laser printing, and/or laser thermal imaging (LITI).

When the layers constituting the charge generation layer, the layers constituting the hole transport region, the emission layer, and/or the layers constituting the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on the material to be included and the structure of a layer to be formed.

### [General definition of substituents]

The term "C₁-C₆₀ alkyl group" as used herein refers to a linear or branched aliphatic saturated hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an isoamyl group, and a hexyl group. The term "C₁-C₆₀ alkylene group" as used herein refers to a divalent group having substantially the same structure as the C₁-C₆₀ alkyl group. Corresponding definitions apply to other ranges given for the number of carbon atoms in an alkyl/alkylene group.

The term "C₂-C₆₀ alkenyl group" as used herein refers to a hydrocarbon group having at least one carbon-carbon double bond in the middle or at the terminus of the C₂-C₆₀ alkyl group, and non-limiting examples thereof include an ethenyl group, a propenyl group, and a butenyl group. The term "C₂-C₆₀ alkenylene group" as used herein refers to a divalent group having substantially the same structure as the C₂-C₆₀ alkenyl group. Corresponding definitions apply to other ranges given for the number of carbon atoms in an alkenyl/alkenylene group.

The term "C₂-C₆₀ alkynyl group" as used herein refers to a hydrocarbon group having at least one carbon-carbon triple bond in the middle or at the terminus of the C₂-C₆₀ alkyl group, and non-limiting examples thereof include an ethynyl group and a propynyl group. The term "C₂-C₆₀ alkynylene group" as used herein refers to a divalent group having substantially the same structure as the C₂-C₆₀ alkynyl group. Corresponding definitions apply to other ranges given for the number of carbon atoms in an alkynyl/alkynylene group.

The term "C₁-C₆₀ alkoxy group" as used herein refers to a monovalent group represented by -OA₁₀₁ (wherein A₁₀₁ is a C₁-C₆₀ alkyl group), and non-limiting examples thereof include a methoxy group, an ethoxy group, and an isopropyloxy group. Corresponding definitions apply to other ranges given for the number of carbon atoms in an alkoxy group.

The term "C₃-C₁₀ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having substantially the same structure as the C₃-C₁₀ cycloalkyl group.

The term "C₁-C₁₀ heterocycloalkyl group" as used herein refers to a monovalent monocyclic group having at least one heteroatom selected from N, O, Si, P, and S as a ring-forming atom and 1 to 10 carbon atoms, and non-limiting examples thereof include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having substantially the same structure as the C₁-C₁₀ heterocycloalkyl group.

The term "C₃-C₁₀ cycloalkenyl group" as used herein refers to a monovalent monocyclic group that has 3 to 10 carbon atoms, at least one carbon-carbon double bond in the ring thereof, and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having substantially the same structure as the C₃-C₁₀ cycloalkenyl group.

The term "C₁-C₁₀ heterocycloalkenyl group" as used herein refers to a monovalent monocyclic group that has at least one heteroatom selected from N, O, Si, P, and S as a ring-forming atom, 1 to 10 carbon atoms, and at least one carbon-carbon double bond in its ring. Non-limiting examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein refers to a divalent group having substantially the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the two or more rings may be fused to each other. Corresponding definitions apply to other ranges given for the number of carbon atoms in an aryl/arylene group.

The term "C₁-C₆₀ heteroaryl group" as used herein refers to a monovalent group having a heterocyclic aromatic system that has at least one heteroatom selected from N, O, Si, P, and S as a ring-forming atom, in addition to 1 to 60 carbon atoms. The term "C₁-C₆₀ heteroarylene group" as used herein refers to a divalent group having a heterocyclic aromatic system that has at least one heteroatom selected from N, O, Si, P, and S as a ring-forming atom, in addition to 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the two or more rings may be condensed with each other. Corresponding definitions apply to other ranges given for the number of carbon atoms in an heteroaryl/heteroarylene group.

The term "C₆-C₆₀ aryloxy group" as used herein refers to -OA₁₀₂ (wherein A₁₀₂ is a C₆-C₆₀ aryl group), and the term "C₆-C₆₀ arylthio group" as used herein refers to -SA₁₀₃ (wherein A₁₀₃ is a C₆-C₆₀ aryl group). Corresponding definitions apply to other ranges given for the number of carbon atoms in an aryloxy group and an arylthio group.

The term "monovalent non-aromatic condensed polycyclic group" as used herein refers to a monovalent group having two or more rings condensed with each other, only carbon atoms (for example, 8 to 60 carbon atoms) as ring-forming atoms, and no aromaticity in its molecular structure when considered as a whole. A detailed example of the monovalent non-aromatic condensed polycyclic group is a fluorenyl group and an adamantyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group having two or more rings condensed to each other, at least one heteroatom selected from N, O, Si, P, and S, other than carbon atoms (for example, 1 to 60 carbon atoms) as a ring-forming atom, and no aromaticity in its molecular structure when considered as a whole. An example of the monovalent non-aromatic condensed heteropolycyclic group is an azaadamantyl group. The term "divalent non-aromatic condensed heteropolycyclic group" as used herein refers to a divalent group having the same structure as the monovalent non-aromatic condensed heteropolycyclic group.

The term "C₅-C₆₀ carbocyclic group" as used herein refers to a monocyclic or polycyclic group that includes only carbon as a ring-forming atom, and consists of 5 to 60 carbon atoms. The C₅-C₆₀ carbocyclic group may be an aromatic carbocyclic group or a non-aromatic carbocyclic group. The C₅-C₆₀ carbocyclic group may be a ring (such as benzene), a monovalent group (such as a phenyl group), or a divalent group (such as a phenylene group). In one or more embodiments, depending on the number of substituents connected to the C₅-C₆₀ carbocyclic group, the C₅-C₆₀ carbocyclic group may be a trivalent group or a quadrivalent group. Corresponding definitions apply to other ranges given for the number of carbon atoms in a carbocyclic group.

The term "C₁-C₆₀ heterocyclic group" as used herein refers to a group having substantially the same structure as the C₅-C₆₀ carbocyclic group, except that as a ring-forming atom, at least one heteroatom selected from N, O, Si, P, and S is used in addition to carbon (the number of carbon atoms may be in the range of 1 to 60). Corresponding definitions apply to other ranges given for the number of carbon atoms in a heterocyclic group.

In the present specification, at least one substituent of the substituted C₅-C₆₀ *(e.g.* C₅-C₃₀) carbocyclic group, the substituted C₁-C₆₀ (*e.g.* C₁-C₂₀) heterocyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ (*e.g*. C₆-C₃₀) arylene group, the substituted C₁-C₆₀ (*e.g*. C₁-C₂₀) heteroarylene group, the substituted divalent non-aromatic condensed polycyclic group, the substituted divalent non-aromatic condensed heteropolycyclic group, the substituted C₁-C₆₀ (*e.g*. C₁-C₂₀) alkyl group, the substituted C₂-C₆₀ *(e.g.* C₂-C₂₀) alkenyl group, the substituted C₂-C₆₀ *(e.g.* C₂-C₂₀) alkynyl group, the substituted C₁-C₆₀ (*e.g*. C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (*e.g.* C₆-C₃₀) aryl group, the substituted C₆-C₆₀ (*e.g.* C₆-C₃₀) aryloxy group, the substituted C₆-C₆₀ (*e.g.* C₆-C₃₀) arylthio group, the substituted C₁-C₆₀ (*e.g.* C₁-C₂₀) heteroaryl group, the substituted monovalent non-aromatic condensed polycyclic group, and the substituted monovalent non-aromatic condensed heteropolycyclic group may be selected from:
deuterium (-D), -F, -Cl, -Br, -I, a hydroxyl group, a cyano group, a nitro group, an amidino group, a hydrazino group, a hydrazono group, a C₁-C₆₀ (*e.g*. C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g*. C₁-C₂₀) alkoxy group;
a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g*. C₁-C₂₀) heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g*. C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g*. C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, a monovalent non-aromatic condensed heteropolycyclic group, a biphenyl group, and a terphenyl group.

The term "Ph" as used herein refers to a phenyl group, the term "Me" as used herein refers to a methyl group, the term "Et" as used herein refers to an ethyl group, the term "ter-Bu" or "Bu^{t}" as used herein refers to a tert-butyl group, and the term "OMe" as used herein refers to a methoxy group.

The term "biphenyl group" as used herein refers to "a phenyl group substituted with a phenyl group." In other words, the "biphenyl group" is a substituted phenyl group having a C₆-C₆₀ aryl group as a substituent.

The term "terphenyl group" as used herein refers to "a phenyl group substituted with a biphenyl group". In other words, the "terphenyl group" is a substituted phenyl group having, as a substituent, a C₆-C₆₀ aryl group substituted with a C₆-C₆₀ aryl group.

* and *' as used herein, unless defined otherwise, each refer to a binding site to a neighboring atom in a corresponding formula.

Hereinafter, a light-emitting device according to embodiments will be described in more detail with reference to Examples.

### [Examples]

### Example 1

As a substrate and an anode, a glass substrate with 15 Ωcm² (150 Å) ITO thereon (manufactured by Corning Inc.) was cut to a size of 50 mm×50 mm×0.7 mm, sonicated using isopropyl alcohol and pure water for 5 minutes each, irradiated with ultraviolet (UV) light for 30 minutes thereto, and exposed to ozone for cleaning. Then, the resultant glass substrate was loaded onto a vacuum deposition apparatus.

HT3 and F4-TCNQ were co-deposited at a weight ratio of 9:1 on the ITO anode to form a hole injection layer having a thickness of 50 Å. HT3 (100 Å) was deposited on the hole injection layer to form a hole transport layer.

HT18 (100 Å) was deposited on the hole transport layer to form a hole transport auxiliary layer, BH8 and BD1 were co-deposited at a weight ratio of 95:5 to form an emission layer having a thickness of 200 Å, and then, ET28 (50 Å) was deposited thereon to form an upper auxiliary layer, thereby completing the manufacture of a first light-emitting unit.

ET1 and LiQ (50 Å) were co-deposited at a weight ratio of 9:1 on the first light-emitting unit to form an electron transport layer.

Bphen and Li were co-deposited at a weight ratio of 9:1 on the electron transport layer to form an n-type charge generation layer having a thickness of 50 Å.

HT3 and Bi₂Te₃ were co-deposited at a weight ratio of 9:1 on the n-type charge generation layer to form a first doping layer having a thickness of 100 Å, and HT3 and KI were co-deposited at the weight ratio of 9:1 on the first doping layer to form a second doping layer having a thickness of 200 Å to form a second doping layer, thereby completing the manufacture of a p-type charge generation layer. As a result, a first charge generation layer was formed, in which an n-type charge generation layer and a p-type charge generation layer were stacked.

A second light-emitting unit was formed on the first charge generation layer in substantially the same manner as used to form the first light-emitting unit, and ET1 and LiQ (50 Å) were co-deposited at a weight ratio of 9:1 on the second light-emitting unit.

A second charge generation layer was formed on the electron transport layer in substantially the same manner as used to form the first charge generation layer.

A third light-emitting unit was formed on the second charge generation layer in substantially the same manner as used to form the first light-emitting unit.

On the third light-emitting unit, ET1 and LiQ were co-deposited at a weight ratio of 9:1 to form an electron transport layer having a thickness of 50 Å, and Yb (15Å) was deposited thereon to form an electron injection layer, thereby completely forming an electron transport region.

AgMg (85 Å) was deposited on the electron transport region to form a cathode, and HT28 (700 Å) was deposited on the cathode to form a capping layer, thereby completing the manufacture of an organic light-emitting device.

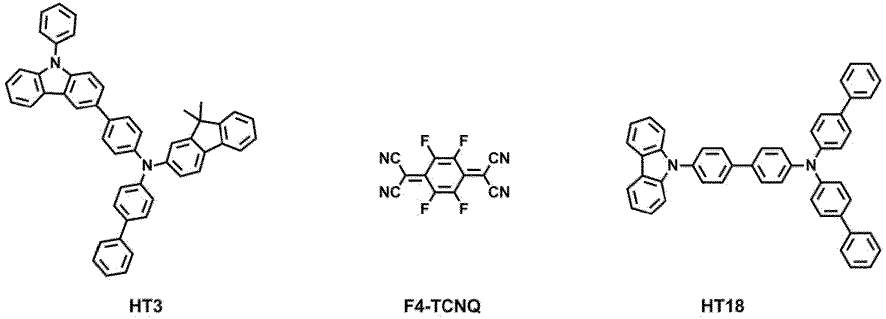

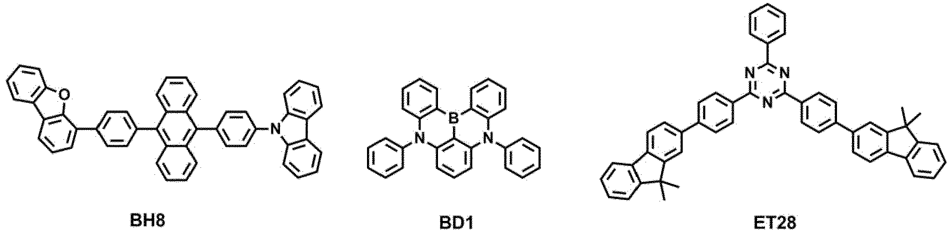

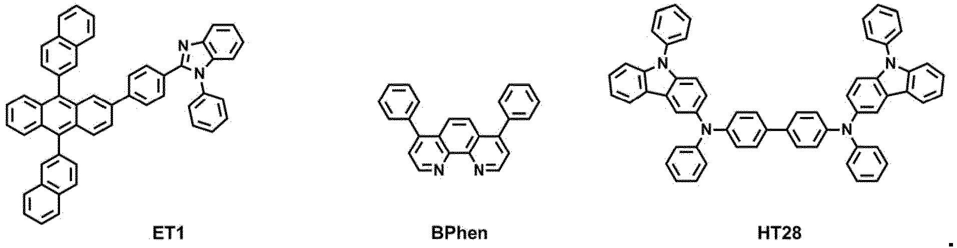

### Example 2

An organic light-emitting device was manufactured in the same manner as in Example 1, except that, in forming the emission layer, H-1 and D-1 were used instead of BH8 and BD1:

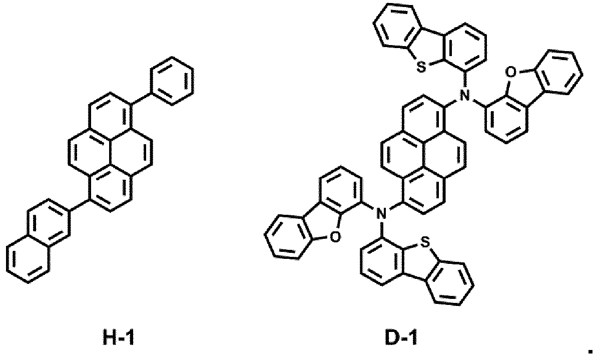

### Comparative Example 1

An organic light-emitting device was manufactured in substantially the same manner as in Example 2, except that, in forming the p-type charge generation layer, the second doping layer was not formed, and the first doping layer was formed using HT3 and HAT-CN and the thickness thereof was adjusted to be 300 Å.

### Comparative Example 2

An organic light-emitting device was manufactured in substantially the same manner as in Example 1, except that, in forming the p-type charge generation layer, the second doping layer was not formed, and the thickness of the first doping layer was adjusted to be 300 Å.

### Comparative Example 3

An organic light-emitting device was manufactured in substantially the same manner as in Example 1, except that, in forming the p-type charge generation layer, the first doping layer was not formed, and the thickness of the second doping layer was adjusted to be 300 Å.

### Comparative Example 4

An organic light-emitting device was manufactured in substantially the same manner as in Example 2, except that, in forming the first doping layer, HAT-CN was used alone, and, in forming the second doping layer, HAT-CN and NPD (NPD in the amount of 10 wt%) were used.

### Comparative Example 5

An organic light-emitting device was manufactured in substantially the same manner as in Example 1, except that, in forming the second doping layer, KI was used alone.

### Evaluation Example 1

The efficiency (Cd/A) and lifespan (hr) of each of the organic light-emitting devices manufactured according to Examples 1 and 2 and Comparative Examples 1 to 5 at the current density of 20 mA/cm² were measured, and the results obtained therefrom are shown on a percentage basis (%) with respect to Comparative Example 1 in Table 1.

**Table 1**

| | p-type charge generation layer | | Emission layer | | Efficiency | Lifespan |
|---|---|---|---|---|---|---|
| | First doping layer | Second doping layer | Host | Dopant | | |
| Example 1 | HT3+Bi₂Te₃ | HT3+KI | BH8 | BD1 | 130% | 125% |
| Example 2 | HT3+Bi₂Te₃ | HT3+KI | H-1 | D-1 | 110 % | 105% |
| Comparative Example 1 | HT3+HAT-CN | | H-1 | D-1 | 100 % | 100 % |
| Comparative Example 2 | HT3+Bi₂Te₃ | - | BH8 | BD1 | 10% | 7% |
| Comparative Example 3 | - | HT3+KI | BH8 | BD1 | 7% | 4% |
| Comparative Example 4 | HAT-CN | HAT-CN+NPD | H-1 | D-1 | 70% | 65% |
| Comparative Example 5 | HT3+Bi₂Te₃ | KI | BH8 | BD1 | 80% | 85% |

Referring to Table 1, the organic light-emitting devices of Examples 1 and 2 had higher or greater efficiencies and life spans than the organic light-emitting devices of Comparative Examples 1 to 5.

The organic light-emitting devices according to embodiments of the present disclosure may have a high efficiency and/or a long lifespan.

As used herein, the terms "substantially," "about," and similar terms are used as terms of approximation and not as terms of degree, and are intended to account for the inherent deviations in measured or calculated values that would be recognized by those of ordinary skill in the art.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

It should be understood that embodiments described herein should be considered in a descriptive sense only and not for purposes of limitation. Descriptions of features or aspects within each embodiment should typically be considered as being available for other similar features or aspects in other embodiments. While one or more embodiments have been described with reference to the drawings, it will be understood by those of ordinary skill in the art that various changes in form and details may be made therein without departing from the scope as defined by the following claims.

## Claims

1. An organic light-emitting device (10) comprising:
a first electrode (110);
a second electrode (190) facing the first electrode (110);
m light-emitting units (153) stacked between the first electrode (110) and the second electrode (190) and comprising at least one emission layer; and
m-1 charge generating layers (155), each located between two neighboring light-emitting units (153) of the m light-emitting units (153) and comprising an n-type charge generating layer (155N) and a p-type charge generation layer (155P),
wherein m is an integer of 2 or more,
**characterized in that** at least one of the m-1 p-type charge generation layers (155P) comprises a first doping layer (155P') and a second doping layer (155P"),
the first doping layer (155P') comprises a first organic material and a first inorganic material,
the second doping layer (155P") comprises a second organic material and a second inorganic material, and
the first inorganic material and the second inorganic material are different from each other.

2. An organic light-emitting device (10) according to claim 1, wherein m is 2 or 3.

3. An organic light-emitting device (10) according to claim 1 or claim 2, wherein the first doping layer (155P') is located at the interface between the n-type charge generation layer (155N) and the second doping layer (155P").

4. An organic light-emitting device (10) according to any one of claims 1 to 3, wherein:
(i) the first inorganic material comprises a post-transition metal, a metalloid, a compound comprising two or more post-transition metals, a compound comprising two or more metalloids, a compound comprising a post-transition metal and a metalloid, or any combination thereof,
the post-transition metal comprising at least one selected from aluminium (Al), gallium (Ga), indium (In), thallium (TI), tin (Sn), lead (Pb), flerovium (FI), bismuth (Bi), and polonium (Po), and
the metalloid comprising at least one selected from boron (B), silicon (Si), germanium (Ge), arsenic (As), antimony (Sb), tellurium (Te), and astatine (At); or
(ii) the first inorganic material comprises Bi₂Te₃, Bi₇Te₃, Bi₂Te, Bi₄Te₃, BiTe, Bi₆Te₇, Bi₄Te₅, BiₓTe_{y} (0<x<100, 0<y<100, 0<x+y≤100), Sb₂Te₃, In₂Te₃, Ga₂Te₂, Al₂Te₃, Tl₂Te₃, As₂Te₃, GeSbTe, SnTe, PbTe, SiTe, GeTe, SiGe, AllnSb, AlGaSb, AlAsSb, GaAs, InSb, AlSb, AlAs, AlₐInₐSb(0<a<1), Al_{b}In_{(1-b)}Sb(0<b<1), AlSb, GaSb, AllnGaAs, or any combination thereof.

5. An organic light-emitting device (10) according to any one of claims 1 to 4, wherein the second inorganic material comprises a halide of an alkali metal, a halide of an alkali earth metal, a halide of a transition metal, a halide of a post-transition metal, a halide of a lanthanum metal, or any combination thereof.

6. An organic light-emitting device (10) according to any one of claims 1 to 5, wherein:
(i) the second inorganic material comprises an iodide of an alkali metal, an iodide of an alkali earth metal, an iodide of a transition metal, an iodide of a post-transition metal, an iodide of a lanthanum metal, or any combination thereof; or
(ii) the second inorganic material comprises Lil, Nal, KI, Rbl, Csl, BeI₂, MgI₂, CaI₂, SrI₂, BaI₂, Ybl, YbI₂, YbI₃, SMI₃, Cul, TlI, Agl, CdI₂, HgI₂, SnI₂, PbI₂, BiI₃, ZnI₂, MnI₂, FeI₂, CoI₂, NiI₂, AlI₃, InI₃, GaI₃, ThI₄, UI₃, or any combination thereof.

7. An organic light-emitting device (10) according to any one of claims 1 to 6, wherein the first organic material and the second organic material each independently comprise a hole transport material.

8. An organic light-emitting device (10) according to any one of claims 1 to 7, wherein the first organic material and the second organic material are each independently a compound represented by one selected from Formulae 201, 202, and 301-2 to 301-4: 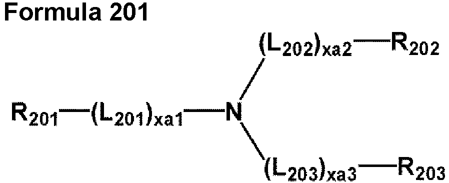 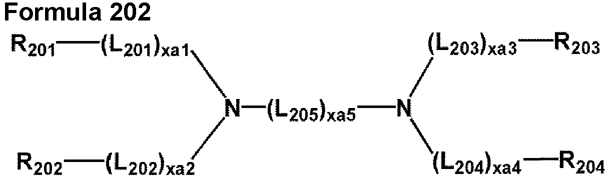 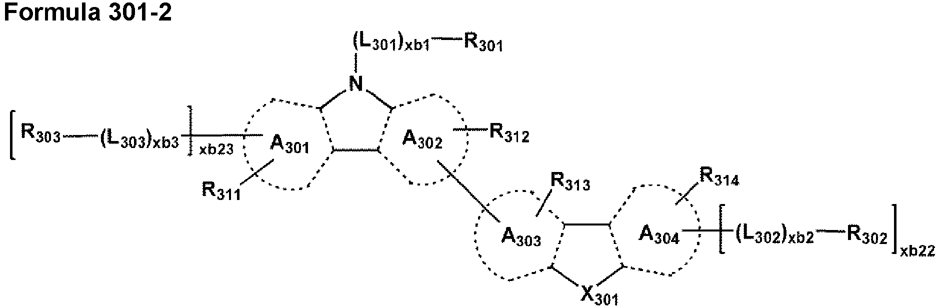 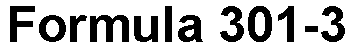 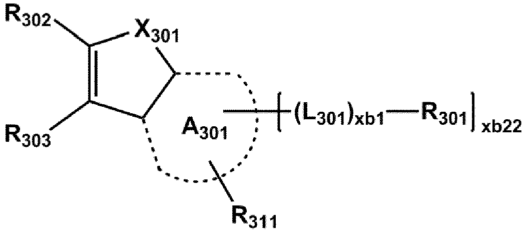 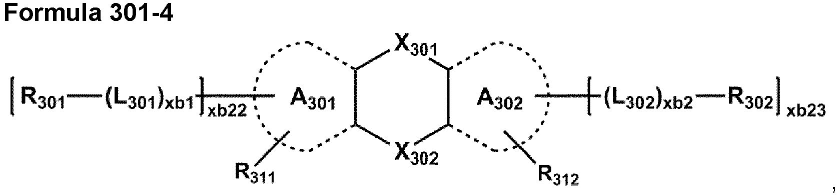 wherein, in Formulae 201, 202 and 301-2 to 301-4,
A₃₀₁ to A₃₀₄ are each independently selected from a benzene ring, a naphthalene ring, a phenanthrene ring, a fluoranthene ring, a triphenylene ring, a pyrene ring, a chrysene ring, a pyridine ring, a pyrimidine ring, an indene ring, a fluorene ring, a spiro-bifluorene ring, a benzofluorene ring, a dibenzofluorene ring, an indole ring, a carbazole ring, a benzocarbazole ring, a dibenzocarbazole ring, a furan ring, a benzofuran ring, a dibenzofuran ring, a naphthofuran ring, a benzonaphthofuran ring, a dinaphthofuran ring, a thiophene ring, a benzothiophene ring, a dibenzothiophene ring, a naphthothiophene ring, a benzonaphthothiophene ring, and a dinaphthothiophene ring,
X₃₀₁ is O, S, or N-[(L₃₀₄)x_{b4}-R₃₀₄],
X₃₀₂ is a single bond, C(R₃₀₅)(R₃₀₆), O, S, or N-[(L₃₀₅)_{xb5}-R₃₀₅],
L₂₀₁ to L₂₀₄ and L₃₀₁ to L₃₀₅ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
L₂₀₅ is selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xa1 to xa4 are each independently an integer from 0 to 3,
xa5 is an integer from 1 to 10,
xb1 to xb5 are each an integer from 0 to 5,
xb22 and xb23 are each independently 0, 1, or 2,
R₂₀₁ to R₂₀₄ and Q₂₀₁ are each independently selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group,
R₃₀₁ to R₃₀₆ are each independently selected from hydrogen, deuterium, -F, -Cl, -Br, -I, a hydroxyl group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), and - P(=O)(Q₃₀₁)(Q₃₀₂),
R₃₁₁ to R₃₁₄ are each independently selected from hydrogen, deuterium, -F, -Cl, -Br, -I, a hydroxyl group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂), and
Q₃₁ to Q₃₃ and Q₃₀₁ to Q₃₀₃ are each independently selected from a C₁-C₁₀ alkyl group, a C₁-C₁₀ alkoxy group, a phenyl group, a biphenyl group, a terphenyl group, and a naphthyl group.

9. An organic light-emitting device (10) according to any one of claims 1 to 8, wherein:
(i) the amount of the first inorganic material included in the first doping layer (155P') is about 0.1 parts by weight to about 20 parts by weight based on 100 parts by weight of the first organic material, and
the amount of the second inorganic material included in the second doping layer (155P") is about 0.1 parts by weight to about 20 parts by weight based on 100 parts by weight of the second organic material; and/or
(ii) the thickness of the first doping layer (155P') and the second doping layer (155P") are each independently about 1 Å to about 300 Å.

10. An organic light-emitting device (10) according to any one of claims 1 to 9, wherein the m-1 n-type charge generation layers (155N) include a metal-free compound containing at least one π electron deficient nitrogen-containing ring, a compound represented by Formula 601, a metal-containing material, or any combination thereof:
**Formula 601** [Ar₆₀₁]ₓₑ₁₁-[(L₆₀₁)ₓₑ₁-R₆₀₁]ₓₑ₂₁,
wherein, in Formula 601,
Ar₆₀₁ is a substituted or unsubstituted C₅-C₆₀ carbocyclic group or a substituted or unsubstituted C₁-C₆₀ heterocyclic group,
xe11 is 1, 2, or 3,
L₆₀₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xe1 is an integer from 0 to 5,
R₆₀₁ is selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂),
Q₆₀₁ to Q₆₀₃ are each independently a C₁-C₁₀ alkyl group, a C₁-C₁₀ alkoxy group, a phenyl group, a biphenyl group, a terphenyl group, or a naphthyl group, and
xe21 is an integer from 1 to 5.

11. An organic light-emitting device (10) according to any one of claims 1 to 10, wherein at least one emission layer of the m light-emitting units (153) comprises a condensed cyclic compound represented by Formula 3: 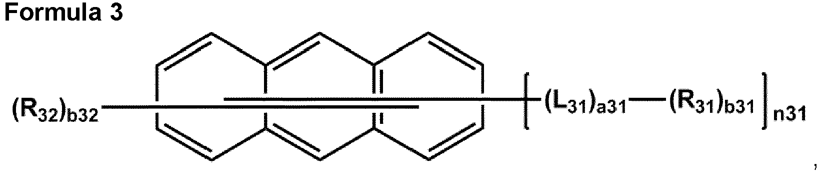 wherein, in Formula 3,
L₃₁ is selected from an unsubstituted or substituted C₅-C₆₀ carbocyclic group and an unsubstituted or substituted C₁-C₆₀ heterocyclic group,
a31 is an integer from 0 to 5,
R₃₁ and R₃₂ are each independently selected from hydrogen, deuterium, -F, -Cl, -Br, -I, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂),
b31 and b32 are each independently an integer from 1 to 5,
n31 is an integer from 1 to 3, and
at least one of the substituted C₅-C₆₀ carbocyclic group, the substituted C₁-C₆₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, or the substituted monovalent non-aromatic condensed heteropolycyclic group is selected from:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, - Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂), and
wherein Q₁₁ to Q₁₃, Q₂₁ to Q₂₃ and Q₃₁ to Q₃₃ are each independently selected from hydrogen, deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group, optionally wherein at least one of R₃₁ or R₃₂ in Formula 3 is a group represented by one selected from Formulae 3A and 3B: 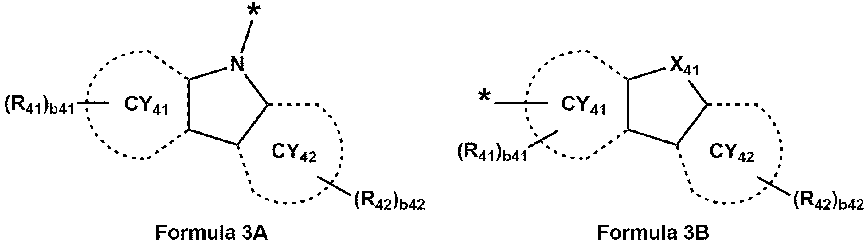 wherein, in Formulae 3A and 3B,
CY₄₁ and CY₄₂ are each independently selected from a C₅-C₃₀ carbocyclic group, and a C₁-C₃₀ heterocyclic group,
X₄₁ is selected from O, S, and N(R₄₃),
R₄₁ to R₄₃ are each independently selected from hydrogen, deuterium, -F, -Cl, - Br, -I, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂),
b41 and b42 are each independently an integer from 1 to 10, and
* indicates a binding site to a neighboring atom.

12. An organic light-emitting device (10) according to any one of claims 1 to 11, wherein at least one emission layer of the m light-emitting units (153) comprises a condensed cyclic compound represented by Formula 4: 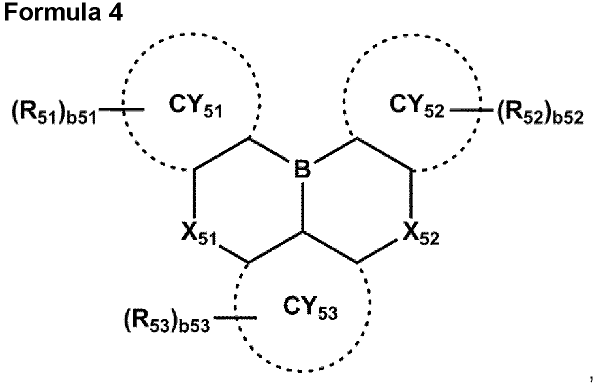 wherein, in Formula 4,
X₅₁ is selected from C(R₅₄)(R₅₅), N(R₅₄), O, and S,
X₅₂ is selected from C(R₅₆)(R₅₇), N(R₅₆), O, and S,
CY₅₁ to CY₅₃ are each independently selected from a C₅-C₃₀ carbocyclic group and a C₁-C₃₀ heterocyclic group,
R₅₁ to R₅₃ and R₅₄ to R₅₇ are each independently selected from hydrogen, deuterium, -F, -Cl, -Br, -I, a hydroxyl group, a cyano group, a nitro group, an amidino group, a hydrazine group, a hydrazone group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂),
b51 to b53 are each independently an integer from 1 to 10,
when b51, b52, and/or b53 are at least two, two neighboring R₅₁ groups, two neighboring R₅₂ groups, and/or two neighboring R₅₃ groups, respectively, are optionally be linked to form a C₅-C₃₀ carbocyclic group or a C₁-C₃₀ heterocyclic group, and
at least one of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, or the substituted monovalent non-aromatic condensed heteropolycyclic group is selected from:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, - Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂), and
wherein Q₁₁ to Q₁₃, Q₂₁ to Q₂₃ and Q₃₁ to Q₃₃ are each independently selected from hydrogen, deuterium, -F, -Cl, -Br, -I, a hydroxyl group, a cyano group, a nitro group, an amidino group, a hydrazine group, a hydrazone group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

13. An organic light-emitting device (10) according to any one of claims 1 to 12, wherein m is an integer of 3 or more, and
the maximum emission wavelengths of light emitted from at least three of the m light-emitting units are identical to each other.

14. An electronic apparatus (100) comprising an organic light-emitting device (10) according to any one of claims 1 to 13.

15. An electronic apparatus (100) according to claim 14, further comprising a color conversion layer (240) located on a travelling direction of at least one light emitted from the organic light-emitting device (10), optionally wherein the color conversion layer (240) comprises quantum dots.

## Patentansprüche

1. Organische lichtemittierende Vorrichtung (10), umfassend:
eine erste Elektrode (110);
eine zweite Elektrode (190), die der ersten Elektrode (110) zugewandt ist;
m lichtemittierende Einheiten (153), die zwischen der ersten Elektrode (110) und der zweiten Elektrode (190) geschichtet sind und mindestens eine Emissionsschicht umfassen; und
m - 1 Ladungserzeugungsschichten (155), die jeweils zwischen zwei benachbarten lichtemittierenden Einheiten (153) der m lichtemittierenden Einheiten (153) angeordnet sind und eine n-Ladungserzeugungsschicht (155N) und eine p-Ladungserzeugungsschicht (155P) umfassen,
wobei m eine ganze Zahl von 2 oder mehr ist,
**dadurch gekennzeichnet, dass** mindestens eine der m-1 p-Ladungserzeugungsschichten (155P) eine erste Dotierungsschicht (155P') und eine zweite Dotierungsschicht (155P'') umfasst,
die erste Dotierungsschicht (155P') ein erstes organisches Material und ein erstes anorganisches Material umfasst,
die zweite Dotierungsschicht (155P'') ein zweites organisches Material und ein zweites anorganisches Material umfasst, und
das erste anorganische Material und das zweite anorganische Material voneinander verschieden sind.

2. Organische lichtemittierende Vorrichtung (10) nach Anspruch 1, wobei m 2 oder 3 ist.

3. Organische lichtemittierende Vorrichtung (10) nach Anspruch 1 oder 2, wobei die erste Dotierungsschicht (155P') an der Grenzfläche zwischen der n-Ladungserzeugungsschicht (155N) und der zweiten Dotierungsschicht (155P'') angeordnet ist.

4. Organische lichtemittierende Vorrichtung (10) nach einem der Ansprüche 1 bis 3, wobei:
(i) das erste anorganische Material ein Post-Übergangsmetall, ein Halbmetall, eine Verbindung, die zwei oder mehr Post-Übergangsmetalle umfasst, eine Verbindung, die zwei oder mehr Halbmetalle umfasst, eine Verbindung, die ein Post-Übergangsmetall und ein Halbmetall umfasst, oder jegliche Kombination davon umfasst,
wobei das Post-Übergangsmetall mindestens eines umfasst, das aus Aluminium (Al), Gallium (Ga), Indium (In), Thallium (Tl), Zinn (Sn), Blei (Pb), Flerovium (Fl), Wismut (Bi) und Polonium (Po) ausgewählt ist, und
wobei das Halbmetall mindestens eines der Elemente Bor (B), Silizium (Si), Germanium (Ge), Arsen (As), Antimon (Sb), Tellur (Te) und Astat (At) umfasst; oder
(ii) das erste anorganische Material Bi₂Te₃, Bi₇Te₃, Bi₂Te, Bi₄Te₃, BiTe, Bi₆Te₇, Bi₄Te₅, BiₓTe_{y} (0 < x < 100, 0 < y < 100, 0 < x + y ≤ 100), Sb₂Te₃, In₂Te₃, Ga₂Te₂, Al₂Te₃, Tl₂Te₃, As₂Te₃, GeSbTe, SnTe, PbTe, SiTe, GeTe, SiGe, AlInSb, AlGaSb, AlAsSb, GaAs, InSb, AlSb, AlAs, AlₐInₐSb(0 < a < 1), Al_{b}In_{(1 - b)}Sb(0 < b < 1), AlSb, GaSb, AlInGaAs oder jegliche Kombination davon umfasst.

5. Organische lichtemittierende Vorrichtung (10) nach einem der Ansprüche 1 bis 4, wobei das zweite anorganische Material ein Halogenid eines Alkalimetalls, ein Halogenid eines Erdalkalimetalls, ein Halogenid eines Übergangsmetalls, ein Halogenid eines Post-Übergangsmetalls, ein Halogenid eines Lanthanoids oder eine beliebige Kombination davon umfasst.

6. Organische lichtemittierende Vorrichtung (10) nach einem der Ansprüche 1 bis 5, wobei:
(i) das zweite anorganische Material ein Iodid eines Alkalimetalls, ein Iodid eines Erdalkalimetalls, ein Iodid eines Übergangsmetalls, ein Iodid eines Post-Übergangsmetalls, ein Iodid eines Lanthanoids oder jegliche Kombination davon umfasst; oder
(ii) das zweite anorganische Material LiI, NaI, KI, RbI, CsI, BeI₂, MgI₂, CaI₂, SrI₂, BaI₂, YbI, YbI₂, YbI₃, SmI₃, CuI, TlI, AgI, CdI₂, HgI₂, SnI₂, PbI₂, BiI₃, ZnI₂, MnI₂, FeI₂, CoI₂, NiI₂, AlI₃, InI₃, GaI₃, ThI₄, UI₃, oder jegliche Kombination davon umfasst.

7. Organische lichtemittierende Vorrichtung (10) nach einem der Ansprüche 1 bis 6, wobei das erste organische Material und das zweite organische Material jeweils unabhängig ein Löchertransportmaterial umfassen.

8. Organische lichtemittierende Vorrichtung (10) nach einem der Ansprüche 1 bis 7, wobei das erste organische Material und das zweite organische Material jeweils unabhängig eine Verbindung sind, die durch eine Formel dargestellt wird, die aus den Formeln 201, 202 und 301-2 bis 301-4 ausgewählt ist: 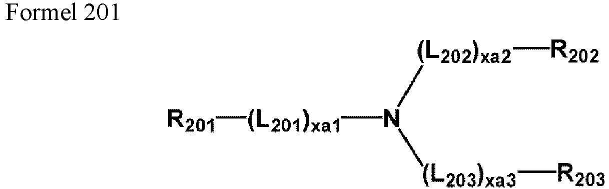 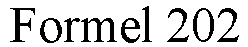 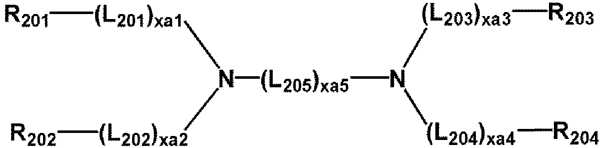 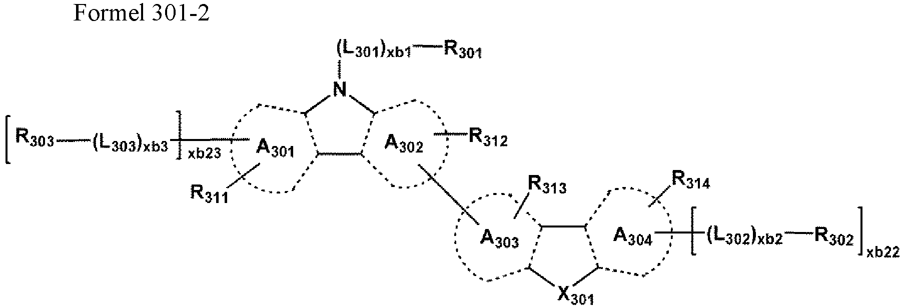 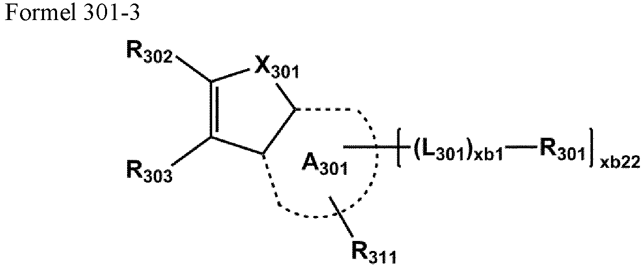 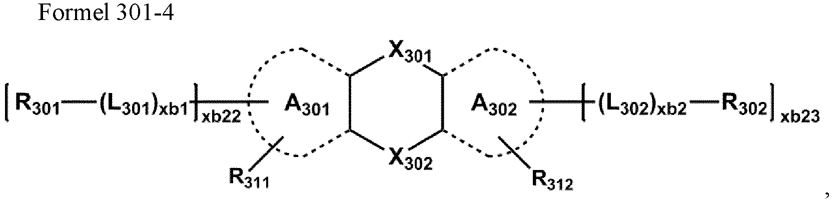 wobei in den Formeln 201, 202 und 301-2 bis 301-4:
A₃₀₁ bis A₃₀₄ jeweils unabhängig aus einem Benzolring, einem Naphthalinring, einem Phenanthrenring, einem Fluoranthenring, einem Triphenylenring, einem Pyrenring, einem Chrysenring, einem Pyridinring, einem Pyrimidinring, einem Indenring, einem Fluorenring, einem Spirobifluorenring, einem Benzofluorenring, einem Dibenzofluorenring, einem Indolring, einem Carbazolring, einem Benzocarbazolring, einem Dibenzocarbazolring, einem Furanring, einem Benzofuranring, einem Dibenzofuranring, einem Naphthofuranring, einem Benzonaphthofuranring, einem Dinaphthofuranring, einem Thiophenring, einem Benzothiophenring, einem Dibenzothiophenderivat, einem Naphthothiophenderivat, einem Benzonaphthothiophenderivat und einem Dinaphthothiophenderivat ausgewählt sind,
X₃₀₁ O, S oder N-[(L₃₀₄)_{xb4}-R₃₀₄] ist,
X₃₀₂ eine Einfachbindung, C(R₃₀₅)(R₃₀₆), O, S oder N-[(L₃₀₅)_{xb5}-R₃₀₅] ist,
L₂₀₁ bis L₂₀₄ und L₃₀₁ bis L₃₀₅ jeweils unabhängig aus einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Cycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe, einer substituierten oder unsubstituierten zweiwertigen nicht-aromatischen kondensierten polycyclischen Gruppe und einer substituierten oder unsubstituierten zweiwertigen nicht-aromatischen kondensierten heteropolycyclischen Gruppe ausgewählt sind,
L₂₀₅ aus *-O-*', *-S-*', *-N(Q₂₀₁)-*', einer substituierten oder unsubstituierten C₁-C₂₀-Alkylengruppe, einer substituierten oder unsubstituierten C₂-C₂₀-Alkenylengruppe, einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Cycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe, einer substituierten oder unsubstituierten zweiwertigen nicht-aromatischen kondensierten polycyclischen Gruppe und einer substituierten oder unsubstituierten zweiwertigen nicht-aromatischen kondensierten heteropolycyclischen Gruppe ausgewählt ist,
xa1 bis xa4 jeweils unabhängig eine ganze Zahl von 0 bis 3 sind,
xa5 eine ganze Zahl von 1 bis 10 ist,
xb1 bis xb5 jeweils eine ganze Zahl von 0 bis 5 sind,
xb22 und xb23 jeweils unabhängig 0, 1 oder 2 sind,
R₂₀₁ bis R₂₀₄ und Q₂₀₁ jeweils unabhängig aus einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polycyclischen Gruppe und einer substituierten oder unsubstituierten einwertigen nicht-aromatischen kondensierten heteropolycyclischen Gruppe ausgewählt sind,
R₃₀₁ bis R₃₀₆ jeweils unabhängig aus Wasserstoff, Deuterium, -F, -Cl, -Br, -I, einer Hydroxylgruppe, einer Nitrogruppe, einer Amidingruppe, einer Hydrazingruppe, einer Hydrazongruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polycyclischen Gruppe, einer substituierten oder unsubstituierten einwertigen nicht-aromatischen kondensierten heteropolycyclischen Gruppe, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁) und -P(=O)(Q₃₀₁)(Q₃₀₂) ausgewählt sind,
R₃₁₁ bis R₃₁₄ jeweils unabhängig aus Wasserstoff, Deuterium, -F, -Cl, -Br, -I, einer Hydroxylgruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, eine Terphenylgruppen, eine Naphthylgruppen, -Si(Q₃₁)(Q₃₂)(Q₃₃), -N(Q₃₁)(Q₃₂), -B(Q₃₁)(Q₃₂), -C(=O)(Q₃₁), -S(=O)₂( Q₃₁) und -P(=O)(Q₃₁)(Q₃₂) ausgewählt sind, und
Q₃₁ bis Q₃₃ und Q₃₀₁ bis Q₃₀₃ jeweils unabhängig aus einer C₁-C₁₀-Alkylgruppe, einer C₁-C₁₀-Alkoxygruppe, einer Phenylgruppe, einer Biphenylgruppe, einer Terphenylgruppen und einer Naphthylgruppen ausgewählt sind.

9. Organische lichtemittierende Vorrichtung (10) nach einem der Ansprüche 1 bis 8, wobei:
(i) die Menge des ersten anorganischen Materials, das in der ersten Dotierungsschicht (155P') eingeschlossen ist, etwa 0,1 Gewichtsteile bis etwa 20 Gewichtsteile beträgt, bezogen auf 100 Gewichtsteile des ersten organischen Materials, und
die Menge des zweiten anorganischen Materials, das in der zweiten Dotierungsschicht (155P'') eingeschlossen ist, etwa 0,1 Gewichtsteile bis etwa 20 Gewichtsteile beträgt, bezogen auf 100 Gewichtsteile des zweiten organischen Materials; und/oder
(ii) die Dicke der ersten Dotierungsschicht (155P') und der zweiten Dotierungsschicht (155P'') jeweils unabhängig etwa 1 Å bis etwa 300 Å beträgt.

10. Organische lichtemittierende Vorrichtung (10) nach einem der Ansprüche 1 bis 9, wobei die m - 1 n-Ladungserzeugungsschichten (155N) eine metallfreie Verbindung, die mindestens einen π-elektronenarmen stickstoffhaltigen Ring enthält, eine Verbindung, die durch Formel 601 dargestellt wird, ein metallhaltiges Material oder jegliche Kombination davon einschließen:
Formel 601 [Ar₆₀₁]ₓₑ₁₁-[(L₆₀₁)ₓₑ₁-R₆₀₁]ₓₑ₂₁,
wobei in Formel 601:
Ar₆₀₁ eine substituierte oder unsubstituierte carbocyclische C₅-C₆₀-Gruppe oder eine substituierte oder unsubstituierte heterocyclisch C₁-C₆₀-Gruppe ist,
xe11 1, 2 oder 3 ist,
L₆₀₁ aus einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Cycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe, einer substituierten oder unsubstituierten zweiwertigen nicht-aromatischen kondensierten polycyclischen Gruppe und einer substituierten oder unsubstituierten zweiwertigen nicht-aromatischen kondensierten heteropolycyclischen Gruppe ausgewählt ist,
xe1 eine ganze Zahl von 0 bis 5 ist,
R₆₀₁ aus einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polycyclischen Gruppe, einer substituierten oder unsubstituierten einwertigen nicht-aromatischen kondensierten heteropolycyclischen Gruppe, -Si(Q₆₀₁)(Q₆₀₂)(Q₆₀₃), -C(=O)(Q₆₀₁), -S(=O)₂(Q₆₀₁) und -P(=O)(Q₆₀₁)(Q₆₀₂) ausgewählt ist,
Q₆₀₁ bis Q₆₀₃ jeweils unabhängig eine C₁-C₁₀-Alkylgruppe, eine C₁-C₁₀-Alkoxygruppe, eine Phenylgruppe, eine Biphenylgruppe, eine Terphenylgruppe oder eine Naphthylgruppe sind, und
xe21 eine ganze Zahl von 1 bis 5 ist.

11. Organische lichtemittierende Vorrichtung (10) nach einem der Ansprüche 1 bis 10, wobei mindestens eine Emissionsschicht der m lichtemittierenden Einheiten (153) eine kondensierte cyclische Verbindung umfasst, die durch Formel 3 dargestellt wird: 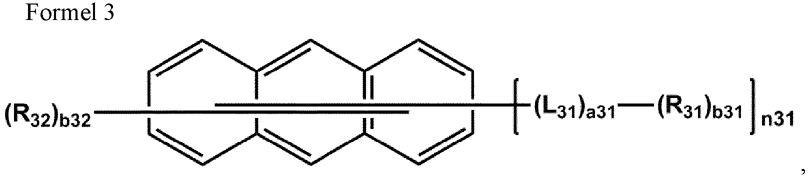 wobei in Formel 3:
L₃₁ aus einer unsubstituierten oder substituierten carbocyclischen C₅-C₆₀-Gruppe und einer unsubstituierten oder substituierten heterocyclischen C₁-C₆₀-Gruppe ausgewählt ist,
a₃₁ eine ganze Zahl von 0 bis 5 ist,
R₃₁ und R₃₂ jeweils unabhängig aus Wasserstoff, Deuterium, -F, -Cl, -Br, -I, einer Hydroxylgruppe, einer Cyanogruppe, einer Nitrogruppe, einer Amidingruppe, einer Hydrazingruppe, einer Hydrazongruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polycyclischen Gruppe, einer substituierten oder unsubstituierten einwertigen nicht-aromatischen kondensierten heteropolycyclischen Gruppe, -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂) ausgewählt sind,
b31 und b32 jeweils unabhängig eine ganze Zahl von 1 bis 5,
n31 eine ganze Zahl von 1 bis 3 ist, und
mindestens eine der substituierten carbocyclischen C₅-C₆₀-Gruppen, der substituierten heterocyclischen C₁-C₆₀-Gruppen, der substituierten C₁-C₆₀-Alkylgruppen, der substituierten C₂-C₆₀-Alkenylgruppen, der substituierten C₂-C₆₀-Alkinylgruppen, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten einwertigen nicht-aromatischen kondensierten polycyclischen Gruppe oder der substituierten einwertigen nicht-aromatischen kondensierten heteropolycyclischen Gruppe aus Folgendem ausgewählt ist:
Deuterium, -F, -Cl, -Br, -I, eine Hydroxylgruppe, eine Cyanogruppe, eine Nitrogruppe, eine Amidinogruppe, eine Hydrazinogruppe, eine Hydrazonogruppe, eine C₁-C₆₀-Alkylgruppe, eine C₂-C₆₀-Alkenylgruppe, eine C₂-C₆₀-Alkinylgruppe und eine C₁-C₆₀-Alkoxygruppe;
eine C₁-C₆₀-Alkylgruppe, eine C₂-C₆₀-Alkenylgruppe, eine C₂-C₆₀-Alkinylgruppe und eine C₁-C₆₀-Alkoxygruppe, jeweils substituiert mit mindestens einer Gruppe, der aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₃-C₁₀-Cycloalkylgruppe, einer C₁-C₁₀-Heterocycloalkylgruppe, einer C₃-C₁₀-Cycloalkenylgruppe, einer C₁-C₁-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polycyclischen Gruppe, einer einwertigen nicht-aromatischen kondensierten heteropolycyclischen Gruppe, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und -P(=O)(Q₁₁)(Q₁₂) ausgewählt ist;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine einwertige nicht-aromatische kondensierte polycyclische Gruppe und eine einwertige nicht-aromatische kondensierte heteropolycyclische Gruppe;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, einer C₁-C₆₀-Heteroarylgruppe, eine einwertige nicht-aromatische kondensierte polycyclische Gruppe und eine einwertige nicht-aromatische kondensierte heteropolycyclische Gruppe, jeweils substituiert mit mindestens einem aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polycyclischen Gruppe, einer einwertigen nicht-aromatischen kondensierten heteropolycyclischen Gruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂), und
wobei Q₁₁ bis Q₁₃, Q₂₁ bis Q₂₃ und Q₃₁ bis Q₃₃ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, eine C₁-C₆₀-Heteroarylgruppe, einer einwertigen nicht-aromatischen kondensierten polycyclischen Gruppe, einer einwertigen nicht-aromatischen kondensierten heteropolycyclischen Gruppe, einer Biphenylgruppe und einer Terphenylgruppe ausgewählt sind, wobei optional mindestens eines von R₃₁ oder R₃₂ in Formel 3 eine Gruppe ist, die durch eine aus Formel 3A und 3B ausgewählte Formel dargestellt wird: 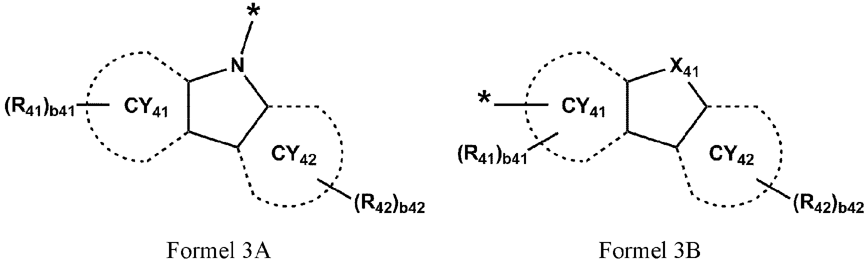 wobei in den Formeln 3A und 3B:
CY₄₁ und CY₄₂ jeweils unabhängig aus einer carbocyclischen C₅-C₃₀-Gruppe und einer heterocyclischen C₁-C₃₀-Gruppe ausgewählt sind,
X₄₁ aus O, S und N(R₄₃) ausgewählt ist,
R₄₁ bis R₄₃ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polycyclischen Gruppe, einer substituierten oder unsubstituierten einwertigen nicht-aromatischen kondensierten heteropolycyclischen Gruppe, -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂) ausgewählt sind,
b41 und b42 jeweils unabhängig eine ganze Zahl von 1 bis 10 sind, und
* eine Bindungsstelle an ein benachbartes Atom angibt.

12. Organische lichtemittierende Vorrichtung (10) nach einem der Ansprüche 1 bis 11, wobei mindestens eine Emissionsschicht der m lichtemittierenden Einheiten (153) eine kondensierte cyclische Verbindung umfasst, die durch Formel 4 dargestellt wird: 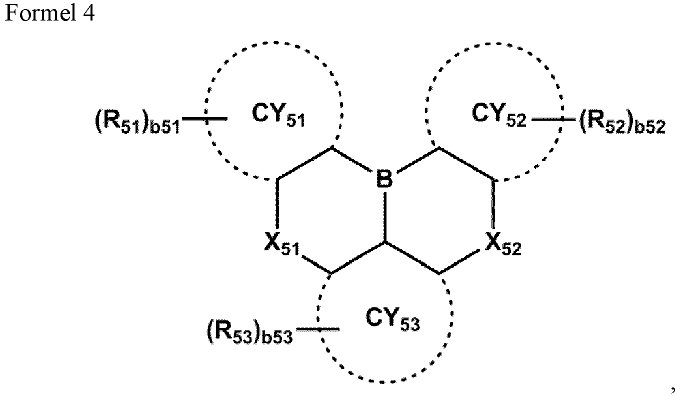 wobei in Formel 4:
X₅₁ aus C(R₅₄)(R₅₅), N(R₅₄), O und S ausgewählt ist,
X₅₂ aus C(R₅₆)(R₅₇), N(R₅₆), O und S ausgewählt ist,
CY₅₁ bis CY₅₃ jeweils unabhängig aus einer carbocyclischen C₅-C₃₀-Gruppe und einer heterocyclischen C₁-C₃₀-Gruppe ausgewählt sind,
R₅₁ bis R₅₃ und R₅₄ bis R₅₇ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nicht-aromatischen kondensierten polycyclischen Gruppe, einer substituierten oder unsubstituierten einwertigen nicht-aromatischen kondensierten heteropolycyclischen Gruppe, -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂) ausgewählt sind,
b51 bis b53 jeweils unabhängig eine ganze Zahl von 1 bis 10 sind,
wenn b51, b52 und/oder b53 mindestens zwei sind, zwei benachbarte R₅₁-Gruppen, zwei benachbarte R₅₂-Gruppen und/oder zwei benachbarte R₅₃-Gruppen jeweils optional verknüpft sind, um eine carbocyclische C₅-C₃₀-Gruppe oder eine heterocyclische C₁-C₃₀-Gruppe auszubilden, und
mindestens eine der substituierten C₁-C₆₀-Alkylgruppen, der substituierten C₂-C₆₀-Alkenylgruppen, der substituierten C₂-C₆₀-Alkinylgruppen, der substituierten C₁-C₆₀-Alkoxygruppen, der substituierten C₃-C₁₀-Cycloalkylgruppen, der substituierten C₁-C₁₀-Heterocycloalkylgruppen, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten einwertigen nicht-aromatischen kondensierten polycyclischen Gruppe, oder der substituierten einwertigen nicht-aromatischen kondensierten heteropolycyclischen Gruppe aus Folgendem ausgewählt ist:
Deuterium, -F, -Cl, -Br, -I, eine Hydroxylgruppe, eine Cyanogruppe, eine Nitrogruppe, eine Amidinogruppe, eine Hydrazinogruppe, eine Hydrazonogruppe, eine C₁-C₆₀-Alkylgruppe, eine C₂-C₆₀-Alkenylgruppe, eine C₂-C₆₀-Alkinylgruppe und eine C₁-C₆₀-Alkoxygruppe;
eine C₁-C₆₀-Alkylgruppe, eine C₂-C₆₀-Alkenylgruppe, eine C₂-C₆₀-Alkinylgruppe und eine C₁-C₆₀-Alkoxygruppe, jeweils substituiert mit mindestens einem Substituenten, der aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polycyclischen Gruppe, einer einwertigen nicht-aromatischen kondensierten heteropolycyclischen Gruppe, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und -P(=O)(Q₁₁)(Q₁₂) ausgewählt ist;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine einwertige nicht-aromatische kondensierte polycyclische Gruppe und eine einwertige nicht-aromatische kondensierte heteropolycyclische Gruppe;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine einwertige nicht-aromatische kondensierte polycyclische Gruppe und eine einwertige nicht-aromatische kondensierte heteropolycyclische Gruppe, jeweils substituiert mit mindestens einer Gruppe, der aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nicht-aromatischen kondensierten polycyclischen Gruppe, einer einwertigen nicht-aromatischen kondensierten heteropolycyclischen Gruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und -P(=O)(Q₂₁)(Q₂₂) ausgewählt ist; und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂), und
wobei Q₁₁ bis Q₁₃, Q₂₁ bis Q₂₃ und Q₃₁ bis Q₃₃ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer einwertigen nicht-aromatischen kondensierten polycyclischen Gruppe, einer einwertigen nicht-aromatischen kondensierten heteropolycyclischen Gruppe, einer Biphenylgruppe und einer Terphenylgruppe ausgewählt sind.

13. Organische lichtemittierende Vorrichtung (10) nach einem der Ansprüche 1 bis 12, wobei m eine ganze Zahl von 3 oder mehr ist, und
die maximalen Emissionswellenlängen von Licht, das aus mindestens drei der m lichtemittierenden Einheiten emittiert wird, miteinander identisch sind.

14. Elektronische Einrichtung (100), umfassend eine organische lichtemittierende Vorrichtung (10) nach einem der Ansprüche 1 bis 13.

15. Elektronische Einrichtung (100) nach Anspruch 14, ferner umfassend eine Farbkonversionsschicht (240), die sich in einer Bewegungsrichtung von mindestens einem aus der organischen lichtemittierenden Vorrichtung (10) emittierten Licht befindet, wobei optional die Farbkonversionsschicht (240) Quantenpunkte umfasst.

## Revendications

1. Dispositif électroluminescent organique (10) comprenant :
une première électrode (110) ;
une seconde électrode (190) faisant face à la première électrode (110) ;
m unités électroluminescentes (153) empilées entre la première électrode (110) et la seconde électrode (190) et comprenant au moins une couche d'émission ; et
m - 1 couches de génération de charge (155), chacune située entre deux unités électroluminescentes voisines (153) des m unités électroluminescentes (153) et comprenant une couche de génération de charge de type n (155N) et une couche de génération de charge de type p (155P),
dans lequel m est un nombre entier égal à 2 ou plus,
**caractérisé en ce qu'**au moins une des m - 1 couches de génération de charge de type p (155P) comprend une première couche de dopage (155P') et une seconde couche de dopage (155P"),
la première couche de dopage (155P') comprend un premier matériau organique et un premier matériau inorganique,
la seconde couche de dopage (155P") comprend un second matériau organique et un second matériau inorganique, et
le premier matériau inorganique et le second matériau inorganique sont différents l'un de l'autre.

2. Dispositif électroluminescent organique (10) selon la revendication 1, dans lequel m est égal à 2 ou 3.

3. Dispositif électroluminescent organique (10) selon la revendication 1 ou la revendication 2, dans lequel la première couche de dopage (155P') est située au niveau de l'interface entre la couche de génération de charge de type n (155N) et la seconde couche de dopage (155P").

4. Dispositif électroluminescent organique (10) selon l'une quelconque des revendications 1 à 3, dans lequel :
(i) le premier matériau inorganique comprend un métal de post-transition, un métalloïde, un composé comprenant deux métaux de post-transition ou plus, un composé comprenant deux métalloïdes ou plus, un composé comprenant un métal de post-transition et un métalloïde ou une quelconque combinaison de ceux-ci,
le métal de post-transition comprenant au moins un sélectionné parmi l'aluminium (Al), le gallium (Ga), l'indium (In), le thallium (Ta), l'étain (Sn), le plomb (Pb), le flérovium (Fl), le bismuth (Bi) et le polonium (Po), et
le métalloïde comprenant au moins un élément sélectionné parmi le bore (B), le silicium (Si), le germanium (Ge), l'arsenic (As), l'antimoine (Sb), le tellure (Te) et l'astate (At) ; ou
(ii) le premier matériau inorganique comprend du Bi₂Te₃, du Bi₇Te₃, du Bi₂Te, du Bi₄Te₃, du BiTe, du Bi₆Te₇, du Bi₄Te₅, du BiₓTe_{y} (0 < x < 100, 0 < y < 100, 0 < x + y ≤ 100), du Sb₂Te₃, de l'In₂Te₃, du Ga₂Te₂, de l'Al₂Te₃, du Tl₂Te₃, de l'As₂Te₃, du GeSbTe, du SnTe, du PbTe, du SiTe, du GeTe, du SiGe, de l'AlInSb, de l'AlGaSb, de l'AlAsSb, du GaAs, de l'InSb, de l'AlSb, de l'AlAs, de l'AlₐInₐSb(0 < a < 1), de l'Al_{b}In_{(1 - b)}Sb(0 < b < 1), de l'AlSb, du GaSb, de l'AlInGaAs ou une quelconque combinaison de ceux-ci.

5. Dispositif électroluminescent organique (10) selon l'une quelconque des revendications 1 à 4, dans lequel le second matériau inorganique comprend un halogénure d'un métal alcalin, un halogénure d'un métal alcalinoterreux, un halogénure d'un métal de transition, un halogénure d'un métal de post-transition, un halogénure d'un métal de lanthane ou une quelconque combinaison de ceux-ci.

6. Dispositif électroluminescent organique (10) selon l'une quelconque des revendications 1 à 5, dans lequel :
(i) le second matériau inorganique comprend un iodure d'un métal alcalin, un iodure d'un métal alcalinoterreux, un iodure d'un métal de transition, un iodure d'un métal de post-transition, un iodure de métal de lanthane ou une combinaison de ceux-ci ; ou
(ii) le second matériau inorganique comprend du LiI, du NaI, du KI, du RbI, du CsI, du BeI₂, du MgI₂, du CaI₂, du SrI₂, du BaI₂, de l'YbI, de l'YbI₂, de l'YbI₃, du SmI₃, du CuI, du TlI, de l'AgI, du CdI₂, de l'HgI₂, du SnI₂, du PbI₂, du BiI₃, du ZnI₂, du MnI₂, du FeI₂, du CoI₂, du NiI₂, de l'AlI₃, de l'InI₃, du GaI₃, du ThI₄, de l'UI₃ ou une quelconque combinaison de ceux-ci.

7. Dispositif électroluminescent organique (10) selon l'une quelconque des revendications 1 à 6, dans lequel le premier matériau organique et le second matériau organique comprennent chacun indépendamment un matériau de transport de trous.

8. Dispositif électroluminescent organique (10) selon l'une quelconque des revendications 1 à 7, dans lequel le premier matériau organique et le second matériau organique sont chacun indépendamment un composé représenté par une formule sélectionnée parmi les Formules 201, 202 et 301-2 à 301-4 : 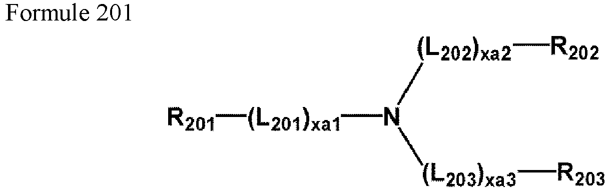 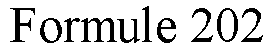 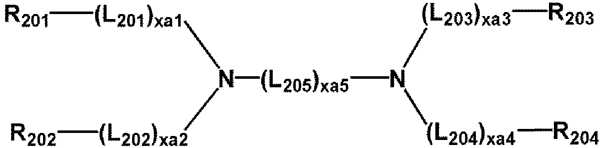 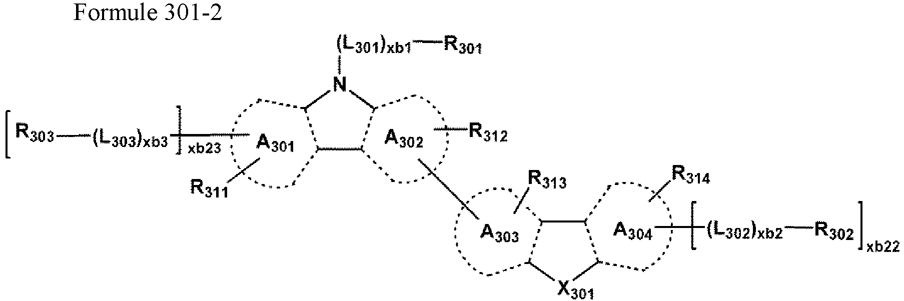 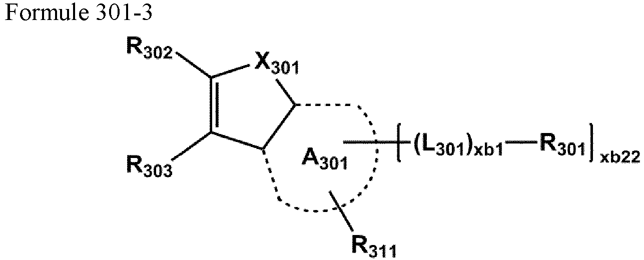 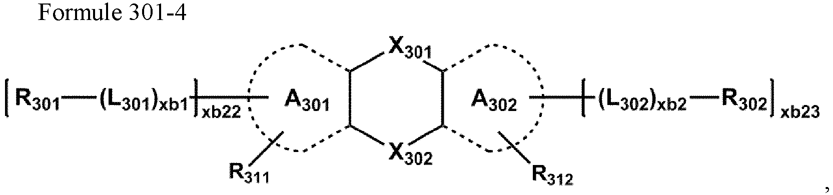 où, dans les formules 201, 202 et 301-2 à 301-4,
A₃₀₁ à A₃₀₄ sont chacun sélectionnés indépendamment parmi un cycle benzène, un cycle naphthalène, un cycle phénanthrène, un cycle fluoranthène, un cycle triphénylène, un cycle pyrène, un cycle chrysène, un cycle pyridine, un cycle pyrimidine, un cycle indène, un cycle fluorène, un cycle spiro-bifluorène, un cycle benzofluorène, un cycle dibenzofluorène, un cycle indole, un cycle carbazole, un cycle benzocarbazole, un cycle dibenzocarbazole, un cycle furane, un cycle benzofurane, un cycle dibenzofurane, un cycle naphtofurane, un cycle benzonaphtofurane, un cycle dinaphtofurane, un cycle thiophène, un cycle benzothiophène, un cycle dibenzothiophène, un cycle naphtothiophène, un cycle benzonaphtothiophène et un cycle dinaphtothiophène,
X₃₀₁ est O, S ou N-[(L₃₀₄)_{xb4}-R₃₀₄],
X₃₀₂ est une liaison simple, C(R₃₀₅)(R₃₀₆), O, S ou N-[(L₃₀₅)_{xb5}-R₃₀₅],
L₂₀₁ à L₂₀₄ et L₃₀₁ à L₃₀₅ sont chacun sélectionnés indépendamment parmi un groupe cycloalkylène en C₃-C₁₀ substitué ou non substitué, un groupe hétérocycloalkylène en C₁-C₁₀ substitué ou non substitué, un groupe cycloalcénylène en C₃-C₁₀ substitué ou non substitué, un groupe hétérocycloalcénylène en C₁-C₁₀ substitué ou non substitué, un groupe arylène en C₆-C₆₀ substitué ou non substitué, un groupe hétéroarylène en C₁-C₆₀ substitué ou non substitué, un groupe polycyclique condensé non aromatique divalent substitué ou non substitué et un groupe hétéropolycyclique condensé non aromatique divalent substitué ou non substitué,
L₂₀₅ est sélectionné parmi *-O-*, *-S-*, *-N(Q₂₀₁)-*, un groupe alkylène en C₁-C₂₀ substitué ou non substitué, un groupe alcénylène en C₂-C₂₀ substitué ou non substitué, un groupe cycloalkylène en C₃-C₁₀ substitué ou non substitué, un groupe hétérocycloalkylène en C₁-C₁₀ substitué ou non substitué, un groupe cycloalcénylène en C₃-C₁₀ substitué ou non substitué, un groupe hétérocycloalcénylène en C₁-C₁₀ substitué ou non substitué, un groupe arylène en C₆-C₆₀ substitué ou non substitué, un groupe hétéroarylène en C₁-C₆₀ substitué ou non substitué, un groupe polycyclique condensé non aromatique divalent substitué ou non substitué et un groupe hétéropolycyclique condensé non aromatique divalent substitué ou non substitué,
xa1 à xa4 sont chacun indépendamment un nombre entier égal à 0 à 3,
xa5 est un nombre entier égal à 1 à 10,
xb1 à xb5 sont chacun un nombre entier égal à 0 à 5,
xb22 et xb23 sont chacun indépendamment 0, 1 ou 2,
R₂₀₁ à R₂₀₄ et Q₂₀₁ sont chacun sélectionnés indépendamment parmi un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non aromatique monovalent substitué ou non substitué et un groupe hétéropolycyclique condensé non aromatique monovalent substitué ou non substitué,
R₃₀₁ à R₃₀₆ sont chacun sélectionnés indépendamment parmi hydrogène, deutérium, -F, -Cl, -Br, -I, un groupe hydroxyle, un groupe nitro, un groupe amidino, un groupe hydrazine, un groupe hydrazone, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non aromatique monovalent substitué ou non substitué, un groupe hétéropolycyclique condensé non aromatique monovalent substitué ou non substitué, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁) et -P(=O)(Q₃₀₁)(Q₃₀₂),
R₃₁₁ à R₃₁₄ sont chacun sélectionnés indépendamment parmi hydrogène, deutérium, -F, -Cl, -Br, -I, un groupe hydroxyle, un groupe nitro, un groupe amidino, un groupe hydrazino, un groupe hydrazono, un groupe alkyle en C₁-C₂₀, un groupe alcoxy en C₁-C₂₀, un groupe phényle, un groupe biphényle, un groupe terphényle, un groupe naphtyle, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et -P(=O)(Q₃₁)(Q₃₂), et
Q₃₁ à Q₃₃ et Q₃₀₁ à Q₃₀₃ sont chacun sélectionnés indépendamment parmi un groupe alkyle en C₁-C₁₀, un groupe alcoxy en C₁-C₁₀, un groupe phényle, un groupe biphényle, un groupe terphényle et un groupe naphtyle.

9. Dispositif électroluminescent organique (10) selon l'une quelconque des revendications 1 à 8, dans lequel :
(i) la quantité du premier matériau inorganique incluse dans la première couche de dopage (155P') est d'environ 0,1 partie en poids à environ 20 parties en poids, sur la base de 100 parties en poids du premier matériau organique, et
la quantité du second matériau inorganique incluse dans la seconde couche de dopage (155P") est d'environ 0,1 partie en poids à environ 20 parties en poids, sur la base de 100 parties en poids du second matériau organique ; et/ou
(ii) l'épaisseur de la première couche de dopage (155P') et de la seconde couche de dopage (155P") sont chacune indépendamment d'environ 1 Å à environ 300 Å.

10. Dispositif électroluminescent organique (10) selon l'une quelconque des revendications 1 à 9, dans lequel les m - 1 couches de génération de charge de type n (155N) incluent un composé exempt de métal contenant au moins un cycle contenant de l'azote présentant une carence en électrons π, un composé représenté par la formule 601, un matériau contenant du métal ou une quelconque combinaison de ceux-ci :
Formule 601 [Ar₆₀₁]ₓₑ₁₁-[(L₆₀₁)ₓₑ₁-R₆₀₁]ₓₑ₂₁,
où, dans la formule 601,
Ar₆₀₁ est un groupe carbocyclique en C₅-C₆₀ substitué ou non substitué ou un groupe hétérocyclique en C₁-C₆₀ substitué ou non substitué,
xe11 est 1, 2 ou 3,
L₆₀₁ est sélectionné parmi un groupe cycloalkylène en C₃-C₁₀ substitué ou non substitué, un groupe hétérocycloalkylène en C₁-C₁₀ substitué ou non substitué, un groupe cycloalcénylène en C₃-C₁₀ substitué ou non substitué, un groupe hétérocycloalcénylène en C₁-C₁₀ substitué ou non substitué, un groupe arylène en C₆-C₆₀ substitué ou non substitué, un groupe hétéroarylène en C₁-C₆₀ substitué ou non substitué, un groupe polycyclique condensé non aromatique divalent substitué ou non substitué et un groupe hétéropolycyclique condensé non aromatique divalent substitué ou non substitué,
xe1 est un nombre entier égal à 0 à 5,
R₆₀₁ est sélectionné parmi un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non aromatique monovalent substitué ou non substitué, un groupe hétéropolycyclique condensé non aromatique monovalent substitué ou non substitué, -Si(Q₆₀₁)(Q₆₀₂)(Q₆₀₃), -C(=O)(Q₆₀₁), -S(=O)₂(Q₆₀₁) et -P(=O)(Q₆₀₁)(Q₆₀₂),
Q₆₀₁ à Q₆₀₃ sont chacun indépendamment un groupe alkyle en C₁-C₁₀, un groupe alcoxy en C₁-C₁₀, un groupe phényle, un groupe biphényle, un groupe terphényle ou un groupe naphtyle, et
xe21 est un nombre entier égal à 1 à 5.

11. Dispositif électroluminescent organique (10) selon l'une quelconque des revendications 1 à 10, dans lequel au moins une couche d'émission des m unités électroluminescentes (153) comprend un composé cyclique condensé représenté par la formule 3 : 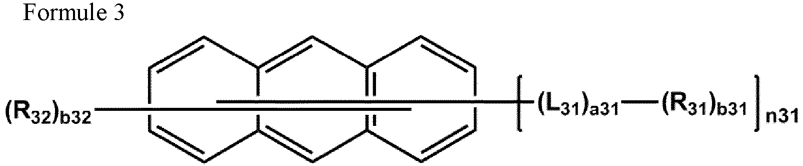 où, dans la formule 3,
L₃₁ est sélectionné parmi un groupe carbocyclique en C₅-C₆₀ non substitué ou substitué et un groupe hétérocyclique en C₁-C₆₀ non substitué ou substitué,
a₃₁ est un nombre entier égal à 0 à 5,
R₃₁ et R₃₂ sont chacun sélectionnés indépendamment parmi hydrogène, deutérium, -F, Cl, -Br, -I, un groupe hydroxyle, un groupe cyano, un groupe nitro, un groupe amidino, un groupe hydrazine, un groupe hydrazone, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non aromatique monovalent substitué ou non substitué, un groupe hétéropolycyclique condensé non aromatique monovalent substitué ou non substitué, -Si(Q₁)(Q₂)(Q₃), -N(Q₁)(Q₂), -B(Q₁)(Q₂), -C(=O)(Q₁), -S(=O)₂(Q₁) et -P(=O)(Q₁)(Q₂),
b31 et b32 sont chacun indépendamment un nombre entier égal à 1 à 5,
n31 est un nombre entier égal à 1 à 3, et
au moins l'un du groupe carboxylique en C₅-C₆₀ substitué, du groupe hétérocyclique en C₁-C₆₀ substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, du groupe polycyclique condensé non aromatique monovalent substitué ou du groupe hétéropolycyclique condensé non aromatique monovalent substitué est sélectionné parmi :
deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀ et un groupe alcoxy en C₁-C₆₀ ;
un groupe alkyle en C₁-C₆₀, un groupe alcényle en C₂-C₆₀, un groupe alcynyle en C₂-C₆₀ et un groupe alcoxy en C₁-C₆₀, chacun étant substitué par au moins un groupe sélectionné parmi deutérium, -F, -Cl, -Br, -I, un groupe hydroxyle, un groupe cyano, un groupe nitro, un groupe amidino, un groupe hydrazino, un groupe hydrazono, un groupe cycloakyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) et -P(=O)(Q₁₁)(Q₁₂) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent et un groupe hétéropolycyclique condensé non aromatique monovalent,
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent et un groupe hétéropolycyclique condensé non aromatique monovalent, chacun étant substitué par au moins un groupe sélectionné parmi : deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) et -P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et -P(=O)(Q₃₁)(Q₃₂), et
dans lequel Q₁₁ à Q₁₃, Q₂₁ à Q₂₃ et Q₃₁ à Q₃₃ sont chacun sélectionnés indépendamment parmi : hydrogène, deutérium, -F, -Cl, -Br, -I, un groupe hydroxyle, un groupe cyano, un groupe nitro, un groupe amidino, un groupe hydrazine, un groupe hydrazone, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe hétéroaryle en C₁-C₆₀, un groupe polycyclique condensé non aromatique monovalent, un groupe hétéropolycyclique condensé non aromatique monovalent, un groupe biphényle et un groupe terphényle, facultativement dans lequel au moins un de R₃₁ ou R₃₂ dans la Formule 3 est un groupe représenté par une formule sélectionnée parmi les Formules 3A et 3B : 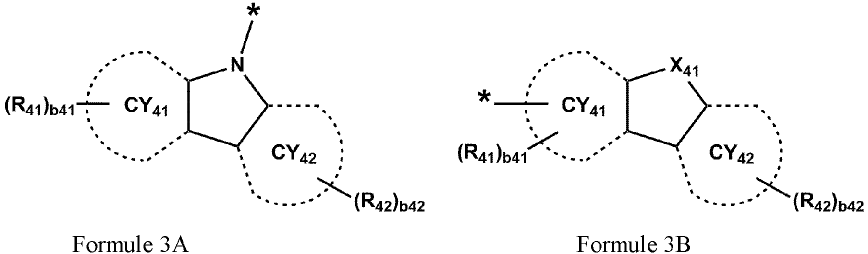 où, dans les Formules 3A et 3B,
CY₄₁ et CY₄₂ sont chacun sélectionnés indépendamment parmi un groupe carbocyclique en C₅-C₃₀ et un groupe hétérocyclique en C₁-C₃₀,
X₄₁ est sélectionné parmi O, S et N(R₄₃),
R₄₁ à R₄₃ sont chacun sélectionnés indépendamment parmi hydrogène, deutérium, - F, -Cl, -Br, -I, un groupe hydroxyle, un groupe cyano, un groupe nitro, un groupe amidino, un groupe hydrazine, un groupe hydrazone, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non aromatique monovalent substitué ou non substitué, un groupe hétérocyclique condensé non aromatique monovalent substitué ou non substitué, -Si(Q₁)(Q₂)(Q₃), -N(Q₁)(Q₂), -B(Q₁)(Q₂), -C(=O)(Q₁), -S(=O)₂(Q₁) et -P(=O)(Q₁)(Q₂),
b41 et b42 sont chacun indépendamment un nombre entier égal à 1 à 10, et
* indique un site de liaison à un atome voisin.

12. Dispositif électroluminescent organique (10) selon l'une quelconque des revendications 1 à 11, dans lequel au moins une couche d'émission des m unités électroluminescentes (153) comprend un composé cyclique condensé représenté par la formule 4 : 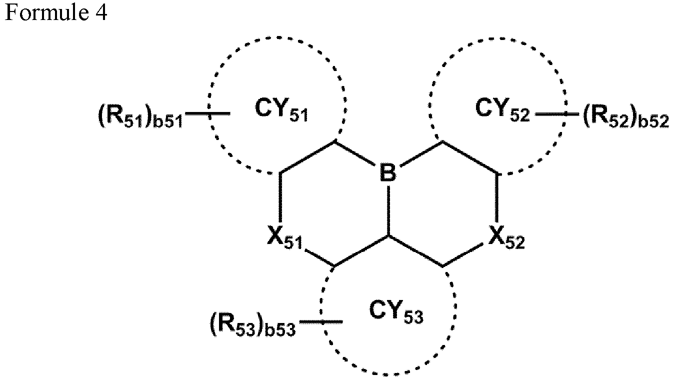 où, dans la formule 4,
X₅₁ est sélectionné parmi C(R₅₄)(R₅₅), N(R₅₄), O et S,
X₅₂ est sélectionné parmi C(R₅₆)(R₅₇), N(R₅₆), O et S,
CY₅₁ à CY₅₃ sont chacun sélectionnés indépendamment parmi un groupe carbocyclique en C₅-C₃₀ et un groupe hétérocyclique en C₁-C₃₀,
R₅₁ à R₅₃ et R₅₄ à R₅₇ sont chacun sélectionnés indépendamment parmi hydrogène, deutérium, -F, Cl, -Br, -I, un groupe hydroxyle, un groupe cyano, un groupe nitro, un groupe amidino, un groupe hydrazine, un groupe hydrazone, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non aromatique monovalent substitué ou non substitué, un groupe hétéropolycyclique condensé non aromatique monovalent substitué ou non substitué, -Si(Q₁)(Q₂)(Q₃), -N(Q₁)(Q₂), de -B(Q₁)(Q₂), de -C(=O)(Q₁), de -S(=O)₂(Q₁) et de -P(=O)(Q₁)(Q₂),
b51 à b53 sont chacun indépendamment un nombre entier égal à 1 à 10,
lorsque b51, b52 et/ou b53 valent au moins deux, deux groupes R₅₁ voisins, deux groupes R₅₂ voisins et/ou deux groupes R₅₃ voisins, respectivement, sont facultativement liés pour former un groupe carbocyclique en C₅-C₃₀ ou un groupe hétérocyclique en C₁-C₃₀, et
au moins un du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalcoxy en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, du groupe polycyclique condensé non aromatique monovalent substitué ou du groupe hétéropolycyclique condensé non aromatique monovalent substitué est sélectionné parmi :
deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀ et un groupe alcoxy en C₁-C₆₀ ;
un groupe alkyle en C₁-C₆₀, un groupe alcényle en C₂-C₆₀, un groupe alcynyle en C₂-C₆₀ et un groupe alcoxy en C₁-C₆₀, chacun étant substitué par au moins un substituant sélectionné parmi deutérium, -F, -Cl, -Br, -I, un groupe hydroxyle, un groupe cyano, un groupe nitro, un groupe amidino, un groupe hydrazino, un groupe hydrazono, un groupe cycloakyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), et -P(=O)(Q₁₁)(Q₁₂) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent et un groupe hétéropolycyclique condensé non aromatique monovalent ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent et un groupe hétéropolycyclique condensé non aromatique monovalent, chacun étant substitué par au moins un substituant sélectionné parmi deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) et -P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et -P(=O)(Q₃₁)(Q₃₂), et
dans lequel Q₁₁ à Q₁₃, Q₂₁ à Q₂₃ et Q₃₁ à Q₃₃ sont chacun sélectionnés indépendamment parmi hydrogène, deutérium, -F, -Cl, -Br, -I, un groupe hydroxyle, un groupe cyano, un groupe nitro, un groupe amidino, un groupe hydrazine, un groupe hydrazone, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe hétéroaryle en C₁-C₆₀, un groupe polycyclique condensé non aromatique monovalent, un groupe hétéropolycyclique condensé non aromatique monovalent, un groupe biphényle et un groupe terphényle.

13. Dispositif électroluminescent organique (10) selon l'une quelconque des revendications 1 à 12, dans lequel m est un nombre entier égal à 3 ou plus, et
les longueurs d'onde d'émission maximales de lumière émise à partir d'au moins trois des m unités électroluminescentes sont identiques les unes aux autres.

14. Appareil électronique (100) comprenant un dispositif électroluminescent organique (10) selon l'une quelconque des revendications 1 à 13.

15. Appareil électronique (100) selon la revendication 14, comprenant en outre une couche de conversion de couleur (240) située sur une direction de déplacement d'au moins une lumière émise à partir du dispositif électroluminescent organique (10), facultativement dans lequel la couche de conversion de couleur (240) comprend des points quantiques.
